(19) Europäisches Patentamt
European Patent Office
Office européen des brevets

(11) EP 4 557 928 A1

# (12) EUROPEAN PATENT APPLICATION

(43) Date of publication:
**21.05.2025 Bulletin 2025/21**

(21) Application number: **23210712.8**

(22) Date of filing: **17.11.2023**

(51) International Patent Classification (IPC):
***H10K 85/30*** *(2023.01)* ***H10K 50/17*** *(2023.01)*
***H10K 50/19*** *(2023.01)* ***H10K 85/60*** *(2023.01)*

(52) Cooperative Patent Classification (CPC):
**H10K 85/331; H10K 59/32; H10K 85/324; H10K 85/344; H10K 85/371;** H10K 50/17; H10K 50/19

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH**
**01099 Dresden (DE)**

(72) Inventors:
- **UVAROV, Vladimir**
  **01099 Dresden (DE)**
- **PINTER, Piermaria**
  **01099 Dresden (DE)**
- **SCHULZE, Benjamin**
  **01099 Dresden (DE)**
- **LUSCHTINETZ, Regina**
  **01099 Dresden (DE)**

(74) Representative: **Michalski Hüttermann & Partner Patentanwälte mbB**
**Kaistraße 16A**
**40221 Düsseldorf (DE)**

## (54) ORGANIC ELECTRONIC DEVICE COMPRISING A COMPOUND OF FORMULA (I) AND A COMPOUND OF FORMULA (III), AND DISPLAY DEVICE COMPRISING THE ORGANIC ELECTRONIC DEVICE

(57) The present invention relates to an organic electronic device comprising a compound of formula (I) and a compound of formula (III), and a display device comprising the organic electronic device.

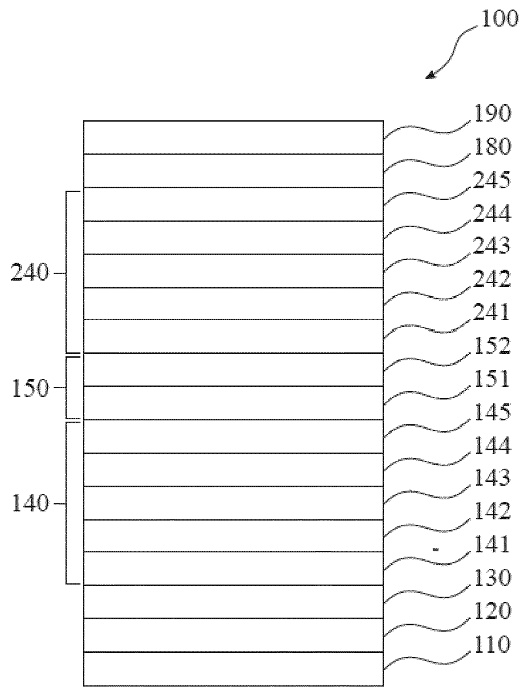


Fig. 1

EP 4 557 928 A1

## Description

### Technical Field

The present invention relates to an organic electronic device comprising a compound of formula (I) and a compound of formula (III), and a display device comprising the organic electronic device.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electronic devices, in particular to achieve improved operating voltage, improved operating voltage stability over time and improved current efficiency. Furthermore, there remains a need to improve electrical crosstalk between neighbor pixels of an active OLED display.

### DISCLOSURE

An aspect of the present invention provides an organic electronic device comprising a substrate, an anode layer, a cathode layer, a first photoactive layer, a second photoactive layer, and a hole injection layer, a charge generation layer,

wherein the charge generation layer comprises a p-type charge generation layer and an n-type charge generation layer,
wherein the hole injection layer, the charge generation layer, the first photoactive layer, and the second photoactive layer are arranged between the anode layer and the cathode layer,
wherein the hole injection layer is arranged closer to the anode layer than the p-type charge generation layer,
wherein the p-type charge generation layer is arranged closer to the cathode layer than the n-type charge generation layer, and the n-type charge generation layer is arranged closer to the anode layer than the p-type charge generation layer;
wherein the hole injection layer is in direct contact to anode layer,
wherein the charge generation layer is arranged between the first photoactive layer and the second photoactive layer,
wherein the hole injection layer comprises a compound of formula (I):

$$M^{n\oplus}(L^{\ominus})_n\ (AL)_m \qquad (I),$$

wherein:

M is a metal ion;
n is the valency of M and selected from 1 to 4;
L is a ligand independently selected from formula (II)

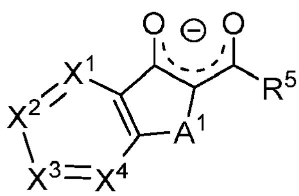

(II),

wherein

$A^1$ is selected from C=O or $SO_2$;
$X^1$ is selected from $CR^1$ or N;
$X^2$ is selected from $CR^2$ or N;
$X^3$ is selected from $CR^3$ or N;
$X^4$ is selected from $CR^4$ or N;

wherein 0, 1 or 2 of the group consisting of $X^1$, $X^2$, $X^3$, $X^4$ are selected from N;
$R^1$ to $R^4$ are independently selected from H, D, substituted or unsubstituted $C_1$ to $C_{12}$ alkyl, partially fluorinated or perfluorinated $C_1$ to $C_{12}$ alkyl, $CF_3$, substituted or unsubstituted $C_1$ to $C_8$ alkoxy, partially fluorinated or perfluorinated $C_1$ to $C_8$ alkoxy, $OCF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_3$ to $C_5$ heteroaryl; substituted or unsubstituted 6-membered $C_4$ to $C_5$ heteroaryl; halogen, F, Cl or CN, and whereby any $R^k$ to $R^{k+1}$ may form a ring, wherein k is an integer selected from 1 to 3;
$R^5$ is selected from substituted or unsubstituted $C_1$ to $C_{12}$ alkyl, partially fluorinated or perfluorinated $C_1$ to $C_{12}$ alkyl, $CF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_3$ to $C_5$ heteroaryl; substituted or unsubstituted 6-membered $C_4$ to $C_5$ heteroaryl;
wherein the one or more substituents of the substituted $C_1$ to $C_{12}$ alkyl, substituted $C_1$ to $C_8$ alkoxy, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl, substituted 6-membered $C_4$ to $C_5$ heteroaryl of $R^1$ to $R^5$ are independently selected from D, electron-withdrawing group, halogen, Cl, F, CN, partially fluorinated or perfluorinated $C_1$ to $C_8$ alkyl, partially or perfluorinated $C_1$ to $C_8$ alkoxy;

AL is an ancillary ligand which coordinates to the metal M;
m is an integer selected from 0 to 2;

wherein the p-type charge generation layer comprises an organic compound of formula (III)

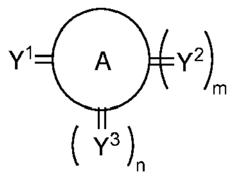

(III),

wherein

n is an integer selected from 0, 1, 2, 3, 4, 5 or 6, preferably 0, 2, or 4;
m is an integer selected from 0 or 1; preferably 1;
$Y^1$, $Y^2$ and $Y^3$ are independently selected from O, S, $CR^{1a}R2^{a}$, $CR^{1b}R^{2b}$, $NR^{3a}$, $NR^{3b}$ or at least one of $Y^1$, $Y^2$, and $Y^3$ form a fused ring with A, wherein each $Y^2$ is selected the same or different, preferably the same, and wherein each $Y^3$ is selected the same or different, preferably the same,
$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{40}$ aryl, substituted or unsubstituted $C_2$ to $C_{40}$ heteroaryl,

wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$

heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from substituted or unsubstituted $C_3$ to $C_{40}$ cyclohydrocarbon group, substituted or unsubstituted $C_3$ to $C_{40}$ cycloalkane group, substituted or unsubstituted $C_3$ to $C_{40}$ cycloalkane group containing one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group,

wherein the one or more substituents on A are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, $CF_3$, partially fluorinated $C_1$ to $C_8$ alkoxy, perfluorinated $C_1$ to $C_8$ alkoxy, $OCF_3$.

It should be noted that throughout the application and the claims any $A^n$, $B^n$, $R^n$, $X^n$ etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an

adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

In the present specification, a "$C_6$ to $C_{40}$ aromatic group" may be a group which is aromatic, or a group containing at least one aromatic moiety, i.e. an aromatic group may also contain a fused non-aromatic moiety. The moiety can contain different atoms.

In the present specification, a "$C_2$ to $C_{40}$ heteroaromatic group" may be a group which is heteroaromatic, or a group containing at least one heteroaromatic moiety, i.e. a heteroaromatic group may also contain a fused non-aromatic moiety. The moiety can contain different atoms.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) energy level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) energy level.

**Advantageous Effects**

Surprisingly, it was found that the organic electronic device according to the invention solves the problem underlying the present invention by enabling devices in various aspects superior over the organic electronic devices known in the art, in particular with respect to improved operating voltage, improved stability in particular operating voltage stability over time and improved current efficiency, and especially to achieve improved stability in particular operating voltage stability over time. Moreover, electrical crosstalk between neighboring pixels of the active OLED display may be reduced.

In the following several advantageous embodiments of the layers of the device according to the invention are described, whereby features can be combined *ad libitum*:

**Hole injection layer**

According to one embodiment of the invention, the thickness of the hole injection layer is in the range of 1 nm to 20 nm, preferably in the range of 1 nm to 15 nm, more preferably in the range of 3 nm to 15 nm.

According to an embodiment, the atomic mass of M of the compound of formula (I) is selected in the range of ≥ 20 Da and ≤ 200 Da. Preferably the atomic mass of M of the compound of formula (I) is in the range of ≥ 54 Da and ≤ 135 Da According to one embodiment, M of the compound of formula (I) may be selected from a metal ion wherein the corresponding metal has an electronegativity value according to Allen of ≥ 0.65 and ≤ 1.9.

The term "electronegativity value according to Allen" especially refers to Allen, Leland C. (1989). "Electronegativity is the average one-electron energy of the valence-shell electrons in ground-state free atoms", Journal of the American Chemical Society 111 (25): 9003-9014.

According to one embodiment, M may be selected from a transition metal or group III or V metal.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III), Ce(IV).

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III).

According to an embodiment, M in the compound of formula (I) is selected from Cu(II), Zn(II), Ga(III), Mn(II), Mn(III), In(III), Fe(II), Fe(III).

According to an embodiment, M in the compound of formula (I) is selected from Cu(II), Zn(II), Mn(II), In(III), Fe(III).

The term "m"

The term "m" is an integer selected from 0 to 2, which corresponds to the number of of ancillary ligand AL which coordinates to the metal M . According to one embodiment "m" is an integer selected from 0 or 1. According to another embodiment "m" is an integer selected from 1. According to another embodiment "m" is an integer selected from 2. Preferably "m" is an integer and may be selected from 0.

According to another embodiment of compound of formula (I), wherein n = 2 or 3; and/or m is an integer selected from 0 or 1, preferably 0.

Ligand L

"L is a ligand independently selected from formula (II)" means that if n>1 than each L can be selected the same or different.

According to an embodiment, wherein each L in formula (II) is selected the same.

According to an embodiment, wherein each L in formula (II) is selected the same when n>1.

According to one embodiment, the molecular mass of L is selected in the range of ≤ 600 Da and ≥ 240 Da, preferably ≤ 500 Da and ≥ 280 Da.

According to one embodiment of the present invention, zero or one of $R^1$ to $R^4$ are not H or D.

According to one embodiment of the present invention, the ligand of formula (II) is free of alkoxy groups.

According to an embodiment, wherein in the ligand of formula (II), $R^1$ to $R^4$ are independently selected from H, D, F or CN, preferably H or D; and $R^5$ is selected from unsubstituted and substituted $C_1$ to $C_6$ alkyl, substituted or unsubstituted $C_6$ to $C_{12}$ aryl, substituted or unsubstituted $C_2$ to $C_{12}$ heteroaryl, substituted or unsubstituted 6-membered heteroaryl;

wherein the substituents in the substituted $C_1$ to $C_6$ alkyl, substituted $C_6$ to $C_{12}$ aryl, substituted $C_2$ to $C_{12}$ heteroaryl, substituted 6-membered heteroaryl are selected from halogen, F, Cl, CN, partially or perfluorinated $C_1$ to $C_4$ alkyl, partially or perfluorinated $C_1$ to $C_4$ alkoxy, $C_1$ to $C_4$ alkyl, $C_1$ to $C_4$ alkoxy.

According to one embodiment of the present invention, the compound of formula (I) comprises at least two

fluorine atoms and/or at least one CN group and less than 50 fluorine atoms and/or less than 16 CN groups; preferably compound of formula (I) comprises between 2 and 36 fluorine atoms and/or between one and 8 CN groups.

According to an embodiment, in case the compound of formula (I) comprises at least one CN group then it is especially preferred that the CN group is present on one or more of the groups $R^1$ to $R^4$, preferably $R^2$ or $R^3$.

According to an embodiment, in case the compound of formula (I) comprises at least two fluorine atoms then it is especially preferred that $R^5$ comprises the at least two fluorine atoms.

According to an embodiment of the present invention, the ligand of formula (II) comprises at least two fluorine atoms and/or at least one CN group.

According to one embodiment of the present invention, the ligand of formula (II) comprises at least two fluorine atoms and/or at least one CN group and less than 25 fluorine atoms and/or less than 4 CN groups; preferably compound of formula (I) comprises between 2 and 13 fluorine atoms and/or between one and 4 CN groups.

According to an embodiment of the present invention, in case the ligand of formula (II) comprises at least one CN group then it is especially preferred that the CN group is present on one or more of the groups $R^1$ to $R^4$, preferably $R^2$ or $R^3$.

According to an embodiment of the present invention, in case the ligand of formula (II) comprises at least two fluorine atoms then it is especially preferred that $R^5$ comprises the at least two fluorine atoms.

According to an embodiment of the present invention, none of the groups $R^1$ to $R^4$ comprises fluorine atoms.

According to an embodiment of the present invention, in the ligand of formula (II), $R^1$ to $R^4$ are independently selected from H, D, F or CN, preferably H or D; and $R^5$ is selected from unsubstituted and substituted $C_1$ to $C_6$ alkyl, substituted or unsubstituted $C_6$ to $C_{12}$ aryl, substituted or unsubstituted $C_2$ to $C_{12}$ heteroaryl, substituted or unsubstituted 6-membered heteroaryl;

wherein the substituents in the substituted $C_1$ to $C_6$ alkyl, substituted $C_6$ to $C_{12}$ aryl, substituted $C_2$ to $C_{12}$ heteroaryl, substituted 6-membered heteroaryl are selected from halogen, F, Cl, CN, partially or perfluorinated $C_1$ to $C_4$ alkyl, partially or perfluorinated $C_1$ to $C_4$ alkoxy, $C_1$ to $C_4$ alkyl, $C_1$ to $C_4$ alkoxy;
wherein at least one of $R^1$ to $R^4$ and/or $R^5$ comprises at least two fluorine atoms and/or at least one CN group.

According to an embodiment of the present invention, in the ligand of formula (II) $R^1$ to $R^4$ are independently selected from H, D or CN, preferably H or D; and $R^5$ is selected from substituted $C_1$ to $C_{12}$ alkyl, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl;

wherein the substituents in the substituted $C_1$ to $C_{12}$ alkyl, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl are selected from halogen, F, Cl, CN, partially or perfluorinated $C_1$ to $C_6$ alkyl, $C_1$ to $C_6$ alkyl, $C_1$ to $C_6$ alkoxy;
wherein at least one of $R^1$ to $R^4$ and/or $R^5$ comprises at least two fluorine atoms and/or at least one CN group.

According to an embodiment of the present invention, in the ligand of formula (II) $R^1$ to $R^4$ are independently selected from H or D; and $R^5$ is selected from substituted $C_1$ to $C_{12}$ alkyl, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl;

wherein the substituents in the substituted $C_1$ to $C_{12}$ alkyl, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl are selected from halogen, F, Cl, CN, partially or perfluorinated $C_1$ to $C_6$ alkyl, $C_1$ to $C_6$ alkyl, $C_1$ to $C_6$ alkoxy;
wherein $R^5$ comprises at least two fluorine atoms and/or at least one CN group.

According to an embodiment of the present invention, in the ligand of formula (II) $R^1$ to $R^4$ are selected from H or D; and $R^5$ is selected from substituted $C_1$ to $C_6$ alkyl, substituted $C_6$ aryl, substituted $C_2$ to $C_5$ heteroaryl, substituted 6-membered heteroaryl;

wherein the substitutents in the substituted $C_1$ to $C_6$ alkyl, substituted $C_6$ aryl, substituted $C_2$ to $C_5$ heteroaryl, substituted 6-membered heteroaryl are selected from halogen, F, Cl, CN, partially or perfluorinated $C_1$ to $C_6$ alkyl, $C_1$ to $C_6$ alkyl, $C_1$ to $C_6$ alkoxy;
wherein $R^5$ comprises at least two fluorine atoms and/or at least one CN group.

According to an embodiment, one or more substituents of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$.

According to an embodiment, one or more substituents of $R^1$ to $R^5$ in formula (II) are independently selected from halogen, Cl, F, CN, partially fluorinated or perfluorinated $C_1$ to $C_8$ alkyl, $CF_3$.

According to an embodiment, formula (II) comprises at least one fluorine atom, preferably at least two fluorine atoms, and more preferably at least three fluorine atoms.

According to an embodiment, $A^1$ is C=O and formula (II) comprises at least one fluorine atom, preferably at least two fluorine atoms, and more preferably at least three fluorine atoms.

According to an embodiment, formula (II) comprises at least one partially fluorinated $C_1$ to $C_4$ alkyl or perfluorinated $C_1$ to $C_4$ alkyl group.

According to an embodiment, formula (II) comprises at least one $CF_3$ group.

According to an embodiment, formula (II) comprises at least two partially fluorinated $C_1$ to $C_4$ alkyl or perfluorinated $C_1$ to $C_4$ alkyl group.

According to an embodiment, formula (II) comprises at least two $CF_3$ groups.

According to an embodiment, at least one of $R^1$ to $R^4$ of formula (II) comprises at least one partially fluorinated $C_1$ to $C_4$ alkyl or perfluorinated $C_1$ to $C_4$ alkyl moiety and $R^5$ of formula (II) comprises at least one partially fluorinated $C_1$ to $C_4$ alkyl or perfluorinated $C_1$ to $C_4$ alkyl moiety.

According to an embodiment, at least one of $R^1$ to $R^4$ of formula (II) comprises at least one $CF_3$ and $R^5$ of formula (II) comprises at least one $CF_3$.

According to an embodiment, the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$, and formula (II) comprises at least one partially fluorinated $C_1$ to $C_4$ alkyl or perfluorinated $C_1$ to $C_4$ alkyl group.

According to an embodiment, the one or more substituents - if present - of $R^1$ to $R^5$ in formula (II) are independently selected from halogen, Cl, F, CN, partially fluorinated or perfluorinated $C_1$ to $C_8$ alkyl, $CF_3$, and formula (II) comprises at least one partially fluorinated $C_1$ to $C_4$ alkyl or perfluorinated $C_1$ to $C_4$ alkyl group

According to an embodiment, the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one $CF_3$ group.

According to an embodiment, the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one $CF_3$ group.

According to an embodiment, the one or more of the substituents - if present - of $R^1$ to $R^5$ in formula (II) -if present - are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one fluorine atom.

According to an embodiment, the one or more of the substituents $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least two fluorine atoms.

According to an embodiment, the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least three fluorine atoms.

According to an embodiment, the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one fluorine atom.

According to an embodiment, the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least two fluorine atoms.

According to an embodiment, the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least three fluorine atoms.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); and the one or more substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); and the one or more substituents - if present - of $R^1$ to $R^5$ in formula (II) are independently selected from halogen, Cl, F, CN, partially fluorinated or perfluorinated $C_1$ to $C_8$ alkyl, $CF_3$.

According to an embodiment, M in the compound of formula (I) is selected from Cu(II), Mn(II), In(III), Fe(III); and the one or more substituents - if present - of $R^1$ to $R^5$ in formula (II) are independently selected from halogen, Cl, F, CN,

partially fluorinated or perfluorinated $C_1$ to $C_8$ alkyl, $CF_3$, partially or perfluorinated $C_1$ to $C_8$ alkoxy, $OCF_3$.

According to an embodiment, M in the compound of formula (I) is selected from Cu(II), Mn(II), In(III), Fe(III); and the one or more substituents - if present - of $R^1$ to $R^5$ in formula (II) are independently selected from halogen, Cl, F, CN, partially fluorinated or perfluorinated $C_1$ to $C_8$ alkyl, $CF_3$.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one partially fluorinated $C_1$ to $C_4$ alkyl or perfluorinated $C_1$ to $C_4$ alkyl group.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one partially fluorinated $C_1$ to $C_4$ alkyl or perfluorinated $C_1$ to $C_4$ alkyl group

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one $CF_3$ group.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one $CF_3$ group.

According to an embodiment, M in the compound of formula (I) is selected from Cu(II), Mn(II), In(III), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one partially fluorinated $C_1$ to $C_4$ alkyl or perfluorinated $C_1$ to $C_4$ alkyl group.

According to an embodiment, M in the compound of formula (I) is selected from Cu(II), Mn(II), In(III), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one partially fluorinated $C_1$ to $C_4$ alkyl or perfluorinated $C_1$ to $C_4$ alkyl group

According to an embodiment, M in the compound of formula (I) is selected from Cu(II), Mn(II), In(III), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one $CF_3$ group.

According to an embodiment, M in the compound of formula (I) is selected from Cu(II), Mn(II), In(III), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one $CF_3$ group.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); and M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one partially fluorinated $C_1$ to $C_4$ alkyl or perfluorinated $C_1$ to $C_4$ alkyl group.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); and M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; formula (II) comprises at least one partially fluorinated $C_1$ to $C_4$ alkyl or perfluorinated $C_1$ to $C_4$ alkyl group

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); one or more of the substituents of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one $CF_3$ group.

According to an embodiment, M in the compound of formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III); one or more substituents of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one $CF_3$ group.

According to an embodiment, M in the compound of formula (I) is selected from Cu(II), Mn(II), In(III), Fe(III); one or

more of the substituents of the substituted of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one partially fluorinated $C_1$ to $C_4$ alkyl or perfluorinated $C_1$ to $C_4$ alkyl group.

According to an embodiment, M in the compound of formula (I) is selected from Cu(II), Mn(II), In(III), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one partially fluorinated $C_1$ to $C_4$ alkyl or perfluorinated $C_1$ to $C_4$ alkyl group

According to an embodiment, M in the compound of formula (I) is selected from Cu(II), Mn(II), In(III), Fe(III); the one or more of the substituents - if present - of $R^1$ to $R^5$ in formula (II) are independently selected from halogen, Cl, F, CN, partially fluorinated or perfluorinated $C_1$ to $C_8$ alkyl, $CF_3$, partially or perfluorinated $C_1$ to $C_8$ alkoxy, $OCF_3$; and formula (II) comprises at least one $CF_3$ group.

According to an embodiment, M in the compound of formula (I) is selected from Cu(II), Mn(II), In(III), Fe(III); the one or more substituents - if present - of $R^1$ to $R^5$ in formula (II) are independently selected from halogen, Cl, F, CN, partially fluorinated or perfluorinated $C_1$ to $C_8$ alkyl, $CF_3$; and formula (II) comprises at least one $CF_3$ group.

According to one embodiment of the compound of formula (I), $R^5$ is selected from $CF_3$, $C_2F_5$, $C_3F_7$, iso-$C_3F_7$, $C_4F_9$, tert-$C_4H_9$, or formulae (B1) to (B51)

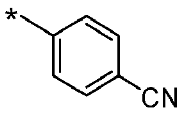 (B1), 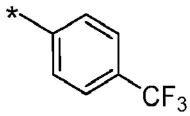 (B2), 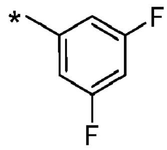 (B3), 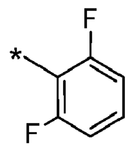 (B4),

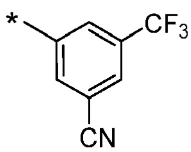 (B5), 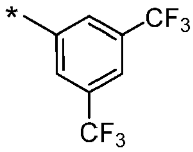 (B6), 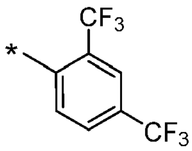 (B7), 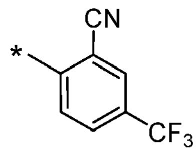 (B8),

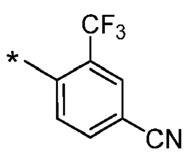 (B9), 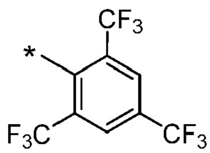 (B10), 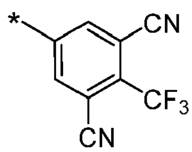 (B11), 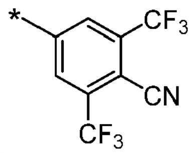 (B12),

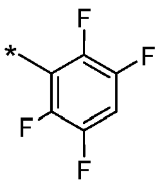 (B13), 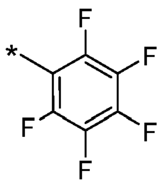 (B14), 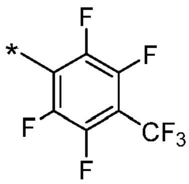 (B15), 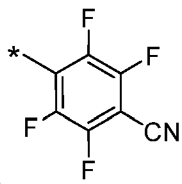 (B16),

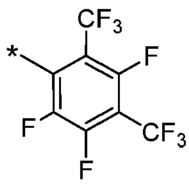 (B17), 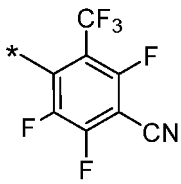 (B18), 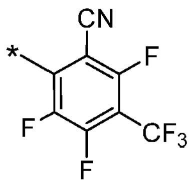 (B19), 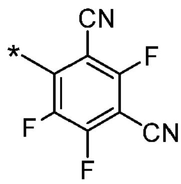 (B20),

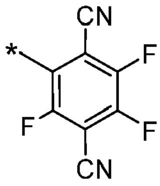 (B21), 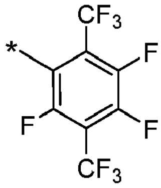 (B22), 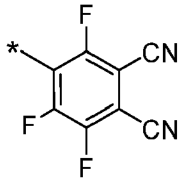 (B23), 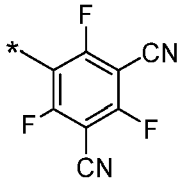 (B24),

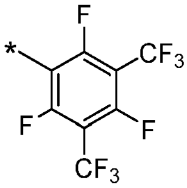 (B25), 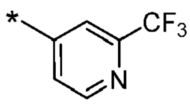 (B26), 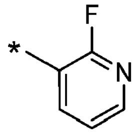 (B27), 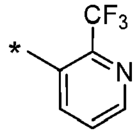 (B28),

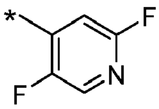 (B29), 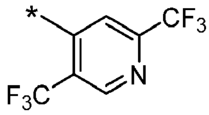 (B30), 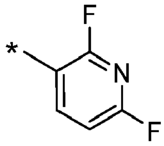 (B31), 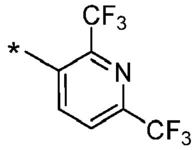 (B32),

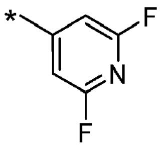 (B33), 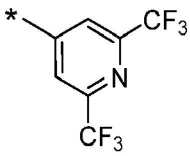 (B34), 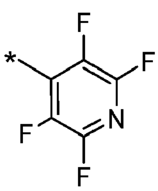 (B35), 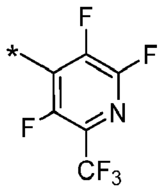 (B36),

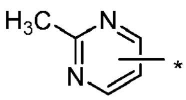 (B37), 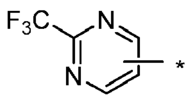 (B38), 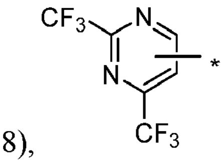 (B39), 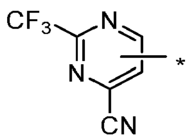 (B40),

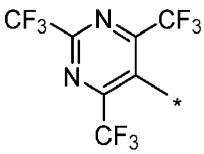 (B41), 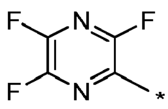 (B42), 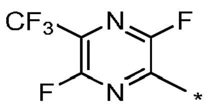 (B43), 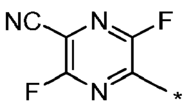 (B44),

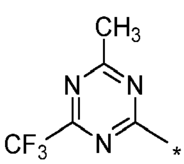 (B45), 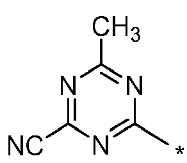 (B46), 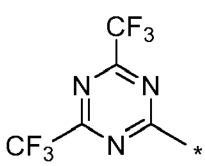 (B47), 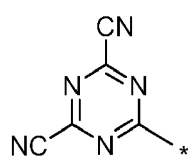 (B48),

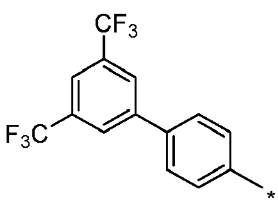 (B49), 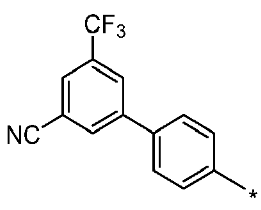 (B50), 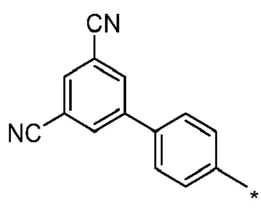 (B51);

wherein the "*" denotes the binding position; preferably, $R^5$ is selected from $CF_3$ or formulae (B1) to (B36), more preferably $R^5$ is selected from $CF_3$ or formulae (B2) to (B25).

According to one embodiment of the present invention, the ligand of formula (II) is selected from one of the following formulae (C1) to (C141)

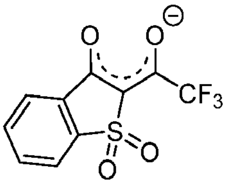 (C1), 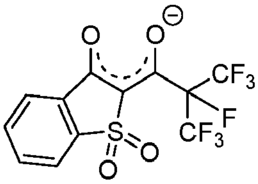 (C2), 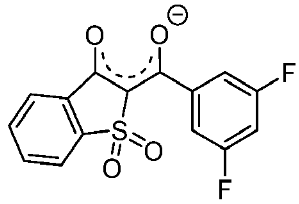 (C3),

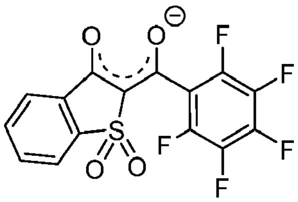 (C4), 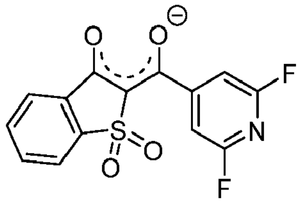 (C5), 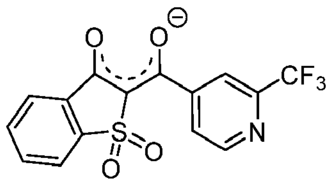 (C6),

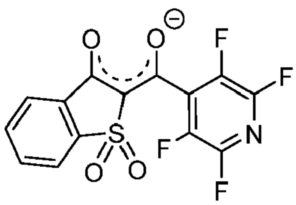 (C7), 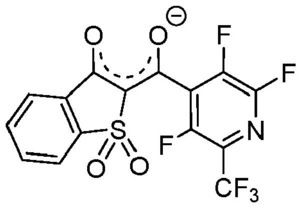 (C8), 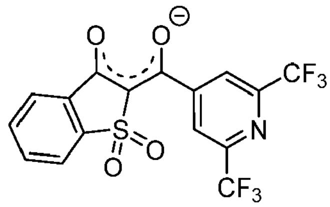 (C9),

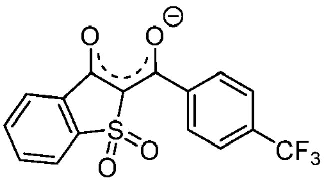 (C10), 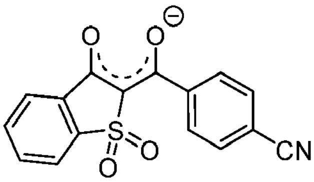 (C11), 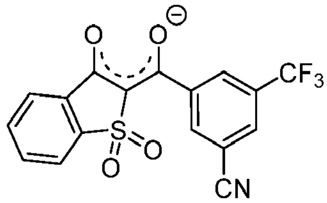 (C12),

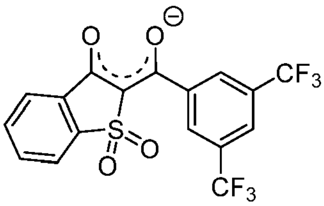 (C13), 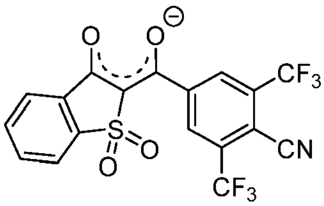 (C14), 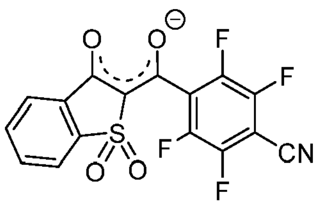 (C15),

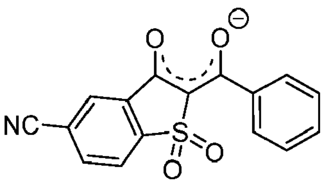 (C16), 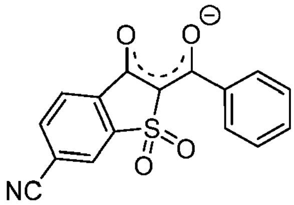 (C17), 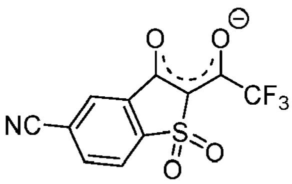 (C18),

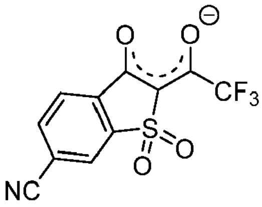 (C19), 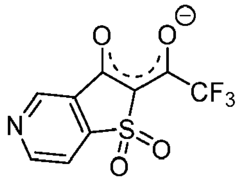 (C20), 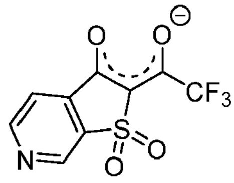 (C21),

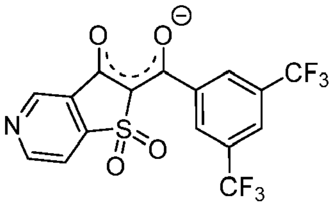 (C23), 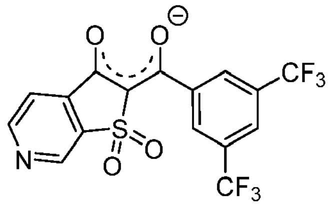 (C24), 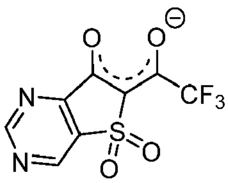 (C25),

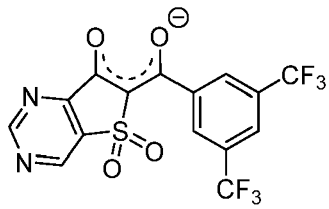 (C26), 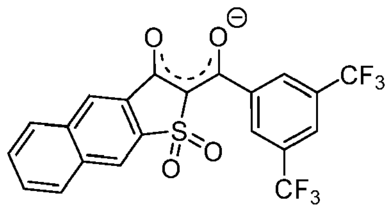 (C27),

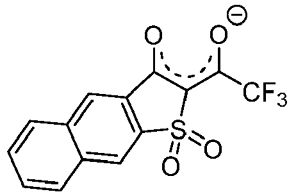 (C28);

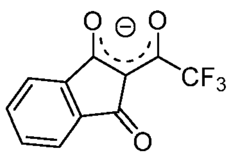
C29,

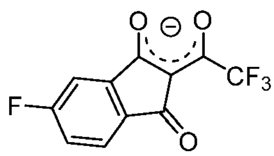
C30,

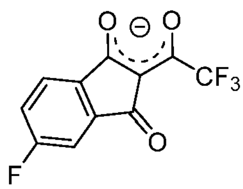
C31,

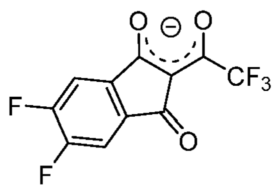
C32,

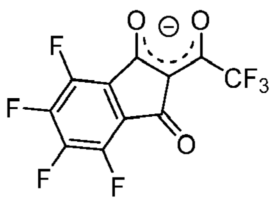
C33,

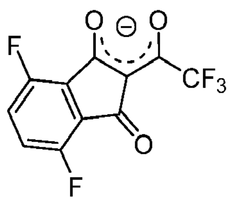
C34,

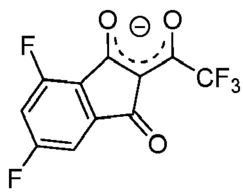
C35,

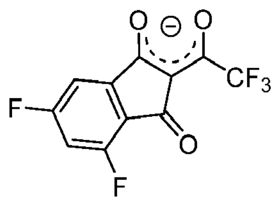
C36,

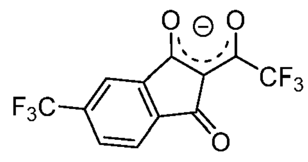

C37,

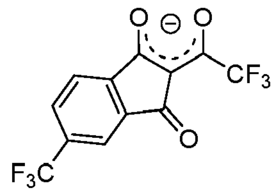

C38,

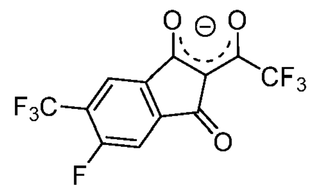

C39,

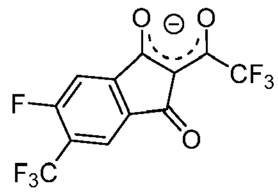

C40,

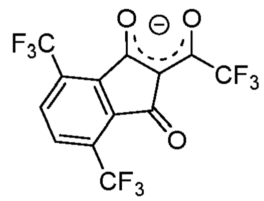

C41,

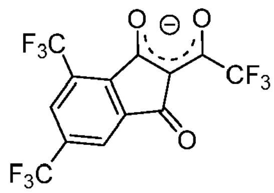

C42,

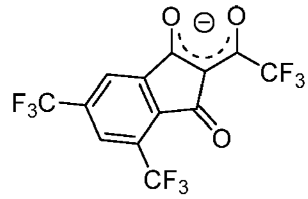

C43,

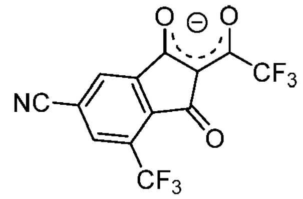

C44,

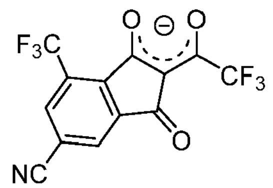

C45,

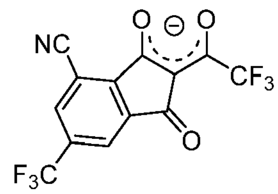

C46,

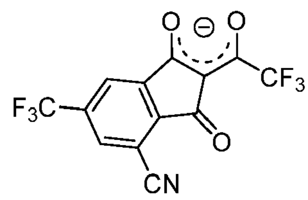

C47,

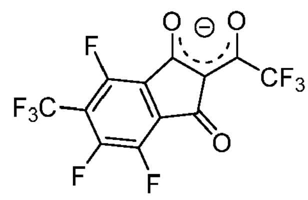

C48,

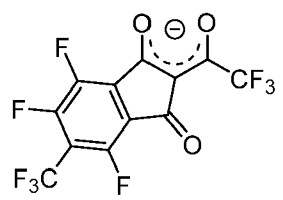

C49,

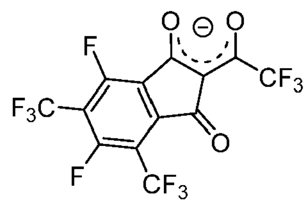

C50,

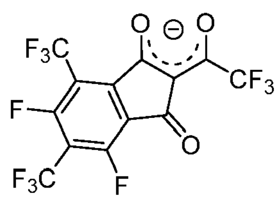

C51,

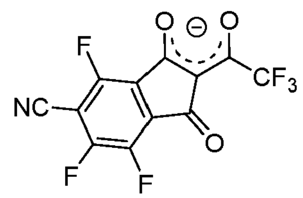

C52,

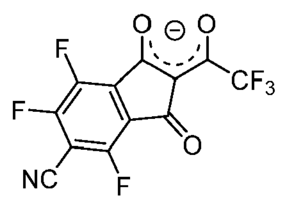

C53,

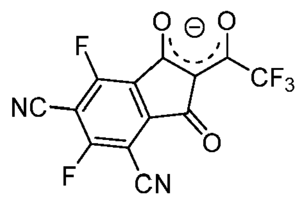

C54,

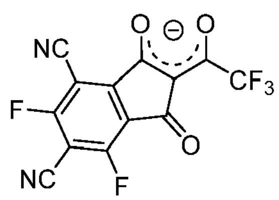

C55,

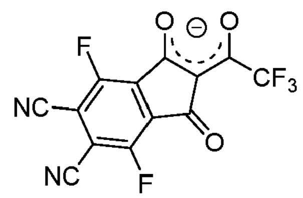

C56,

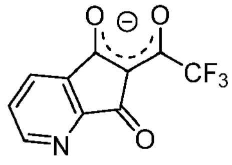
C57,
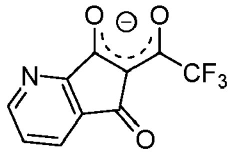
C58,
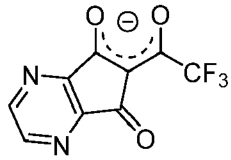
C59,
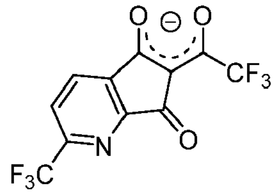
C60,

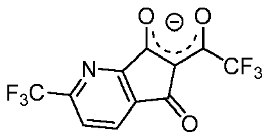
C61,
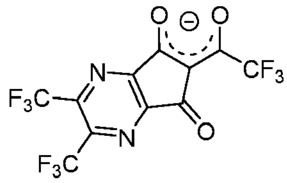
C62,
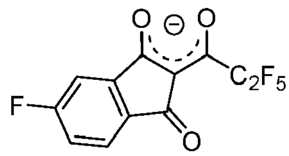
C63,
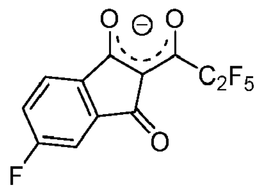
C64,

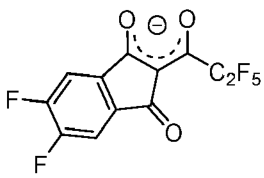
C65,
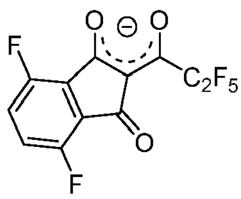
C66,
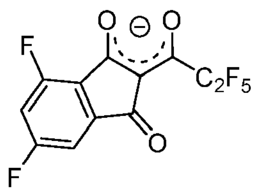
C67,
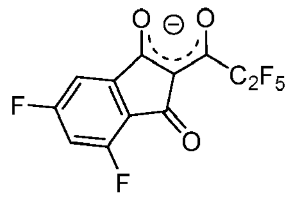
C68,

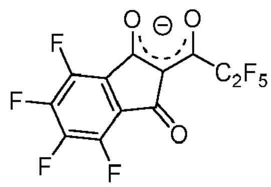
C69,
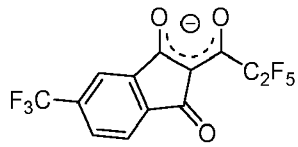
C70,
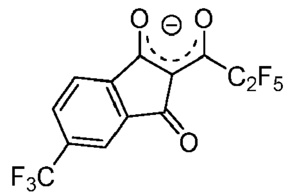
C71,
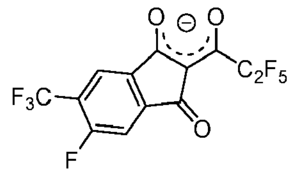
C72,

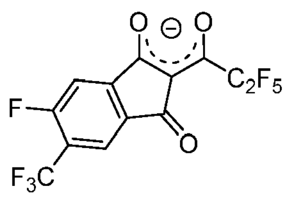
C73,
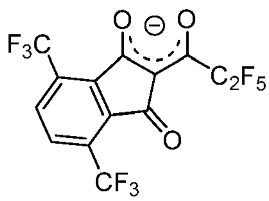
C74,
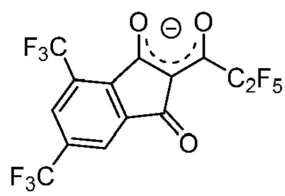
C75,
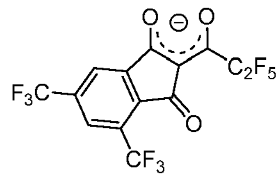
C76,

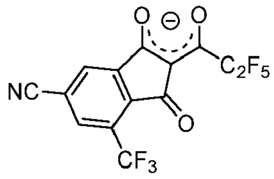
C77,
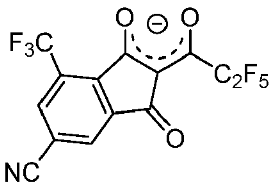
C78,
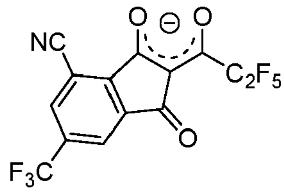
C79,
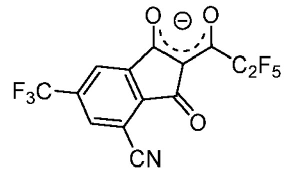
C80,

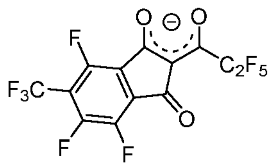
C81,
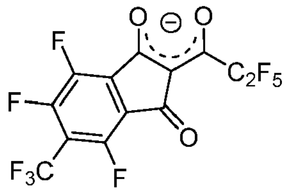
C82,
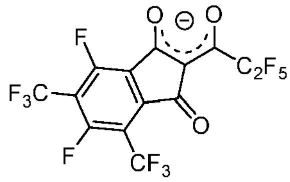
C83,
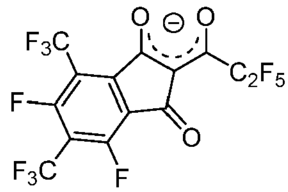
C84,

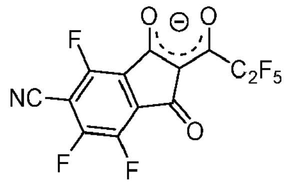
C85,
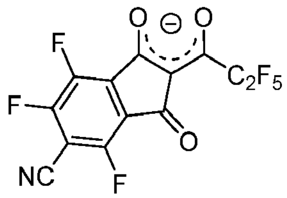
C86,
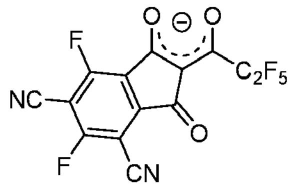
C87,
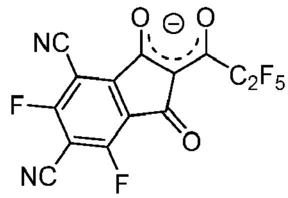
C88,

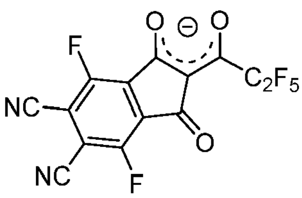
C89,
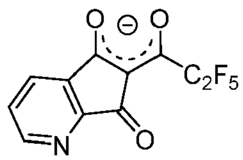
C90,
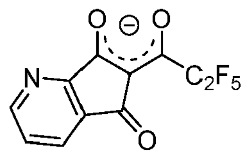
C91,
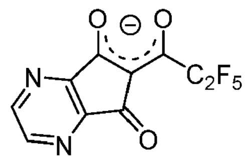
C92,

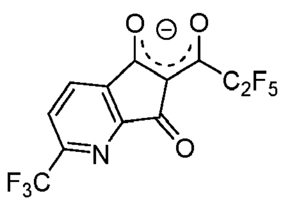
C93,
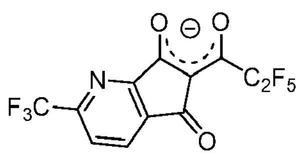
C94,
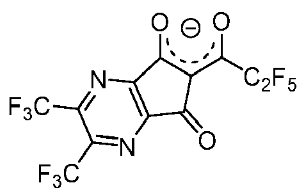
C95,
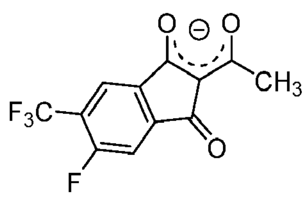
C96,

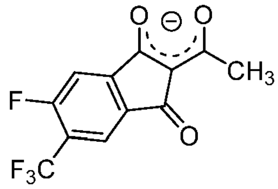
C97,
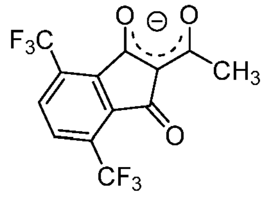
C98,
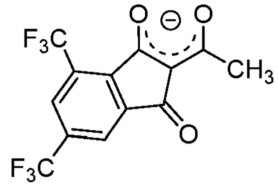
C99,
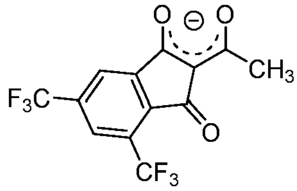
C100,

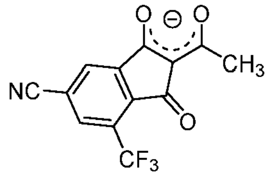
C101,

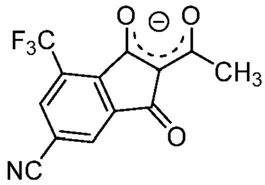
C102,

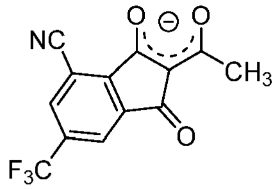
C103,

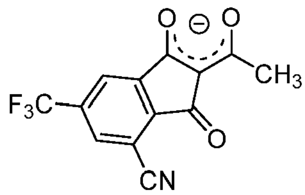
C104,

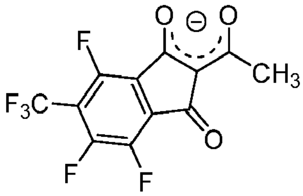
C105,

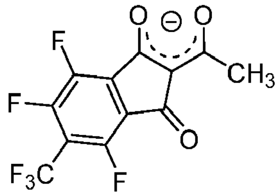
C106,

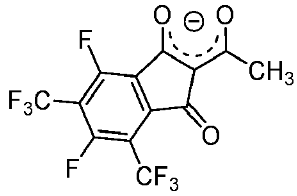
C107,

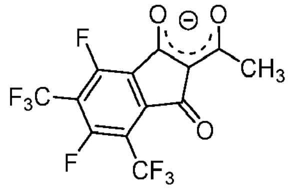
C108,

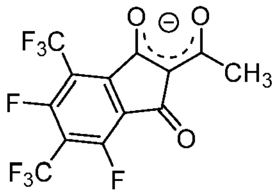
C109,

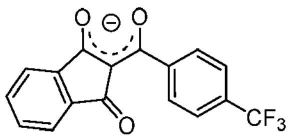
C110,

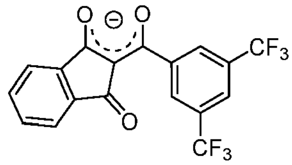
C111,

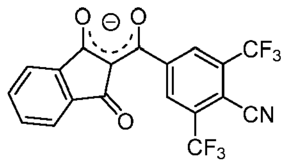
C112,

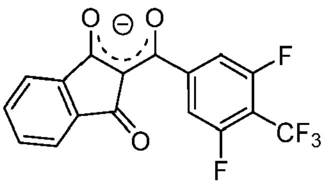
C113,

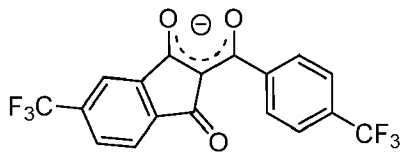
C114,

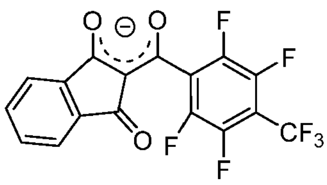
C115,

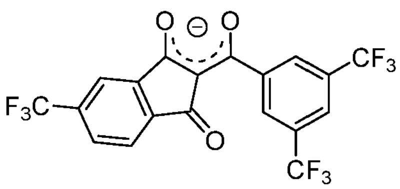
C116,

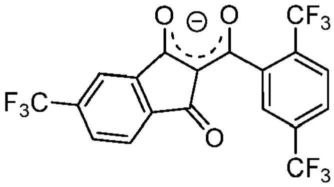
C117,

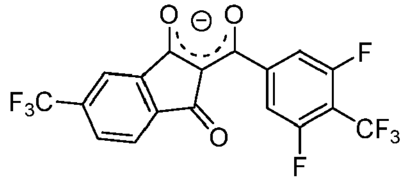
C118,

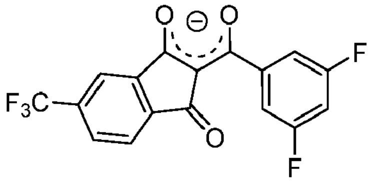

C119,

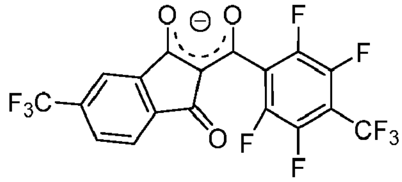

C120,

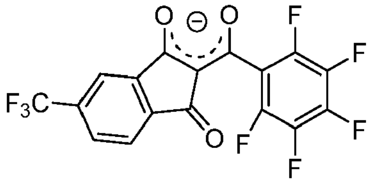

C121,

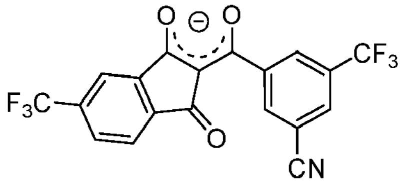

C122,

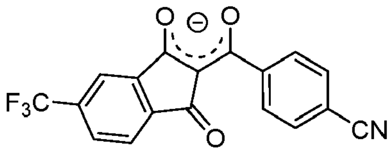

C123,

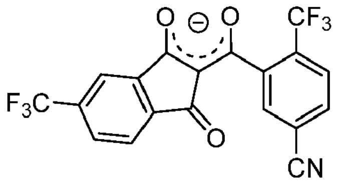

C124,

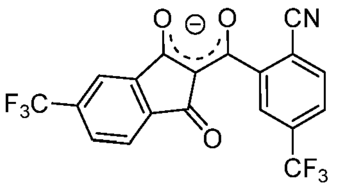

C125,

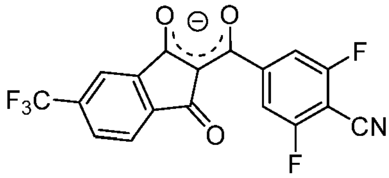

C126,

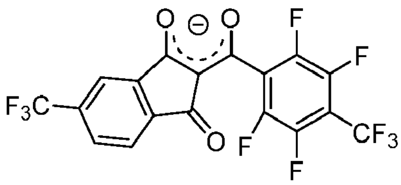

C127,

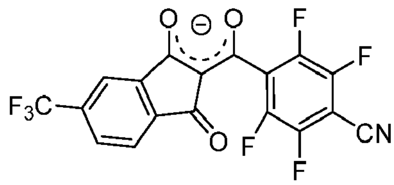

C128,

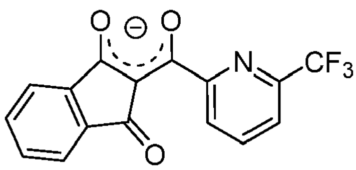

C129,

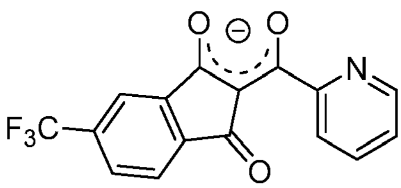

C130,

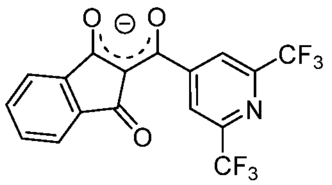

C131,

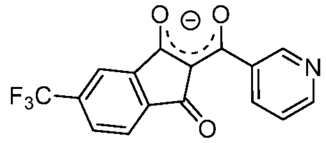

C132,

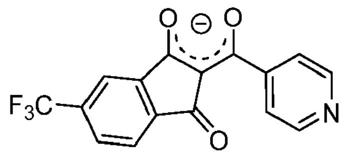

C133,

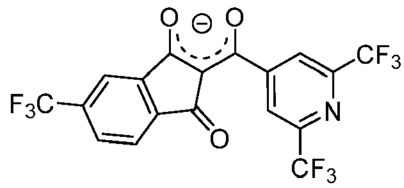

C134,

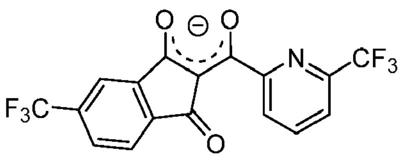

C135,

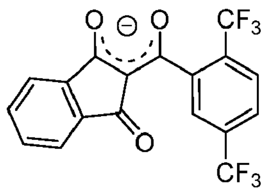

C136,

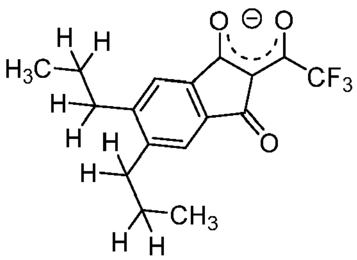

C137,

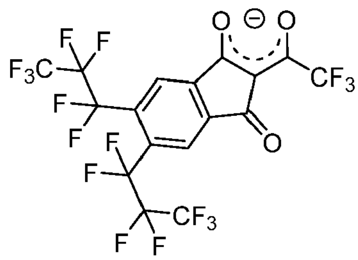

C138,

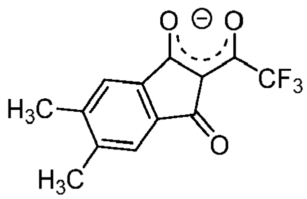

C139,

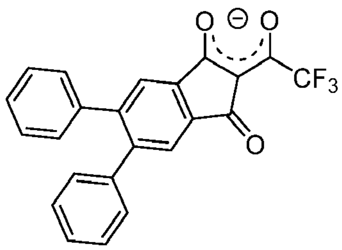

C140,

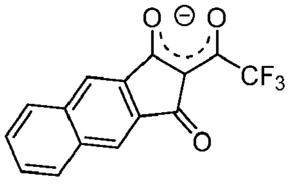

C141;

preferably, the ligand of formula (II) is selected from (C1) to (C24) (C29) to (C136) and (C141), especially preferred are

(C1), (C13), and (C29) to (C136).

According to one embodiment of the present invention, the compound of formula (I) is selected from one of the following formulae (A1) to (A127):

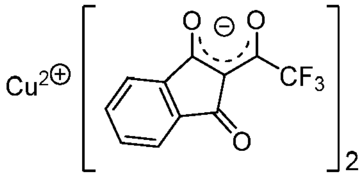

(A1)

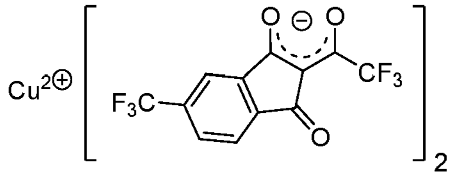

(A2)

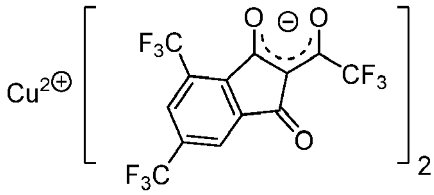

(A3)

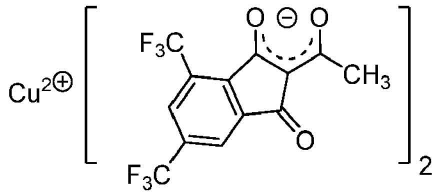

(A4)

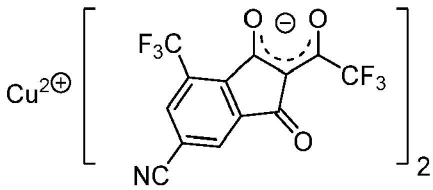

(A5)

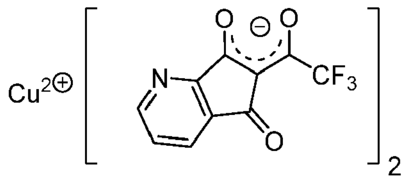

(A6)

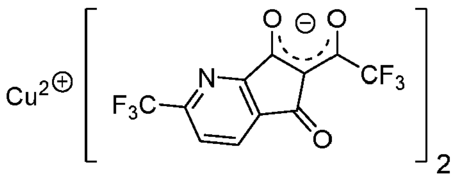

(A7)

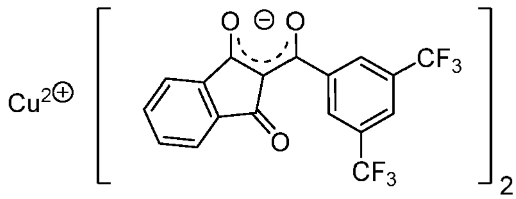

(A8)

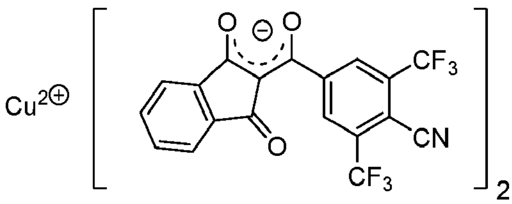

(A9)

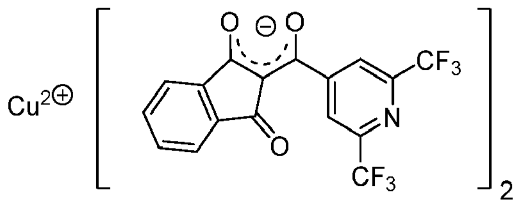

(A10)

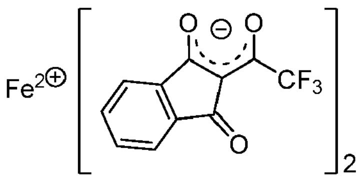

(A11)

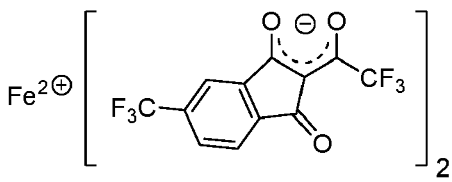

(A12)

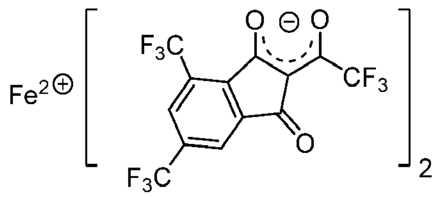

(A13)

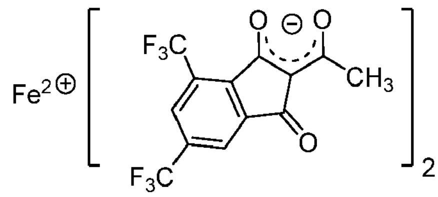

(A14)

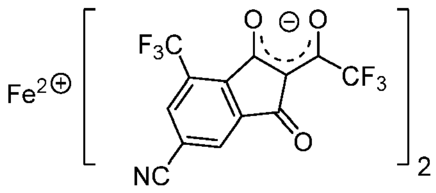

(A15)

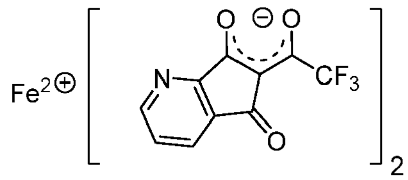

(A16)

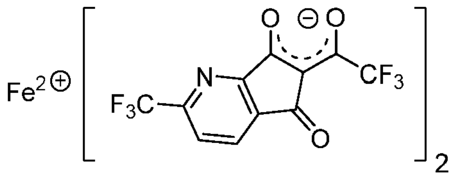

(A17)

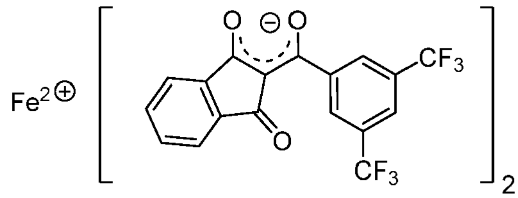

(A18)

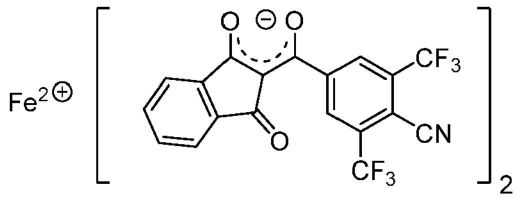

(A19)

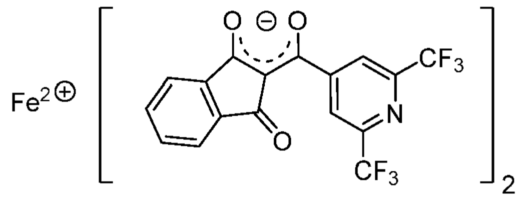

(A20)

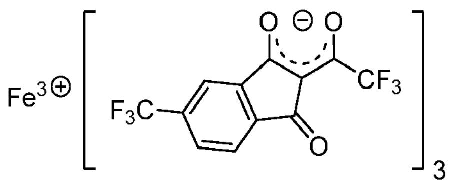

(A21)

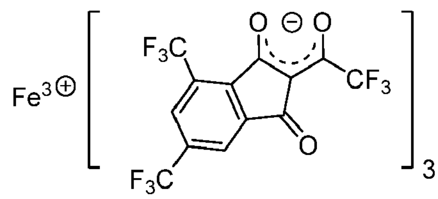

(A22)

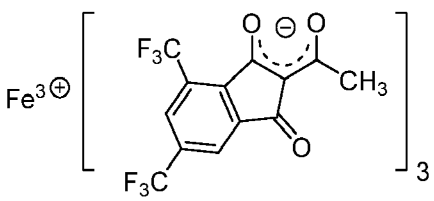

(A23)

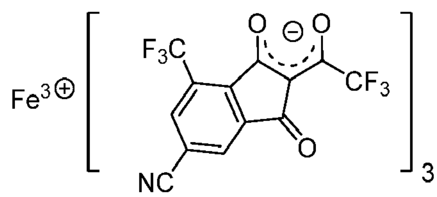

(A24)

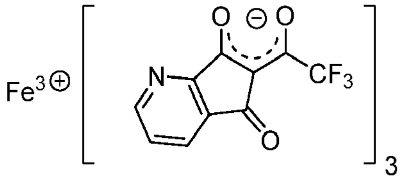

(A25)

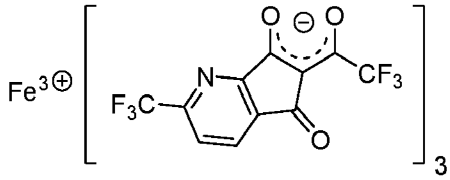

(A26)

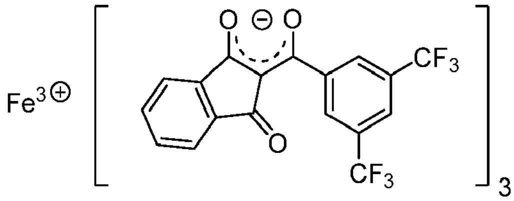

(A27)

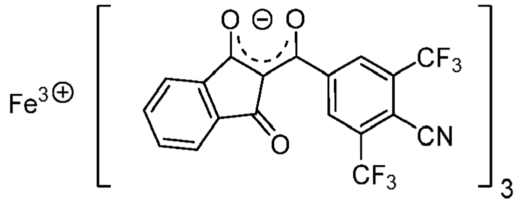

(A28)

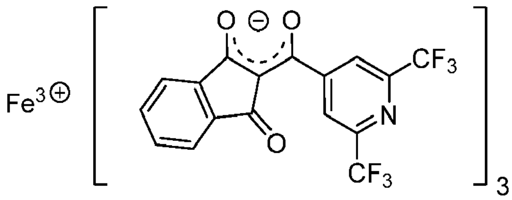

(A29)

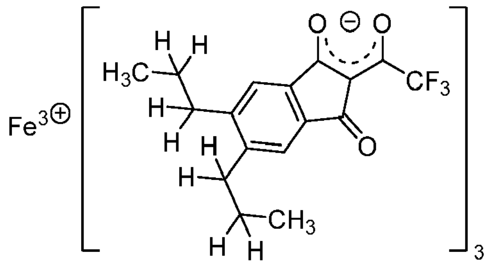

(A30)

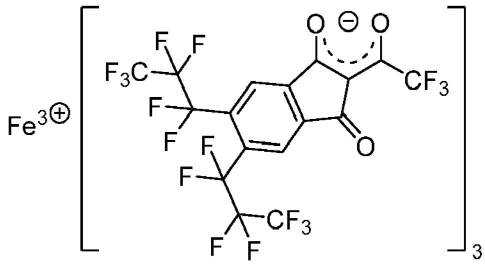

(A31)

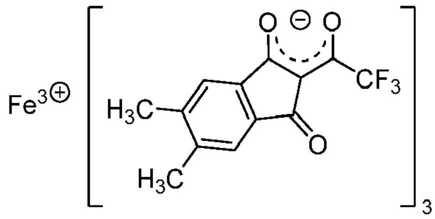

(A32)

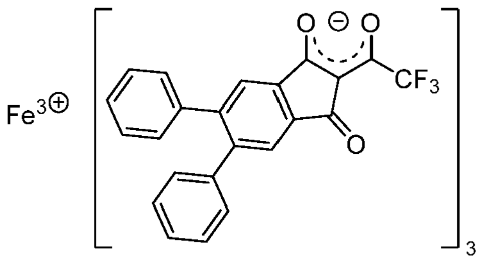

(A33)

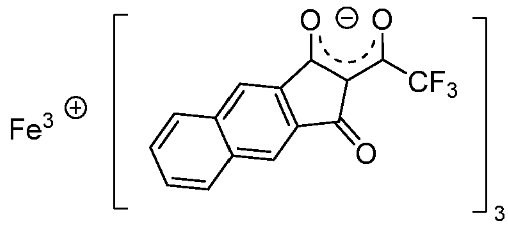

(A34)

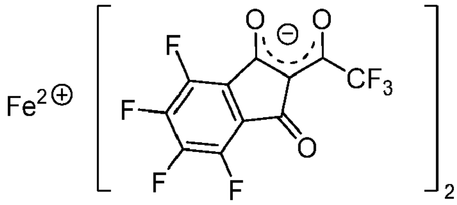

(A35)

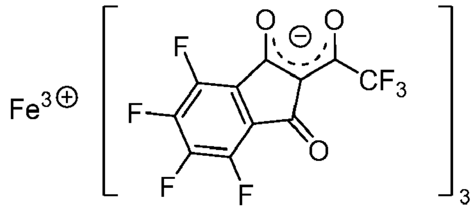

(A36)

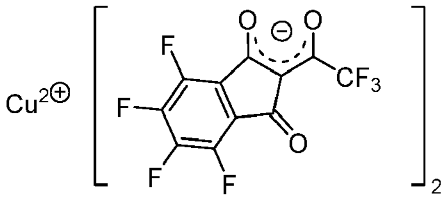

(A37)

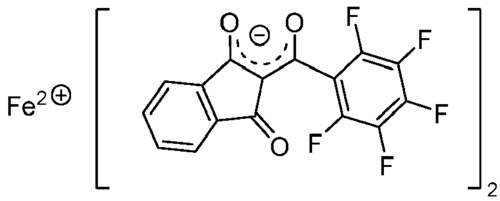

(A38)

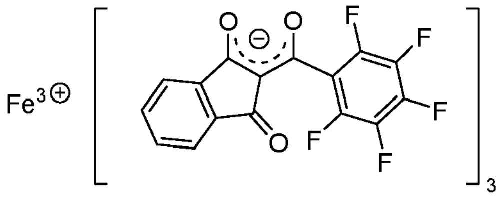

(A39)

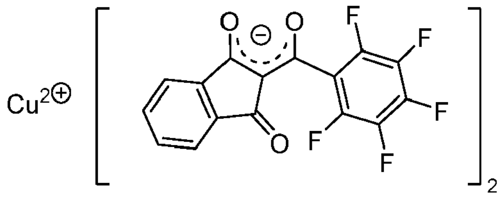

(A40)

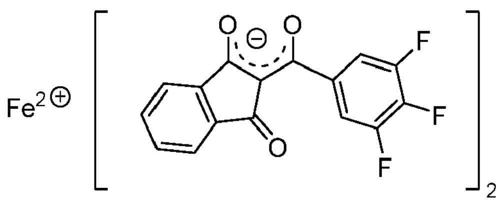

(A41)

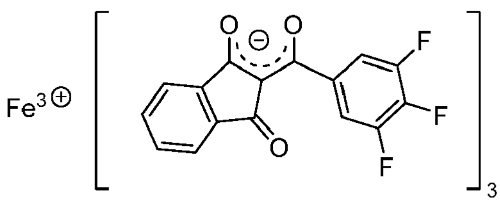

(A42)

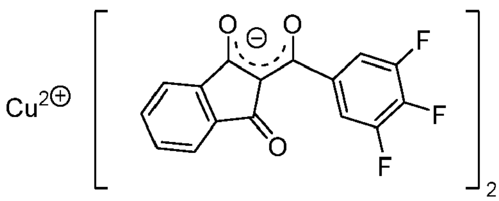

(A43)

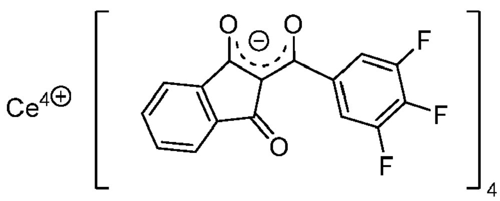

(A44)

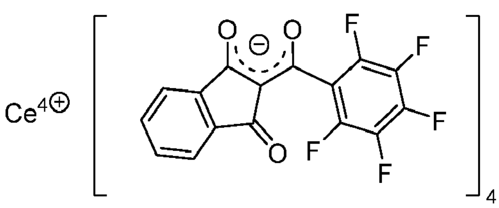

(A45)

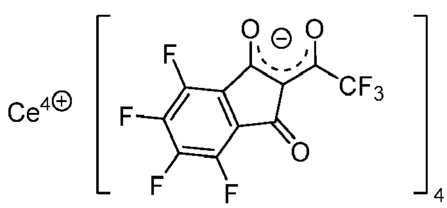

(A46)

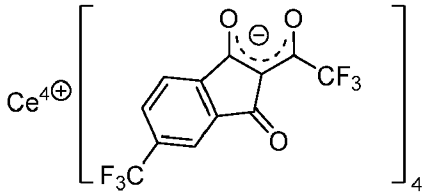
(A47)

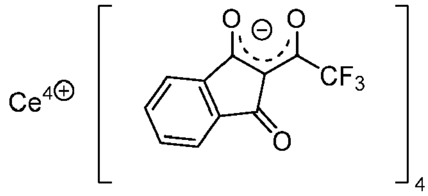
(A48)

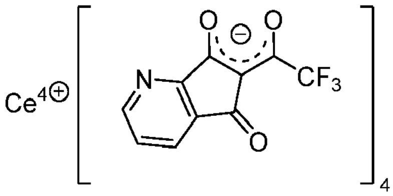
(A49)

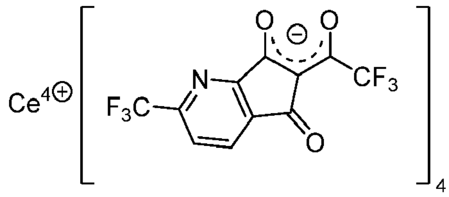
(A50)

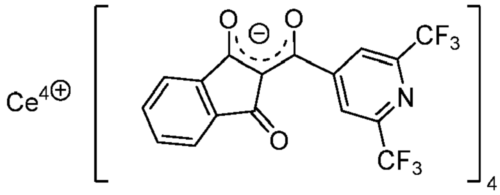
(A51.

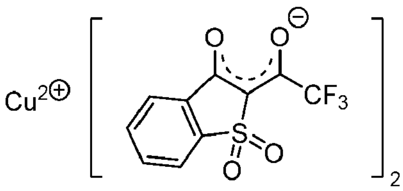
(A52),

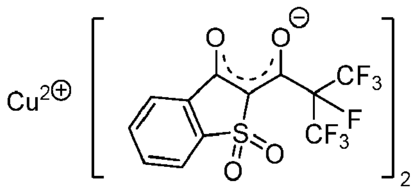
(A53),

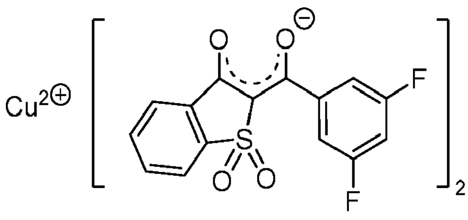
(A54),

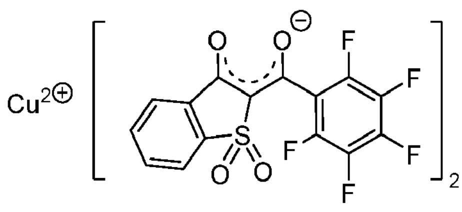
(A55),

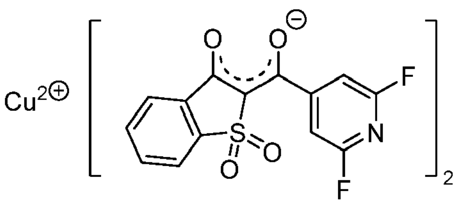
(A56),

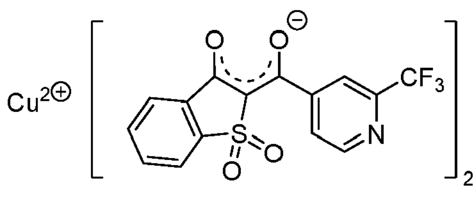
(A57),

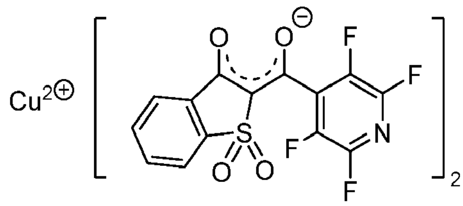
(A58),

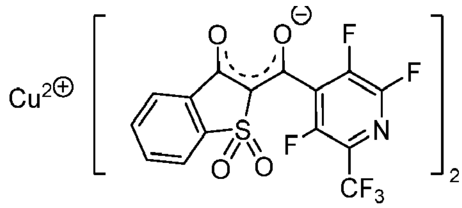
(A59),

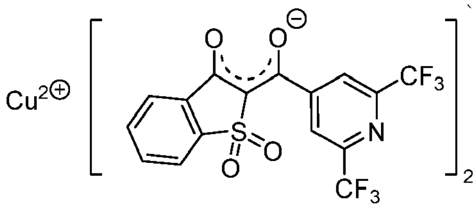
(A60),

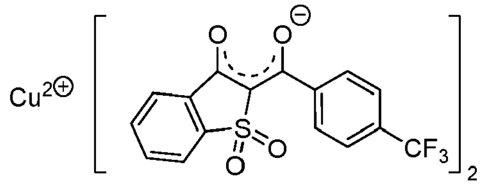
(A61),

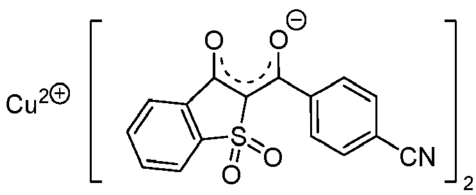
(A62),

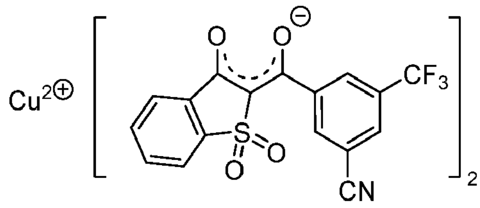
(A63),

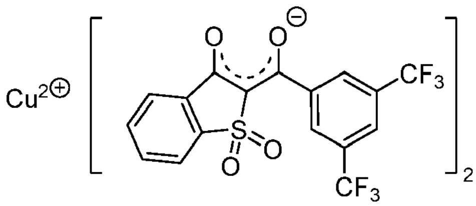
(A64),

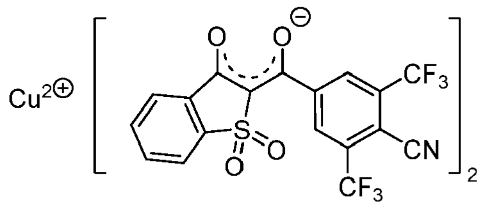
(A65),

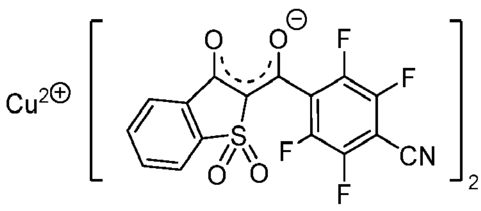
(A66),

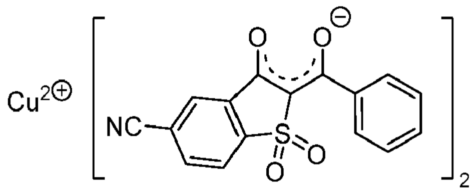
(A67),

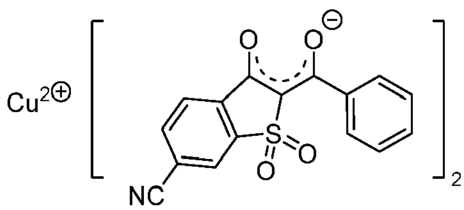
(A68),

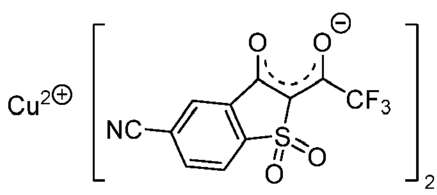
(a69),

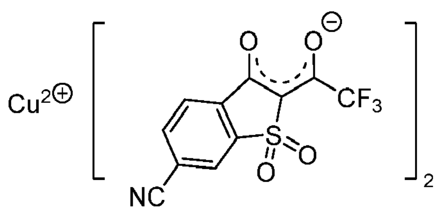
(A70),

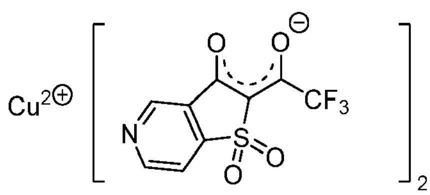
(A71),

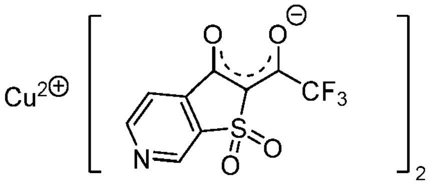 (A72), 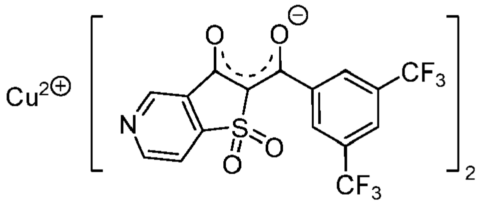 (A73),

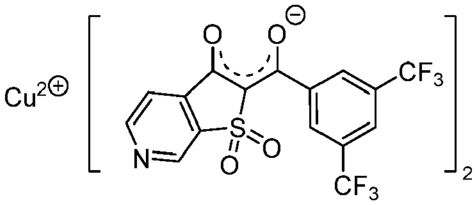 (A74), 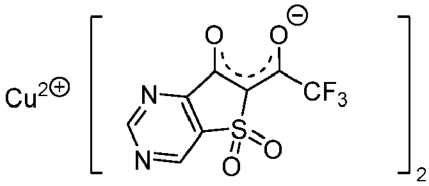 (A75),

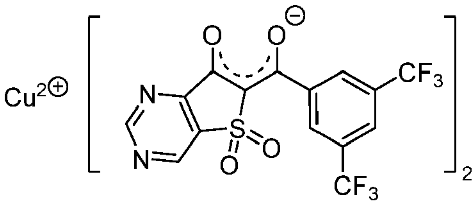 (A76), 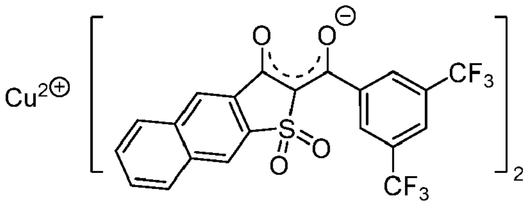 (A77),

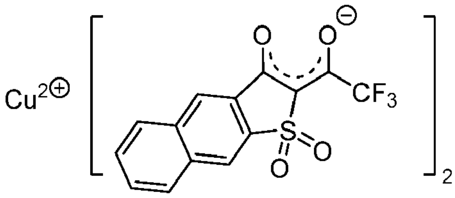 (A78), 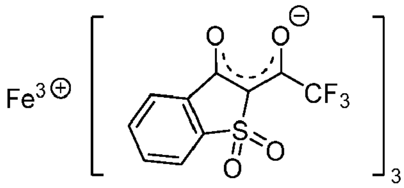 (A79),

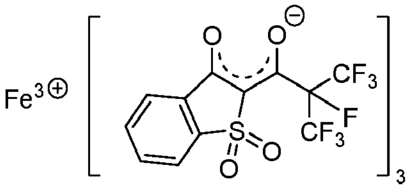 (A80), 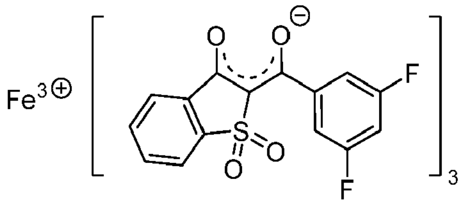 (A81),

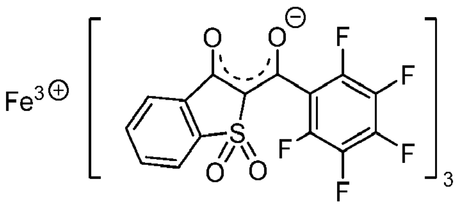 (A82), 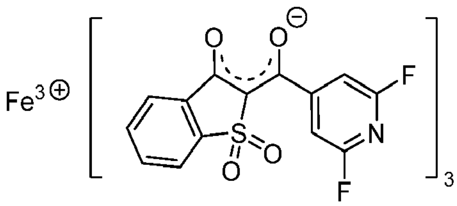 (A83),

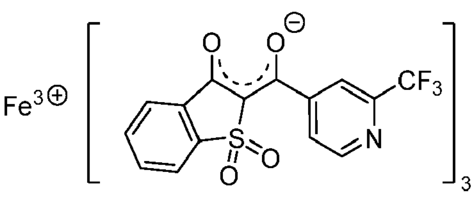 (A84), 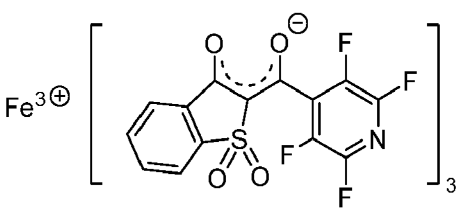 (A85),

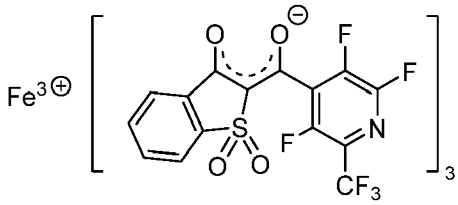 (A86),

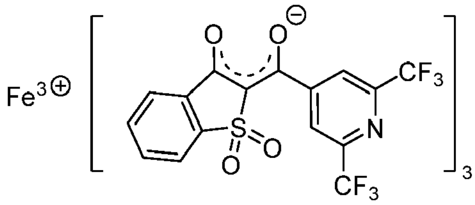 (A87),

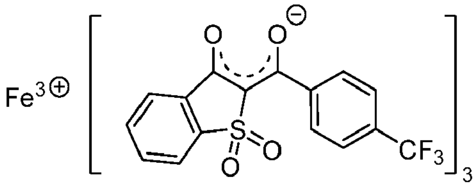 (A88),

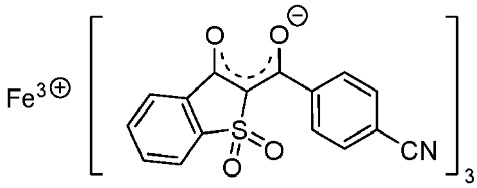 (A89),

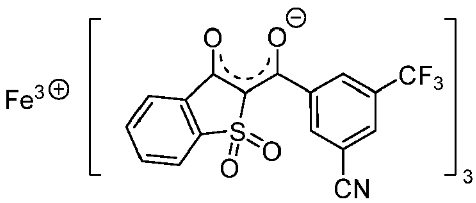 (A90),

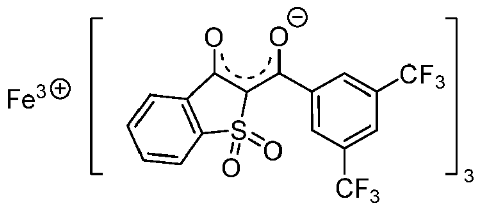 (A91),

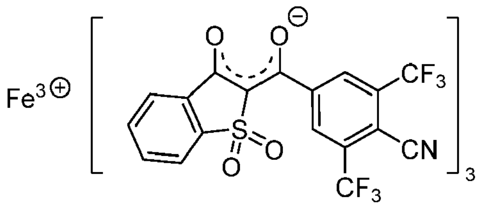 (A92),

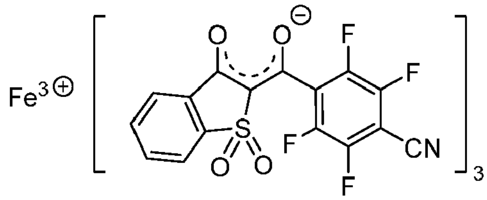 (A93),

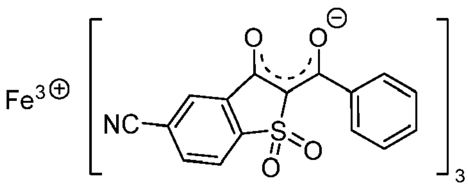 (A94),

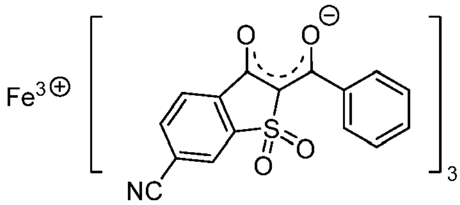 (A95),

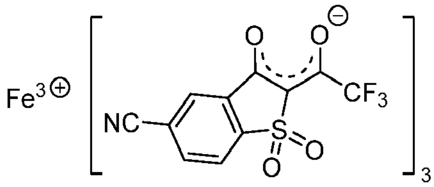 (A96),

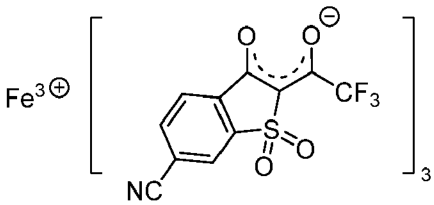 (A97),

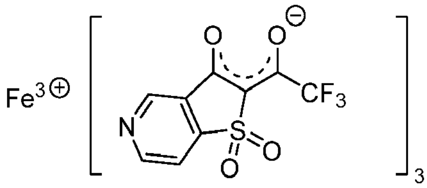 (A98),

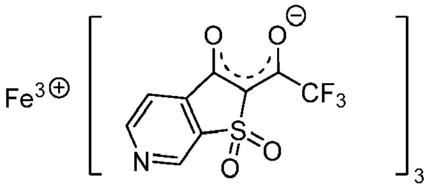 (A99),

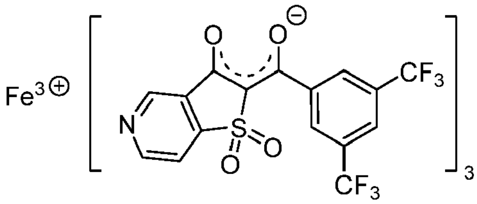 (A100), 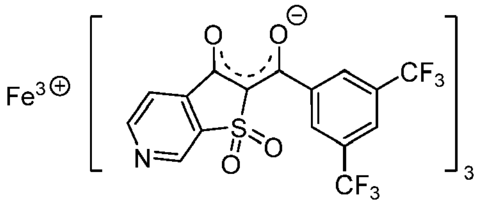 (A101),

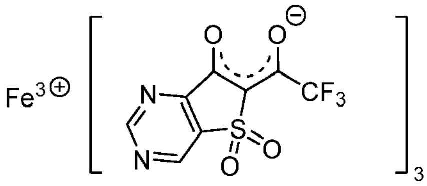 (A102), 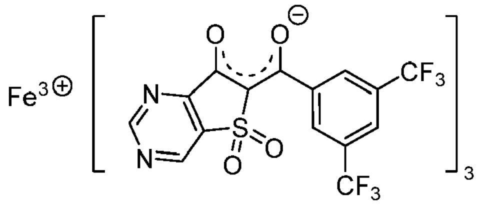 (A103),

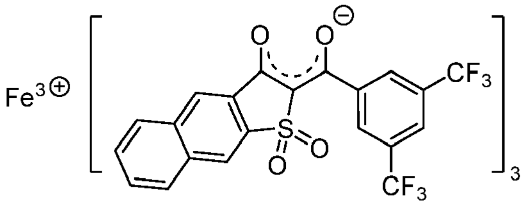 (A104), 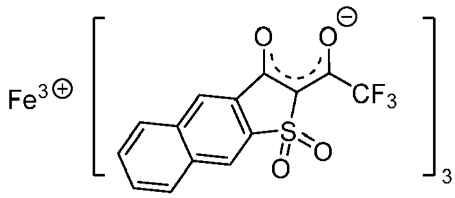 (A105),

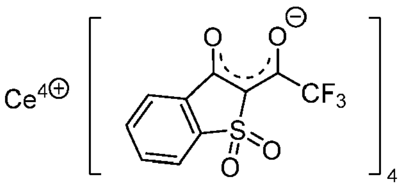 (A106), 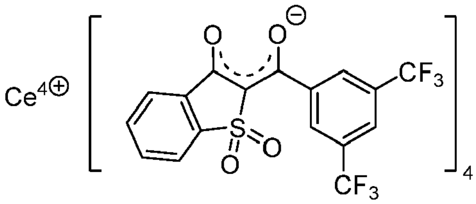 (A107),

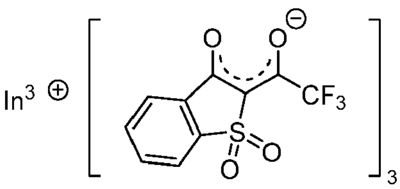 (A108), 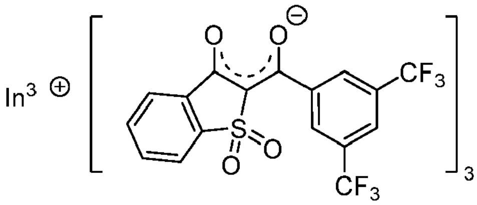 (A109),

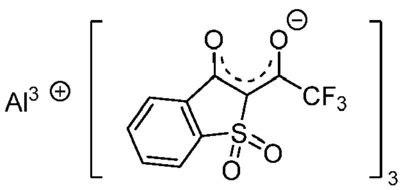 (A110), 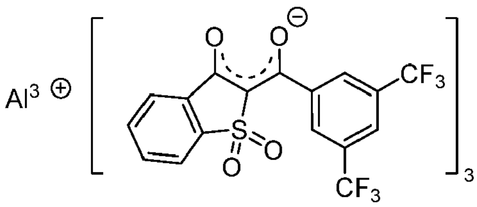 (A111),

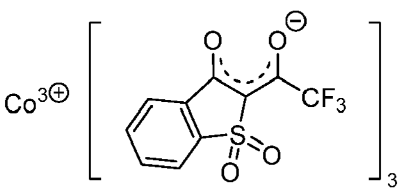 (A112), 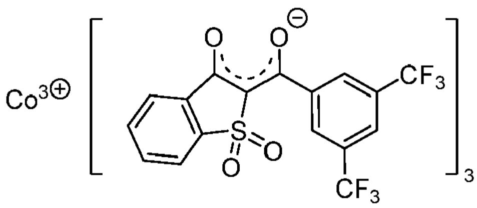 (A113),

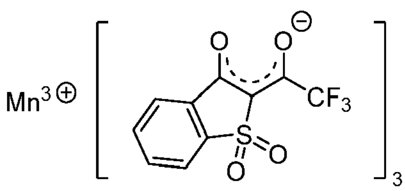 (A114), 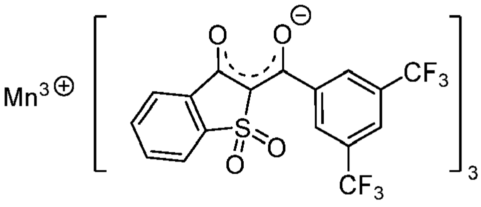 (A115),

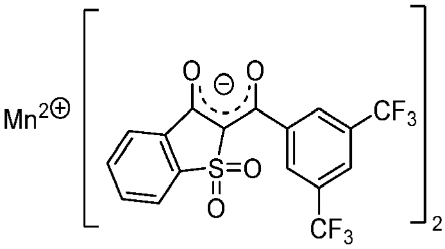 (A116), 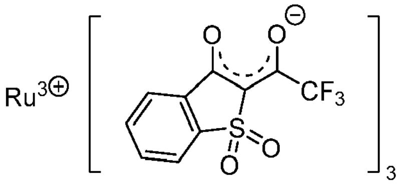 (a117),

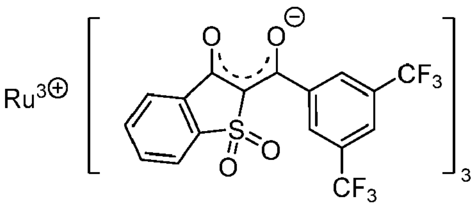 (A118), 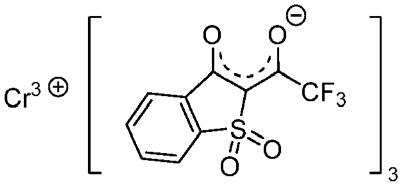 (A119),

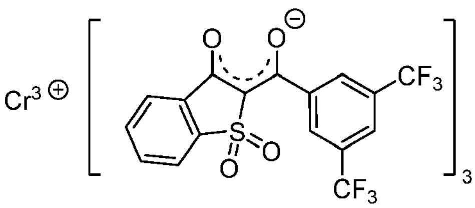 (A120), 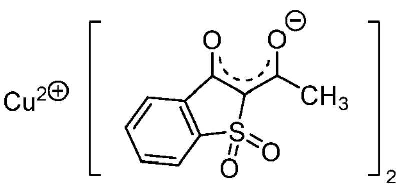 (A121),

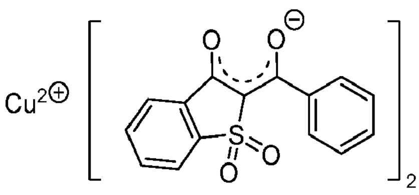 (A122), 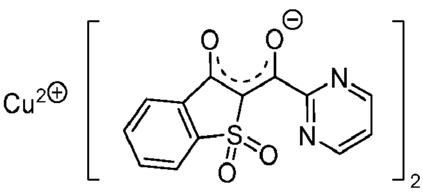 (A123),

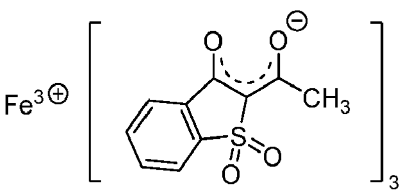 (A124), 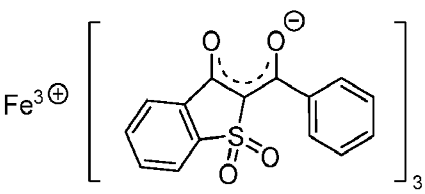 (A125),

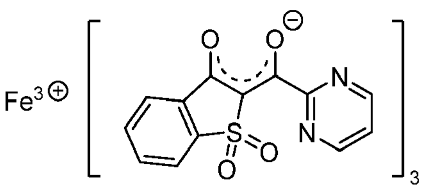 (A126); 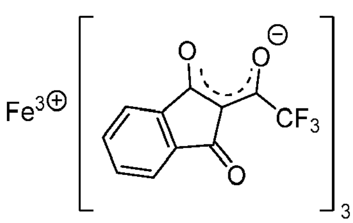 (A127) .

preferably compound of formula (I) is selected from formulae (A1) to (A43) and (A52) to (A120), and (A127).

The compound of formula (I) and the hole injection layer comprising a compound of formula (I) may be essentially non-emissive or non-emissive.

The concentration of the compound of formula (I) may be selected from 1 to 30 wt.-%, preferably from 2 wt.-% to 25 wt.-%, more preferred from 3 wt.-% to 15 wt.-%, based on the weight of the hole injection layer.

The concentration of the compound of formula (I) may be selected from 1 to 30 vol.-%, preferably from 2 vol.-% to 25 vol.-%, more preferred from 3 vol.-% to 15 vol.-% based on the volume of the hole injection layer.

p-type charge generation layer

The p-type charge generation layer may be formed on the anode layer or cathode layer by vacuum deposition, spin coating, printing, casting, slot-die coating, Langmuir-Blodgett (LB) deposition, or the like. When the a p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for example, from about 2 nm to about 15 nm, alternatively about 2 nm to about 12 nm.

According to an embodiment, the organic compound of formula (III) has a LUMO energy level of equal or less than - 4.30 eV; preferably -4.50 eV, more preferably -4.70 eV, still more preferably -4.90 eV, and most preferably -5.00 eV, wherein the LUMO energy level is calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment, the organic compound of formula (III) in the p-type charge generation layer is present in an amount of ≥0.01 vol% to ≤99.9 vol% based on the total volume of the first p-type charge generation layer, preferably ≥0.01 vol% to ≤99 vol%, more preferably ≥0.01 vol% to ≤95 vol%, more preferably ≥0.01 vol% to ≤90 vol%, more preferably ≥0.01 vol% to ≤80 vol%, more preferably ≥0.01 vol% to ≤70 vol%, more preferably 0.01 vol% to ≤60 vol%, more preferably ≥0.01 vol% to ≤50 vol%, more preferably ≥0.01 vol% to ≤40 vol%, more preferably ≥0.01 vol% to ≤30 vol%, more preferably ≥0.01 vol% to ≤20 vol%, and more preferably ≥0.01 vol% to ≤ 10 vol%,.

According to one embodiment, the compound of formula (III) is present in the p-type charge generation layer in an amount of ≥0.01 wt.-% to ≤99.9 wt.-% based on the total weight of the p-type charge generation layer, preferably ≥0.01 wt.-% to ≤99 wt.-%, more preferably ≥0.01 wt.-% to ≤95 wt.-%, more preferably ≥0.01 wt.-% to ≤90 wt.-%, more preferably ≥0.01 wt.-% to ≤80 wt.-%, more preferably ≥0.01 wt.-% to ≤70 wt.-%, more preferably ≥0.01 wt.-% to ≤60 wt.-%, more preferably ≥0.01 wt.-% to ≤50 wt.-%, more preferably ≥0.01 wt.-% to ≤40 wt.-%, more preferably ≥0.01 wt.-% to ≤30 wt.-%, more preferably ≥0.01 wt.-% to ≤20 wt.-%, more preferably ≥0.01 wt.-% to ≤ 10 wt.-%.

**Thickness of the first p-type charge generation layer**

The thickness of the first p-type charge generation layer may be in the range from 0.5 nm to 50 nm; alternatively in the range from 1 nm to about 40 nm; alternatively in the range of 2 nm to 30 nm; alternatively 3 nm to 25 nm; alternatively 4 nm to 20 nm; or alternatively 5nm to 15 nm.

If a second p-type charge generation layer or a second and third p-type charge generation layer is present, the thickness of the second n-type charge generation layer or the third charge generation layer can be independently of each other in the range from 0.5 nm to 50 nm; alternatively in the range from 1 nm to about 40 nm; or alternatively in the range of 2 nm to 30 nm; alternatively 3 nm to 25 nm, alternatively 4 nm to 20 nm; or alternatively 5nm to 15 nm.

Compound of formula (III)

n

According to an embodiment, n can be an integer selected from 0, 1, 2, 3, or 4.

According to a preferred embodiment, n can be an integer selected from 0, 1, or 2.

m

According to a preferred embodiment, m is 1.

$Y^1$, $Y^2$, and $Y^3$

According to an embodiment, $Y^1$, $Y^2$, and $Y^3$ are independently selected from $CR^{1a}R2^a$, $CR^{1b}R^{2b}$, $NR^{3a}$, $NR^{3b}$; wherein each $Y^2$ is selected the same or different, preferably the same, and each $Y^3$ can be selected the same or different.

According to an embodiment, $Y^1$, $Y^2$, and $Y^3$ are independently selected from $CR^{1a}R2^a$, $CR^{1b}R2^b$; wherein each $Y^2$ is selected the same or different, preferably the same, and wherein each $Y^2$ is selected the same or different, preferably the same, and wherein each $Y^3$ can be selected the same or different.

According to an embodiment, A of the organic compound of formula (III) is selected from a group of H1 to H72:

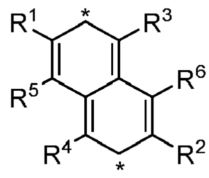
(H1),
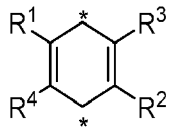
(H2),
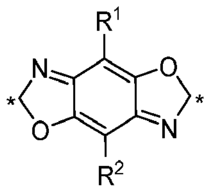
(H3),

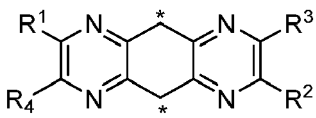
(H4),
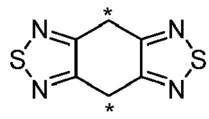
(H5),
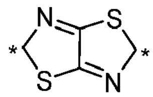
(H6),
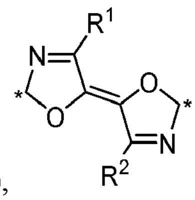
(H7),

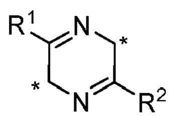
(H8),
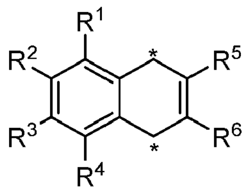
(H9),
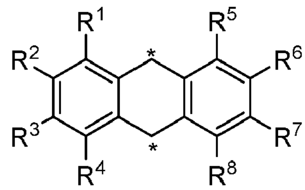
(H10),

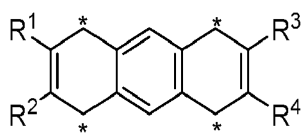
(H11),
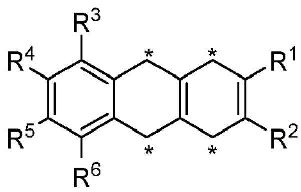
(H12),
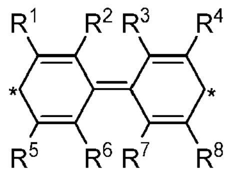
(H13),

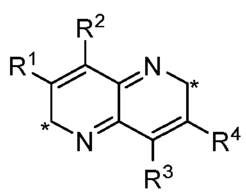
(H14),
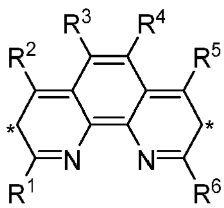
(H15),
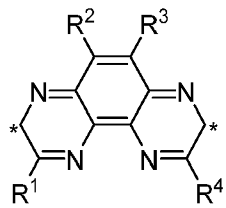
(H16),

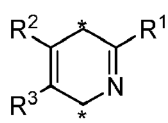
(H17),
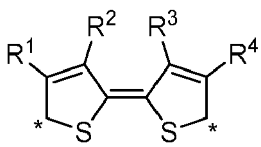
(H18),
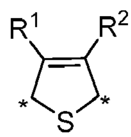
(H19),

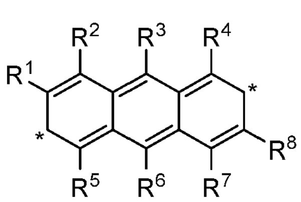 (H20), 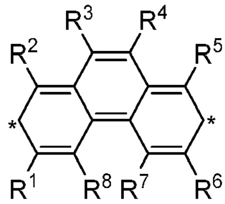 (H21), 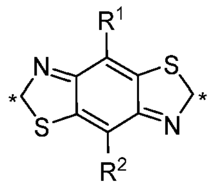 (H22), 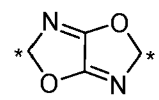

(H23), 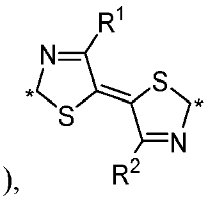 (H24), 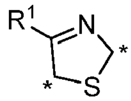 (H25), 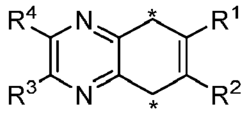 (H26), 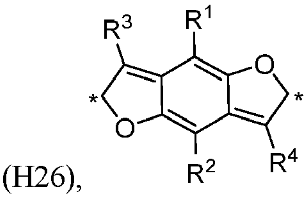 (H27),

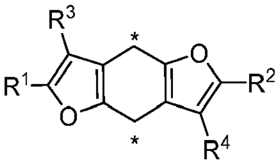 (H28), 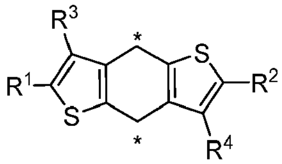 (H29), 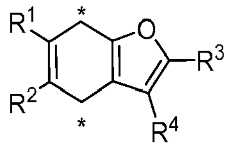 (H30),

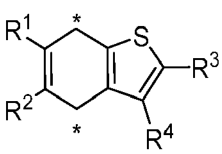 (H31), 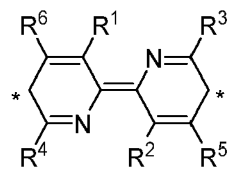 (H32), 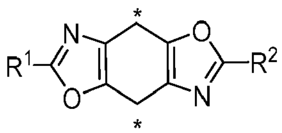 (H33),

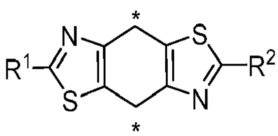 (H34), 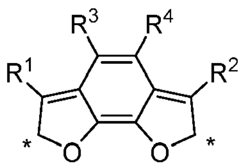 (H35), 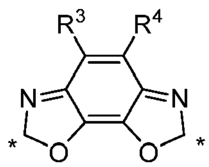 (H36),

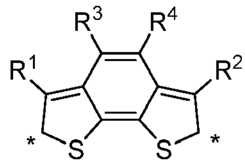 (H37), 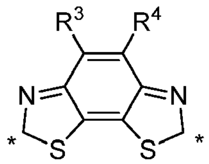 (H38),

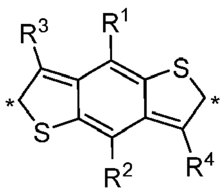 (H39), 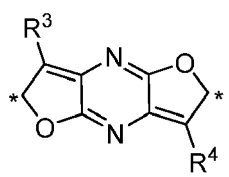 (H40), 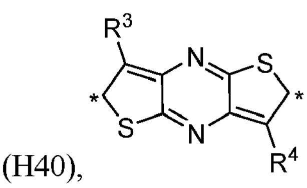 (H41), 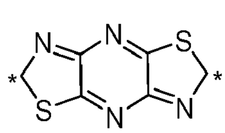

(H42), 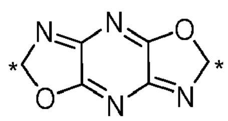 (H43), 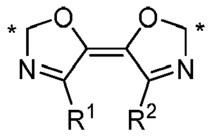 (H44), 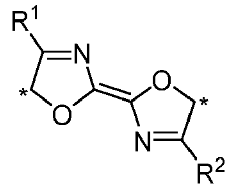 (H45),

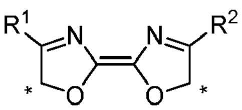 (H46), 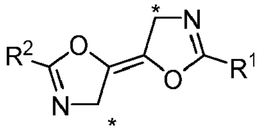 (E47), 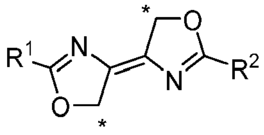 (E48),

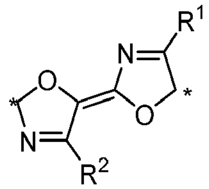 (H49), 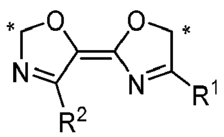 (H50), 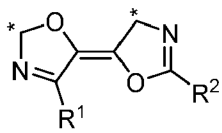 (H51), 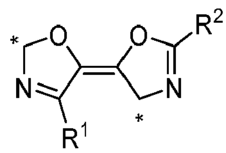

(H52), 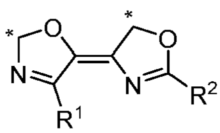 (H53), 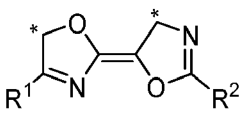 (H54), 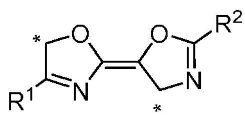 (H55),

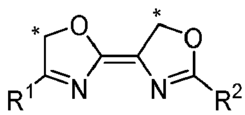 (H56), 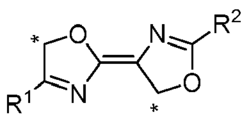 (H57), 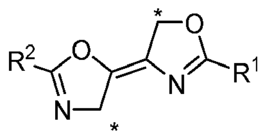 (H58),

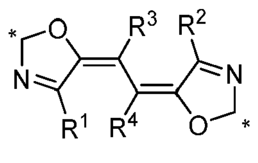 (H59), 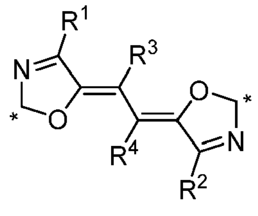 (H60), 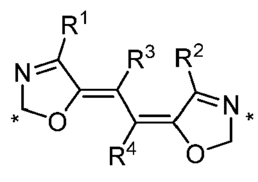 (H61),

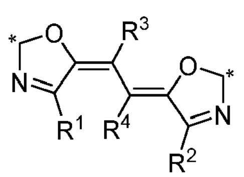 (H62), 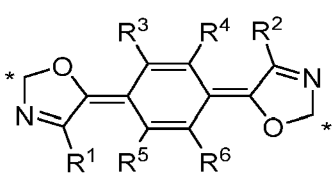 (H63), 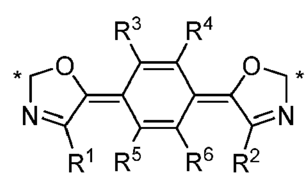 (H64),

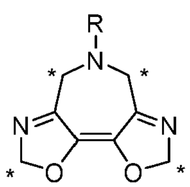 (H65), 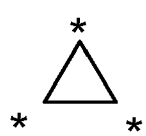 (H66), 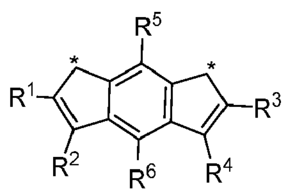 (H67),

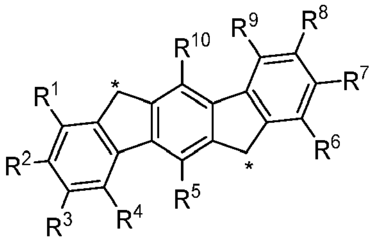 (H68), 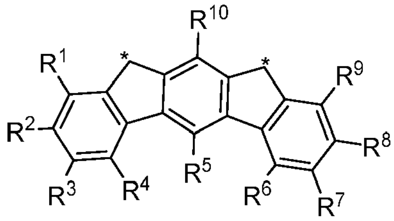 (H69),

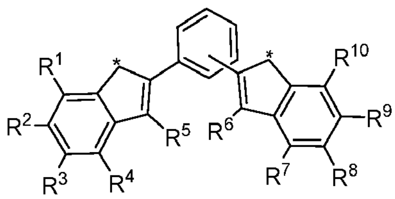 (H70), 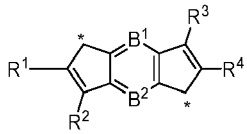 (H71), 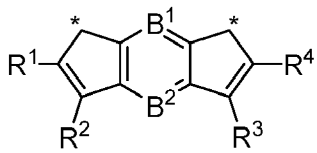 (H72),

wherein the asterisk "*" denotes the binding position;

$R^1$, $R^2$, $R^3$, $R^4$, $R^5$, $R^6$, $R^7$ and $R^8$ are independently selected from H, D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,
wherein the substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
$B^1$ and $B^2$ are independently of each other selected from N, $CR^{5A'}$, or $CR^{6A'}$, wherein
$CR^{5A'}$, or $CR^{6A'}$ are each independently selected from other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein

the one or more substituents on $CR^{5A'}$, or $CR^{6A'}$ are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl,
wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to an embodiment, A of organic compound of formula (III) is selected from a group of H1 to H27, H44 to H46, H49, H50 and H66 to H72:

According to an embodiment, A of organic compound of formula (III) is selected from one of the following moieties:

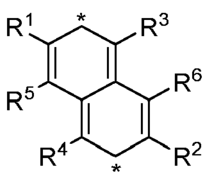 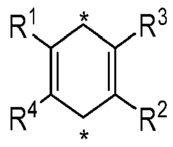 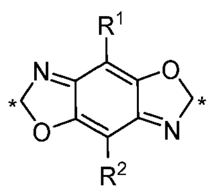

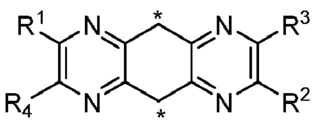
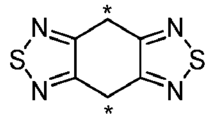
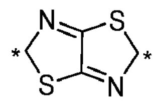
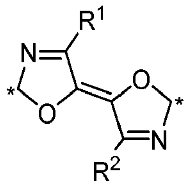
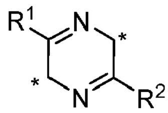
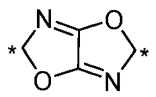
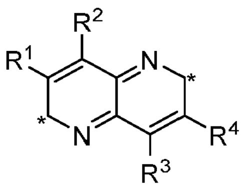
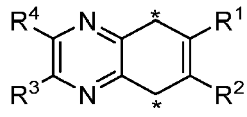
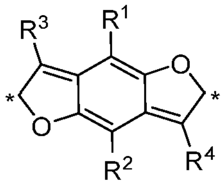
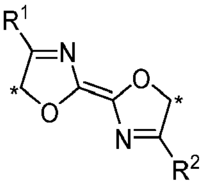
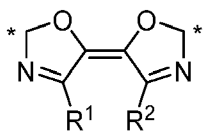
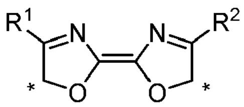
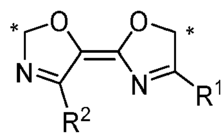
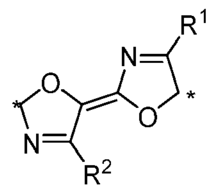
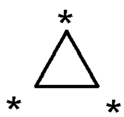
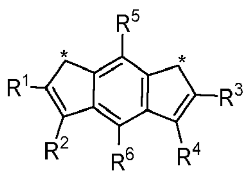
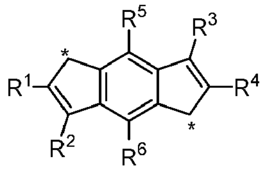
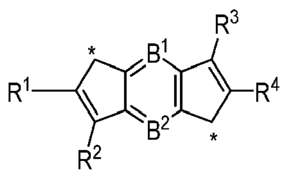
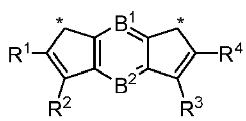

According to an embodiment, A of organic compound of formula (III) is selected from the following moieties:

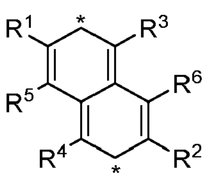
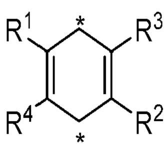
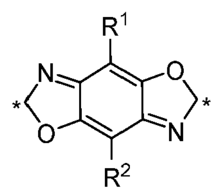

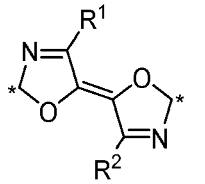
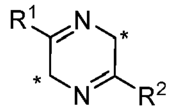
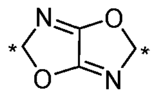
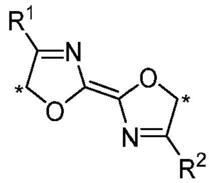
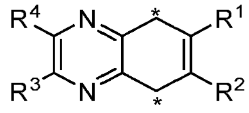
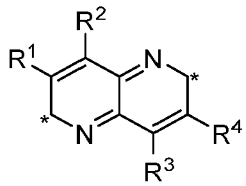
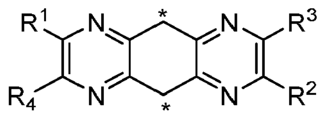
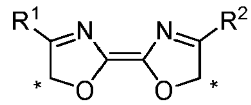
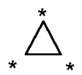
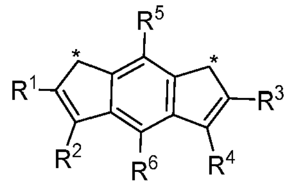
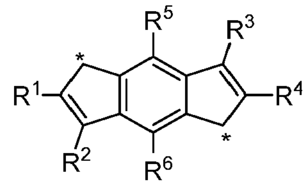
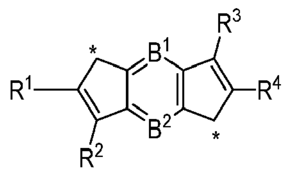
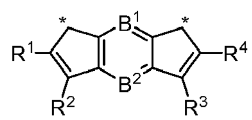

According to an embodiment, A of organic compound of formula (III) is selected from the following moieties:

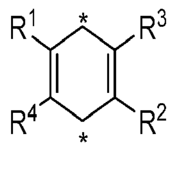
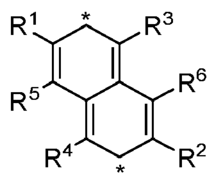
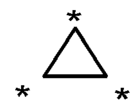
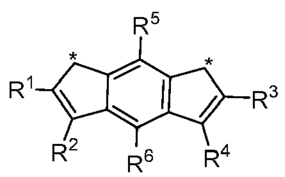
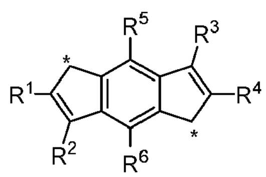
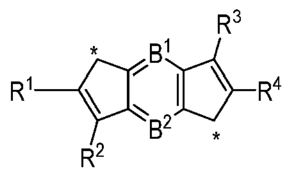
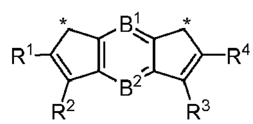

According to an embodiment, A of organic compound of formula (III) is selected from the following moieties:

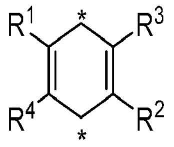 (H2), 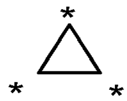 (H66), 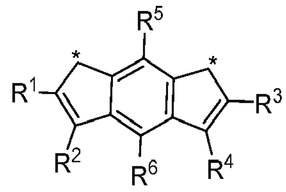 (H67),

or

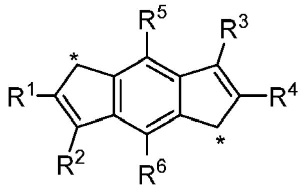 (H72).

According to an embodiment, the organic compound of formula (III) is selected from a organic compound of formula (V):

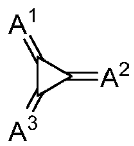 (V),

wherein in formula (V)

- $A^1$ is independently selected from a group of formula (Va):

  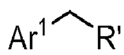 (Va),

  wherein

  $Ar^1$ is independently selected from substituted or unsubstituted aryl and substituted or unsubstituted heteroaryl, wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and

  wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
- $A^2$ is independently selected from a group of formula (Vb):

  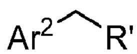 (Vb),

  wherein

  $Ar^2$ is independently selected from substituted or unsubstituted aryl and substituted or unsubstituted heteroaryl, wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and

  wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to

$C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Vc)

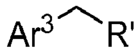 (Vc),

wherein

Ar³ is independently selected from substituted or unsubstituted aryl and substituted or unsubstituted heteroaryl, wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and

wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; and

wherein preferably the compound of formula (V) comprises at least two groups selected from aryl $C_6$ to $C_{19}$ aryl groups, or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, in the organic compound of formula (III)

n is an even integer including 0 preferably n is selected from 0, 2, or 4,
m is an integer selected from 1,
$Y^1$, $Y^2$, and $Y^3$ are independently selected from O, S, $CR^{1a}R2^a$, $CR^{1b}R^{2b}$, $NR^{3a}$, $NR^{3b}$; wherein each $Y^3$ can be selected the same or different,
wherein
$Y^1$, $Y^2$, and $Y^3$ can independently of each other form a fused ring with A;

wherein $R^{1a}$, $R^{2a}$, $R^{1b}$, and $R^{2b}$, are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,

wherein the one or more substituents on $R^{1a}$, $R^{2a}$, $R^{1b}$, and $R^{2b}$, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein $R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents on $R^{3a}$ and $R^{3b}$, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents - if present - of $C_6$ to $C_{30}$ aryl, $C_6$ to $C_{30}$ heteroaryl, $C_1$ to $C_8$ alkyl, $C_1$ to $C_8$

alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein A is selected from substituted or unsubstituted $C_3$ to $C_{40}$ cycloalkane group containing at least one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group, wherein $X^1$, each $X^2$, and each $X^3$ are conjugated to each other via a double-bond in A;

wherein the one or more substituents on A, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, the organic compound of formula (III) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the compound of formula (III) is selected from a compound comprising a indacenedione group, a radialene from a compound of formula (V), or a compound of formula (VIa) or (VIb):

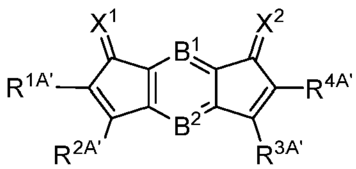
(VIa),
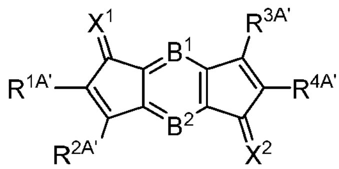
(VIb),

wherein

$B^1$ and $B^2$ are independently of each other selected from N, $CR^{5A'}$ or $CR^{6A'}$,

$R^{1A'}$, $R^{2A'}$, $R^{3A'}$, $R^{4A'}$, $R^{5A'}$, and $R^{6A'}$ are independently selected from each other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein

the one or more substituents on $CR^{5A'}$, or $CR^{6A'}$ are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl, wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$X^1$ and $X^2$ are independently of each other selected from formula (VII)

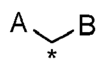
(VII),

wherein

A and B are independently of each other is selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably the compound of formula (VIa) or (VIb) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein
the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the organic compound of formula (III) is selected from a compound of formula (VIa) or (VIb), and the compound of formula (VIa) or (VIb) is represented by (VIIIa) or (VIIIb)

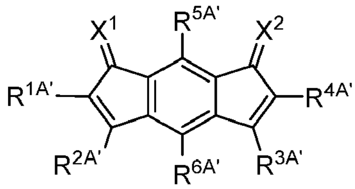
(VIIIa)
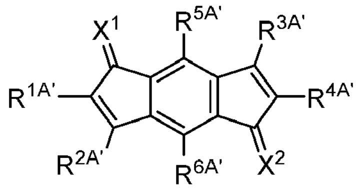
(VIIIb)

wherein

$R^{1A'}$, $R^{2A'}$, $R^{3A'}$, $R^{4A'}$, $R^{5A'}$, and $R^{6A'}$, are each independently of each other selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN; and
$X^1$ and $X^2$ are independently of each other selected from formula (IX)

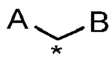
(IX)

wherein A and B are independently of each other is selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably the compound of formula (Villa) or (VIIIb) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, in formula (III), (VIa), (VIb) the one or more substituents - if present - of the aryl, heteroaryl, alkyl, alkoxy, and ether group, when present, are independently of each other selected from $C_1$ to $C_{12}$ alkyl, $C_1$ to $C_{12}$ alkoxy, a $C_1$ to $C_{15}$ heteroalkyl with 1 to 4 heteroatoms one among O, N, O, S, and Si, CN, halogen Cl, F, $CF_3$, $OCF_3$, $Si(CH_3)_3$.
According to an embodiment, the organic compound of formula (III), (V), (VIa), (VIb), (VIIIa), and/or (VIIIb) comprises at least one of the following moiety

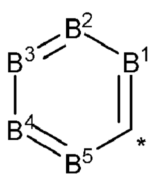

$B^1$ is selected from $CL^1$ or N;
$B^2$ is selected from $CL^2$ or N;
$B^3$ is selected from $CL^3$ or N;
$B^4$ is selected from $CL^4$ or N;

$B^5$ is selected from $CL^5$ or N;

$L^1$, $L^2$, $L^3$, $L^4$, and $L^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

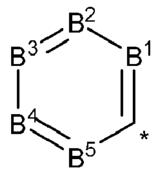

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;

$L^1$, $L^2$, $L^3$, $L^4$, and $L^5$ are independently selected from CN, partially fluorinated $C_1$ to $C_6$ alkyl, perfluorinated $C_1$ to $C_6$ alkyl, $CF_3$, $OCF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

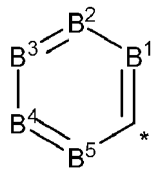

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;

$L^1$, $L^2$, $L^3$, $L^4$, and $L^5$ are independently selected from CN, partially fluorinated $C_1$ to $C_6$ alkyl, perfluorinated $C_1$ to $C_6$ alkyl, $CF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

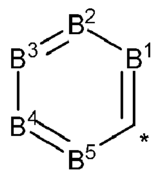

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;

$L^1$, $L^2$, $L^3$, $L^4$, and $L^5$ are independently selected from CN, partially fluorinated $C_1$ to $C_6$ alkyl, perfluorinated $C_1$ to

$C_6$ alkyl, $CF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

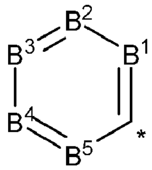

$B^1$ is selected from $CG^1$ or N;
$B^2$ is selected from $CG^2$ or N;
$B^3$ is selected from $CG^3$ or N;
$B^4$ is selected from $CG^4$ or N;
$B^5$ is selected from $CG^5$ or N;

$L^1$, $L^2$, $L^3$, $L^4$, and $L^5$ are independently selected from CN, $CF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

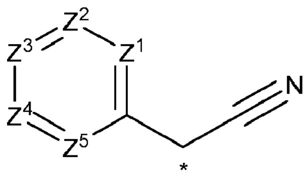

(XXa)

wherein

$Z^1$ is selected from $CV^1$ or N;
$Z^2$ is selected from $CV^2$ or N;
$Z^3$ is selected from $CV^3$ or N;
$Z^4$ is selected from $CV^4$ or N;
$Z^5$ is selected from $CV^5$ or N;

wherein
$V^1$, $V^2$, $V^3$, $V^4$, and $V^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

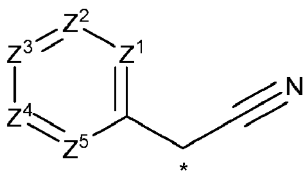

(XXa)

wherein

$Z^1$ is selected from $CV^1$ or N;
$Z^2$ is selected from $CV^2$ or N;
$Z^3$ is selected from $CV^3$ or N;
$Z^4$ is selected from $CV^4$ or N;

$Z^5$ is selected from $CV^5$ or N;

wherein
$V^1$, $V^2$, $V^3$, $V^4$, and $V^5$ are independently selected from CN, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

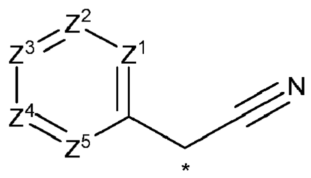
(XXa)

wherein

$Z^1$ is selected from $CV^1$ or N;
$Z^2$ is selected from $CV^2$ or N;
$Z^3$ is selected from $CV^3$ or N;
$Z^4$ is selected from $CV^4$ or N;
$Z^5$ is selected from $CV^5$ or N;

wherein
$V^1$, $V^2$, $V^3$, $V^4$, and $V^5$ are independently selected from CN, partially fluorinated $C_1$ to $C_6$ alkyl, perfluorinated $C_1$ to $C_6$ alkyl, $CF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moiety

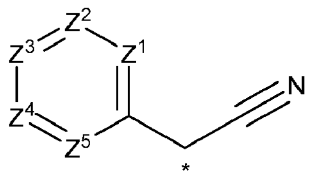
(XXa)

wherein

$Z^1$ is selected from $CV^1$ or N;
$Z^2$ is selected from $CV^2$ or N;
$Z^3$ is selected from $CV^3$ or N;
$Z^4$ is selected from $CV^4$ or N;
$Z^5$ is selected from $CV^5$ or N;

wherein
$V^1$, $V^2$, $V^3$, $V^4$, and $V^5$ are independently selected from CN, $CF_3$, halogen, Cl, F, D or H; wherein the asterisk "*" denotes the binding position.

According to an embodiment, the organic compound of formula (III), (V), (VIa), (VIb), (VIIIa), and/or (VIIIb) comprises at least one of the following moieties:

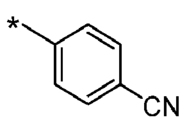 (L1), 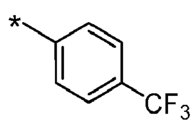 (L2), 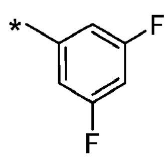 (L3), 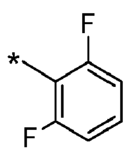 (L4),

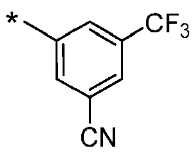 (L5), 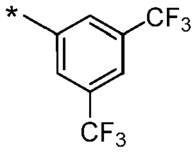 (L6), 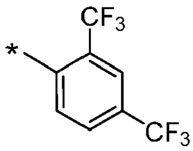 (L7), 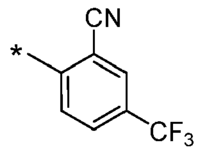 (L8),

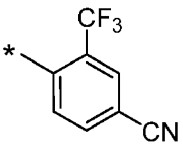 (L9), 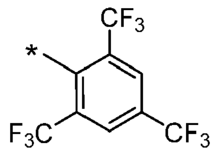 (L10), 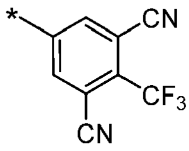 (L11), 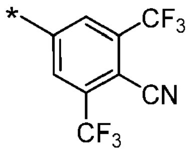 (L12),

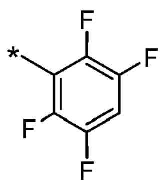 (L13), 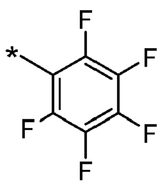 (L14), 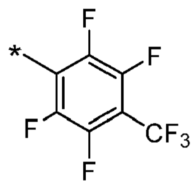 (L15), 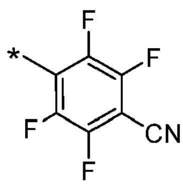 (L16),

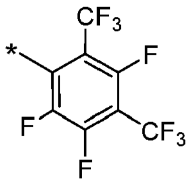 (L17), 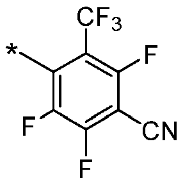 (L18), 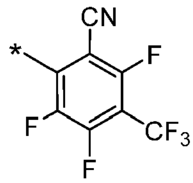 (L19), 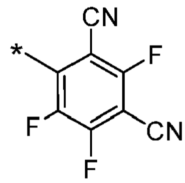 (L20),

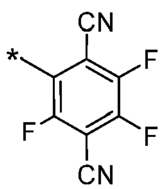 (L21), 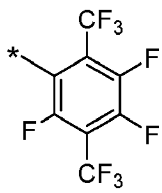 (L22), 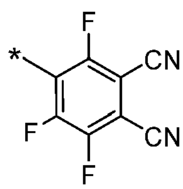 (L23), 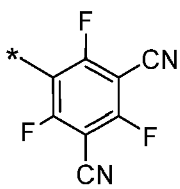 (L24),

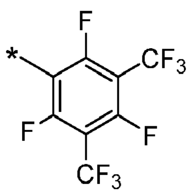 (L25), 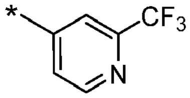 (L26), 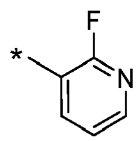 (L27), 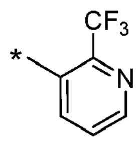 (L28),

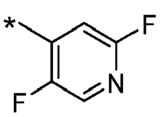 (L29), 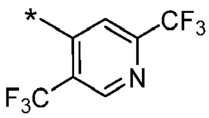 (L30), 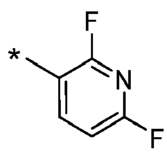 (L31), 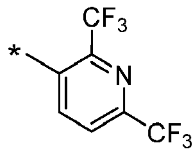 (L32),

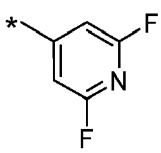 (L33), 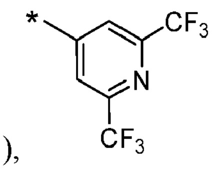 (L34), 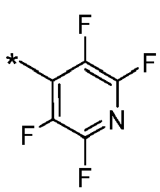 (L35), 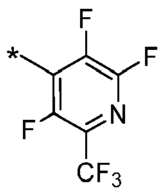 (L36),

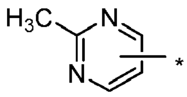 (L37), 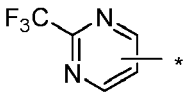 (L38), 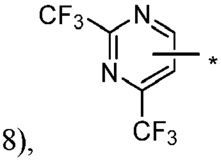 (L39), 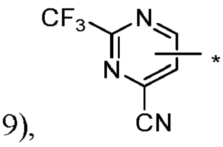 (L40),

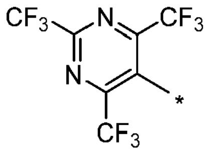 (L41), 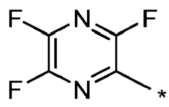 (L42), 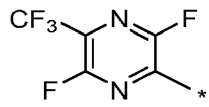 (L43), 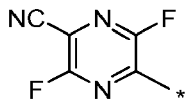 (L44),

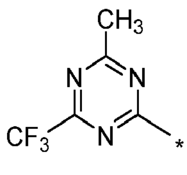 (L45), 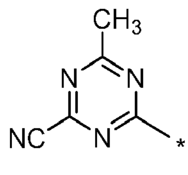 (L46), 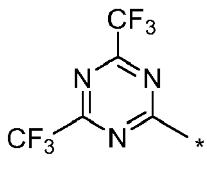 (L47), 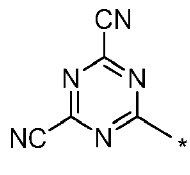 (L48),

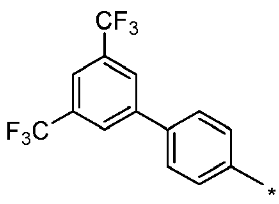 (L49), 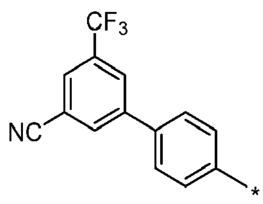 (L50), 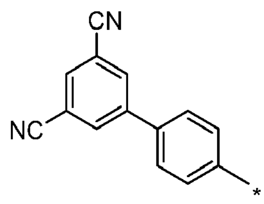 (L51).

According to one embodiment, the compound of formula (III) is selected from a compound of G1 to G27:

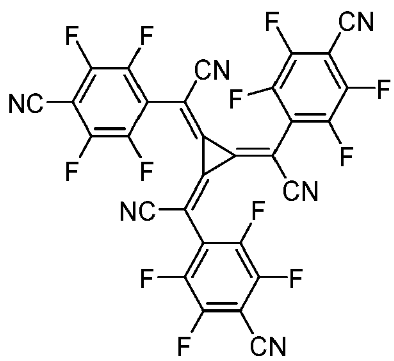 (G1), 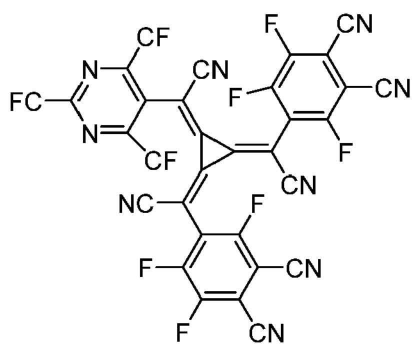 (G2),

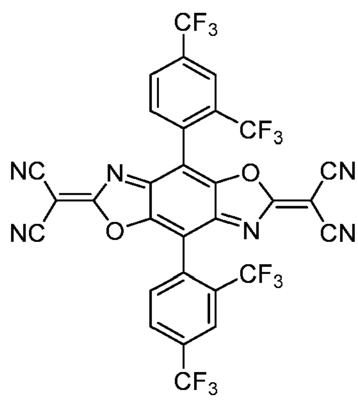 (G3), 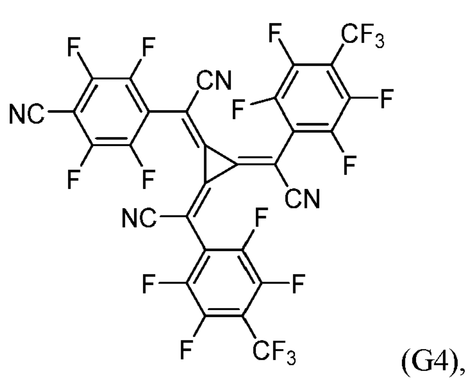 (G4),

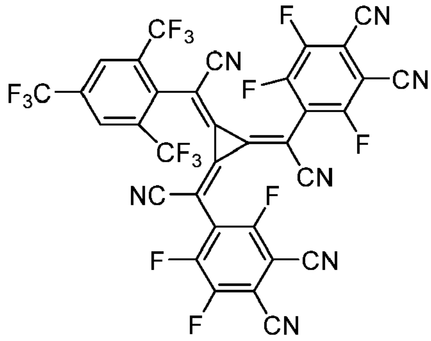
(G5),

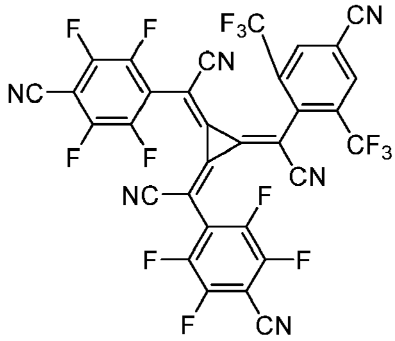
(G6),

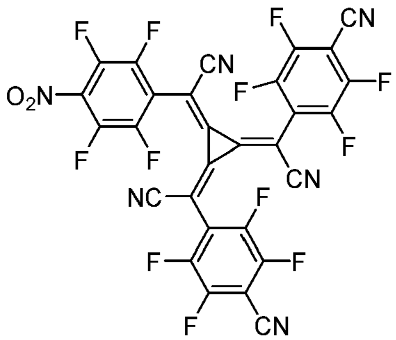
(G7),

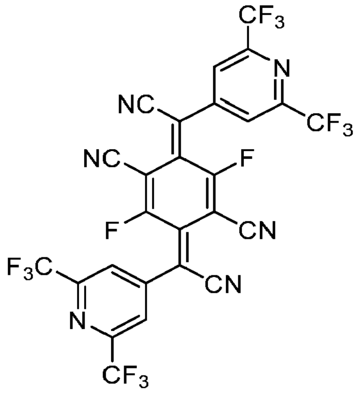
(G8),

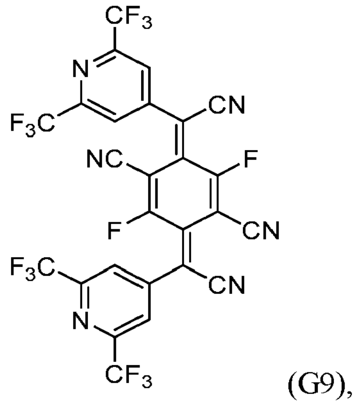
(G9),

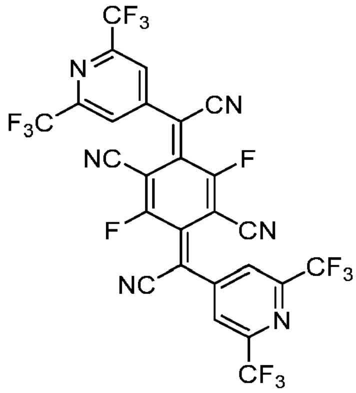
(G10),

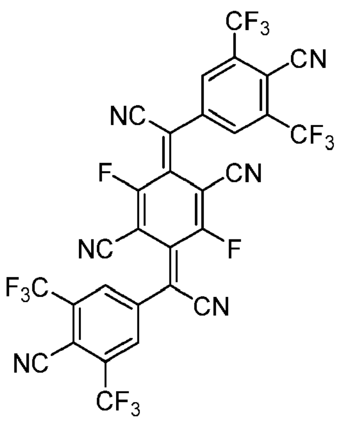
(G11),

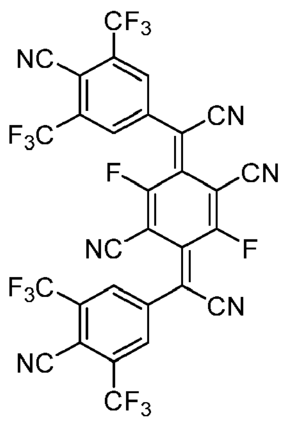
(G12),

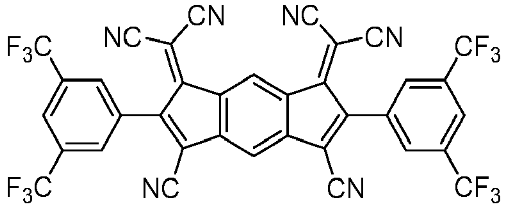 (G13), 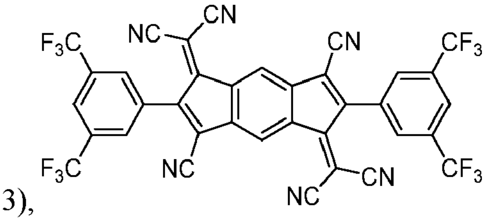 (G14),

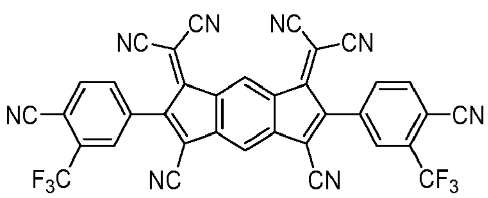 (G15), 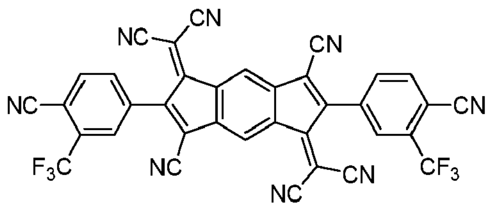 (G16),

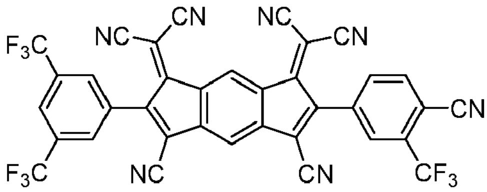 (G17), 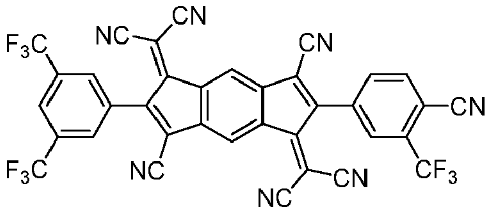 (G18),

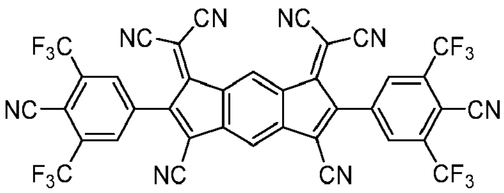 (G19), 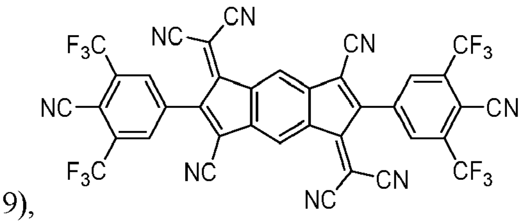 (G20),

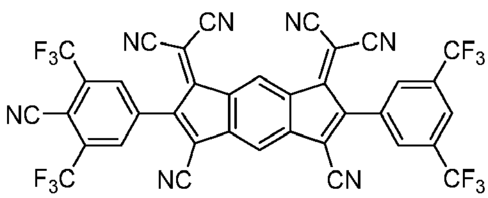 (G21), 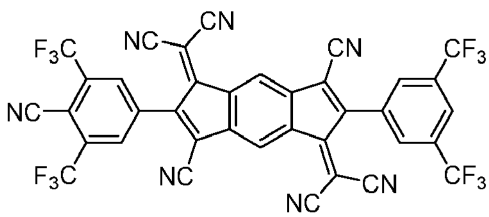 (G22),

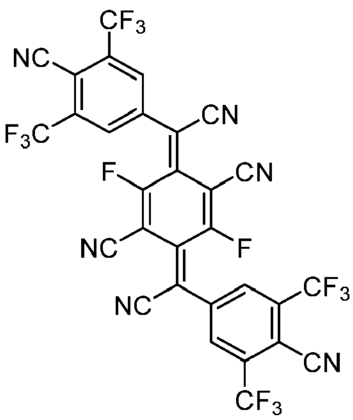 (G23), 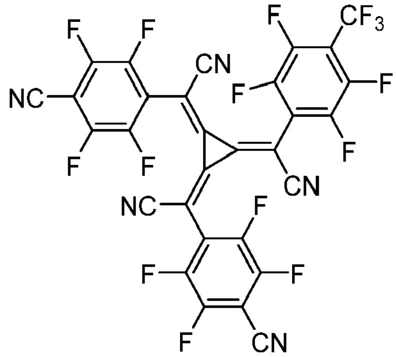 (G24),

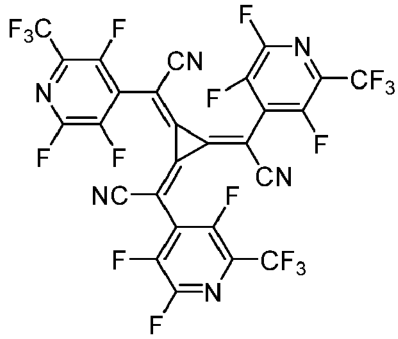
(G25),

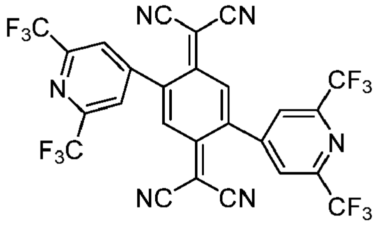
(G26),
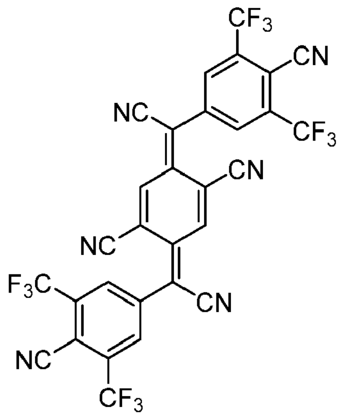
(G27).

**Hole transport material for pHIL and p-CGL**

According to an embodiment, the hole injection layer and/or the p-type charge generation layer comprises at least one arylamine compound, diarylamine compound, triarylamine compound, a compound of formula (IVa) or a compound of formula (IVb):

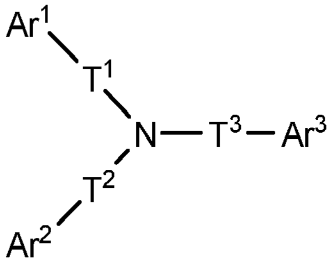
(IVa),
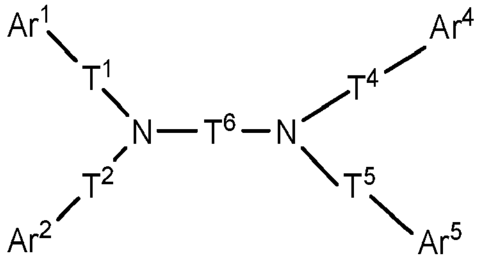
(IVb),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or

unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (IIIa) 6-member ring of an aromatic non-heterocycle;
wherein
the substituents of $Ar^1$, $Ar^2$, $Ar^3$, $Ar^4$ and $Ar^5$ are selected the same or different from the group comprising H, D, F, C(-O) $R^2$, CN, $Si(R^2)_3$, $P(-O)(R^2)_2$, $OR^2$, $S(-O)R^2$, $S(-O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Preferably, the substituents of $Ar^1$, $Ar^2$, $Ar^3$, $Ar^4$ and $Ar^5$ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl, $C_3$ to $C_{18}$ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

<u>Compound of formulae (IVa) and (TVb)</u>

According to an embodiment, the hole injection layer and/or the p-type charge generation layer comprises a compound of formula (IVa) or formula (IVb).

According to one embodiment of the present invention, the compound of formula (IVa) or (IVb) is a matrix compound, preferably a substantially covalent matrix compound.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to an embodiment $T^1$, $T^2$, and $T^3$ may be independently selected from a single bond, phenylene, biphenylene or terphenylene. According to an embodiment $T^1$, $T^2$, and $T^3$ may be independently selected from phenylene, biphenylene or terphenylene and one of $T^1$, $T^2$, and $T^3$ are a single bond. According to an embodiment $T^1$, $T^2$, and $T^3$ may be independently selected from phenylene or biphenylene and one of $T^1$, $T^2$, and $T^3$ are a single bond. According to an embodiment $T^1$, $T^2$, and $T^3$ may be independently selected from phenylene or biphenylene and two of $T^1$, $T^2$, and $T^3$ are a single bond.

According to an embodiment, $T^1$, $T^2$ and $T^3$ may be independently selected from phenylene and one of $T^1$, $T^2$ and $T^3$ are a single bond. According to an embodiment, $T^1$, $T^2$ and $T^3$ may be independently selected from phenylene and two of $T^1$, $T^2$ and $T^3$ are a single bond.

According to one embodiment of the present invention $Ar^1$, $Ar^2$, and $Ar^3$ are independently selected from (E1) to (E16):

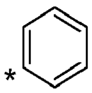 (E1), 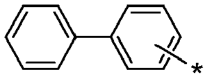 (E2), 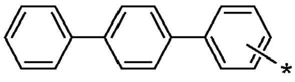 (E3), 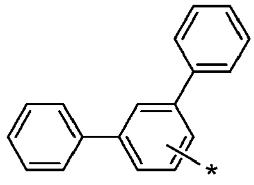 (E4),

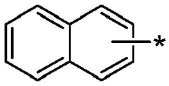 (E5), 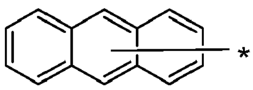 (E6), 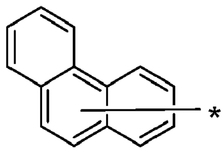 (E7), 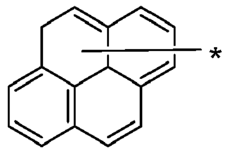 (E8),

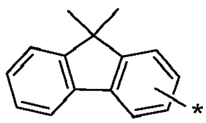 (E9), 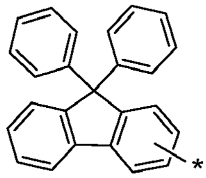 (E10), 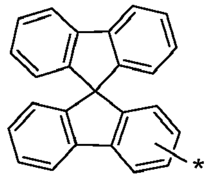 (E11),

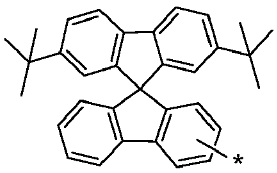 (E12), 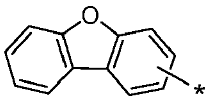 (E13), 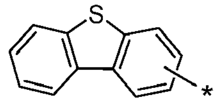 (E14),

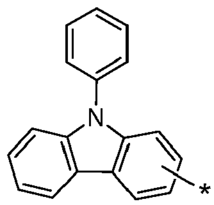 (E15), and 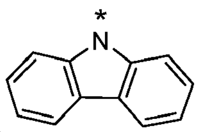 (E16),

wherein the asterisk "*" denotes the binding position.

According to an embodiment, $Ar^1$, $Ar^2$, and $Ar^3$ may be independently selected from E1 to E15; alternatively selected from E1 to E10 and E13 to E15.

According to an embodiment, $Ar^1$, $Ar^2$, $Ar^3$, $Ar^4$ and $Ar^5$ may be independently selected from the group consisting of E1, E2, E5, E7, E9, E10, E13 to E16.

The rate onset temperature may be in a range particularly suited to mass production, when $Ar^1$, $Ar^2$, and $Ar^3$ are selected in this range.

The compounds according to formula (IVa) or (IVb) may be also referred to as "hole transport compound".

According to one embodiment, the compound according to formula (IVa) or (IVb) comprises at least one naphthyl group, carbazole group, dibenzofuran group, dibenzothiophene group and/or substituted fluorenyl group, wherein the substituents are independently selected from methyl, phenyl or fluorenyl.

According to one embodiment of the invention, the compound of formula (IVa) or (IVb) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.39 eV, the HOMO level of N4,N4,N4',N4'-tetrakis(4-methoxyphenyl)biphenyl-4,4'-diamine is -4.53 eV, and the HOMO level of N4,N4'-bis(9,9-dimethyl-9H-fluoren-2-yl)-N4,N4'-diphenyl-[1,1'-biphenyl]-4,4'-diamine is -4.84 eV, when calculated using the program package ORCA V5.0.3 (Max Planck Institute für Kohlenforschung,

Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set in the gas phase.

According to one embodiment of the invention, the compound of formula (IVa) or (IVb) has a HOMO level smaller than -4.39 eV, preferably smaller than -4.53 eV, even more preferred smaller than -4.84 eV when calculated using the program package ORCA V5.0.3 (Max Planck Institute für Kohlenforschung, Kaiser Wilhelm Platz 1, 45470, Muelheim/-Ruhr, Germany) and WEASEL 1.9.2 (FAccTs GmbH, Rolandstrasse 67, 50677 Köln, Germany) by applying the hybrid functional B3LYP with a Def2-TZVP basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to an embodiment of the electronic device, the molecular mass of the compound of formula (IVa) or (IVb) is selected in the range of ≥ 600 Da and ≤ 900 Da, preferably ≥ 620 Da and ≤ 850 Da. When the molecular mass of compound of formula (IVa) or (IVb) is selected within this range, the compound of formula (IVa) or (IVb) may be particularly suited to vacuum thermal deposition.

According to an embodiment of the present invention, the compounds of formula (IVa) or formula (IVb) are selected from formulae (F1) to (F21):

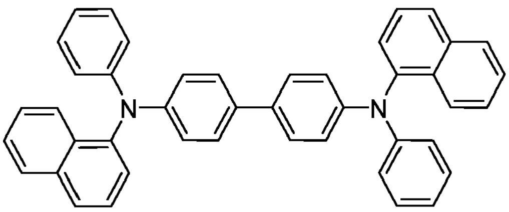
(F1),

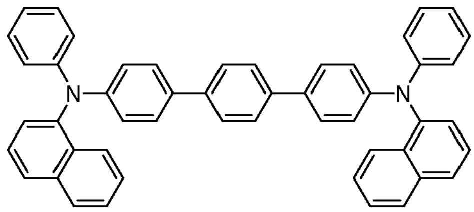
(F2),

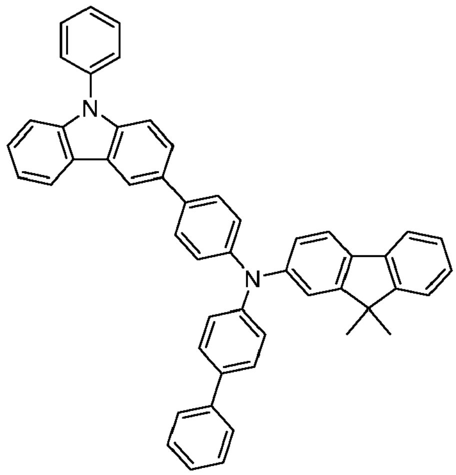
(F3),

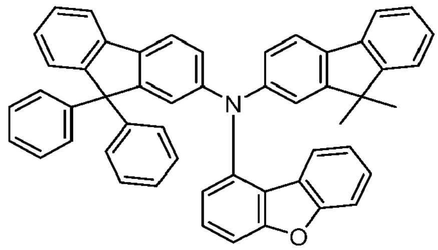
(F4),

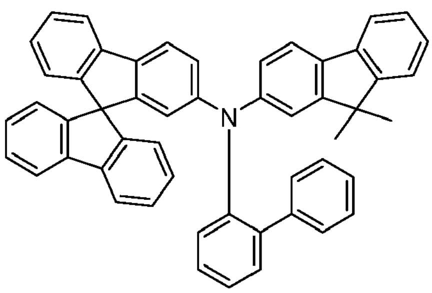
(F5),

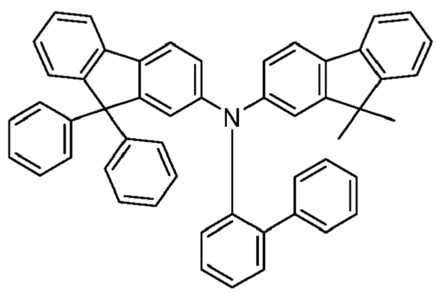
(F6),

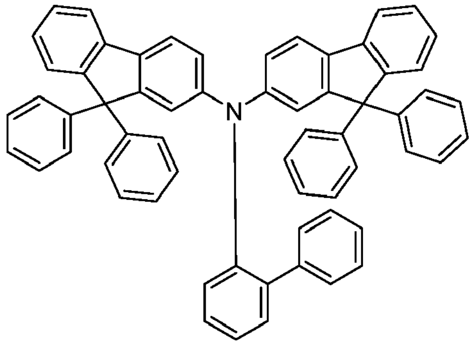
(F7),

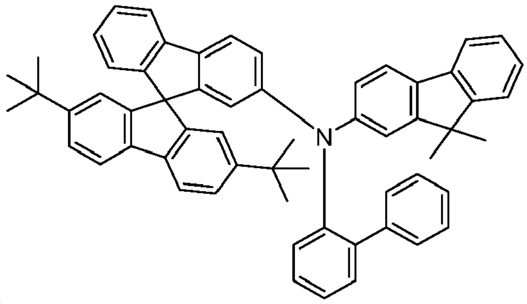
(F8),

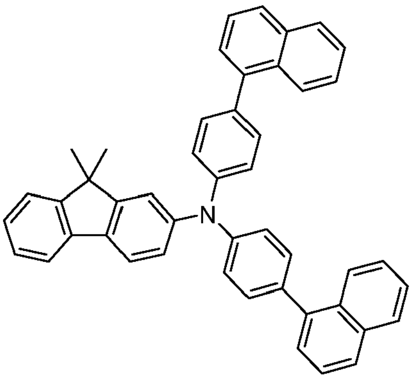
(F9),

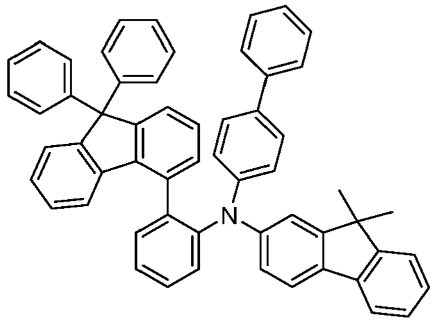
(F10),

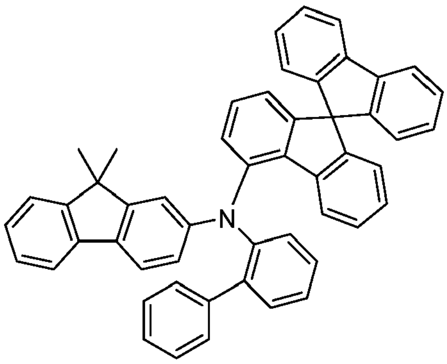
(F11),

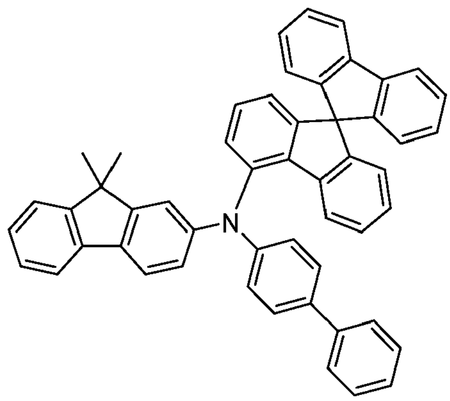
(F12),

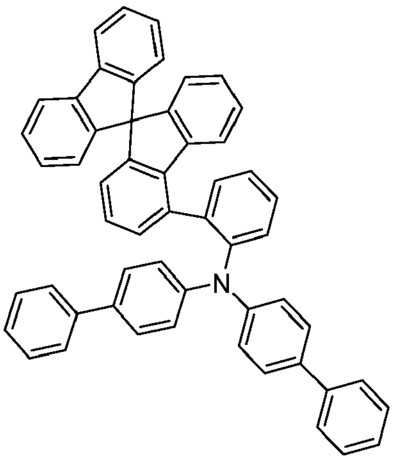
(F13),

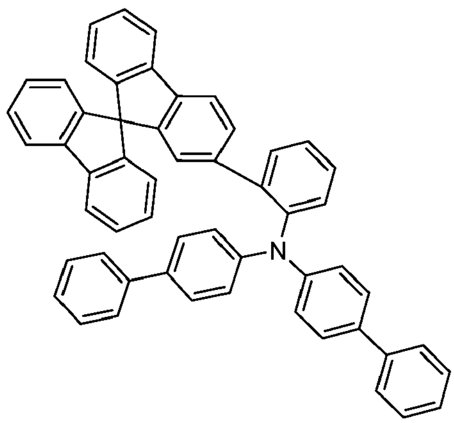
(F14),

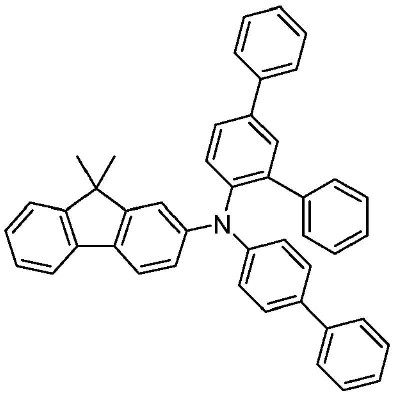
(F15),

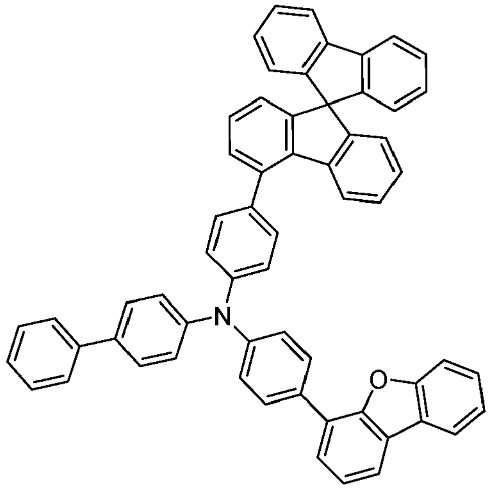
(F16),

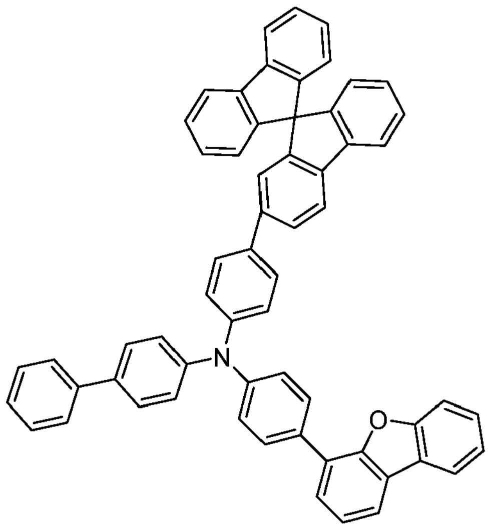
(F17)

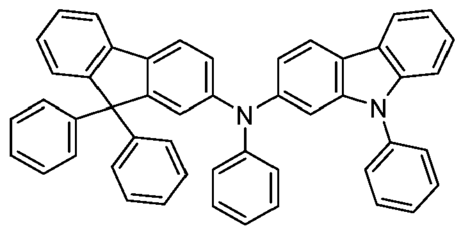
(F18)

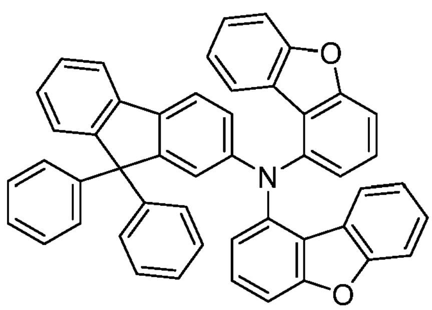
(F19),

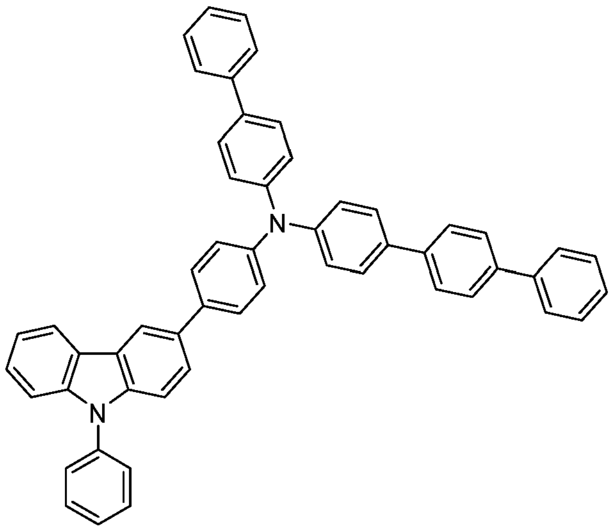
(F20),

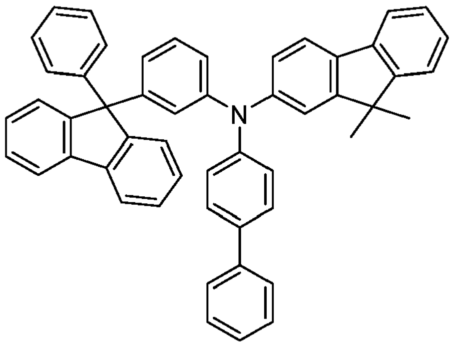

(F21);

preferably the compound of formula (IVa) or formula (IVb) is selected from formulae (F3) to (F21), more preferred from (F4) to (F21).

## n-type charge generation layer

According to an embodiment, the organic electronic device further comprises a layer selected from hole injection layer, hole transport layer, electron blocking layer, a hole blocking layer, an electron transport layer, and an electron injection layer.

According to an embodiment, the organic electronic device further comprises a hole injection layer, a first hole transport layer, a second hole transport layer, first electron blocking layer, second electron blocking layer, optionally a first hole blocking layer, optionally a second hole blocking layer, a first electron transport layer, a second electron transport layer, and an electron injection layer.

According to one embodiment, the first n-type charge generation layer is in direct contact to the first p-type charge generation layer.

According to one embodiment, the second n-type charge generation layer is in direct contact to the second p-type charge generation layer.

According to one embodiment, the third n-type charge generation layer is in direct contact to the third p-type charge generation layer.

According to one embodiment, each of the at least two light-emitting units comprises an electron transport layer.

According to one embodiment, the organic electronic device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer..

According to one embodiment, the organic electronic device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer, and wherein the first n-type charge generation layer is in direct contact to the to the first p-type charge generation layer.

According to one embodiment, the matrix compound of the first n-type charge generation layer is an electron transport material.

According to one embodiment, the matrix compound of the first n-type charge generation layer an organic electron transport material.

According to one embodiment, the matrix compound of the first n-type charge generation layer comprises at least one $C_2$ to $C_{24}$ N-heteroaryl or P=X group, with X being O, P, Se, with P=O especially preferred.

According to an embodiment, the at least one $C_2$ to $C_{24}$ N-heteroaryl may be selected from a compound comprising at least one azine group, preferably at least two azine groups, also preferred three azine groups.

According to an embodiment, the matrix compound of the first n-type charge generation layer comprises at least one group selected from the list consisting of pyridine, pyrimidine, triazine, imidazole, benzimidazole, benzooxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to an embodiment, the matrix compound of the first n-type charge generation layer comprises at least one phenanthroline group, preferably two phenanthroline groups, one or more pyridine groups, one or more pyrimidine groups, one or more triazine groups, one or more imidazo[1,5-*a*]pyridine groups, or one or more phosphine oxide groups.

According to an embodiment, the matrix compound of the first n-type charge generation layer comprises at least one phenanthroline group, preferably two phenanthroline groups, one or more pyridine groups, one or more pyrimidine

groups, or one or more phosphine oxide groups.

According to an embodiment, the matrix compound of the first n-type charge generation layer comprises at least one phenanthroline group, preferably two phenanthroline groups, a pyridine group, a pyrimidine groups, or a phosphine oxide group.

According to an embodiment, the matrix compound of the first n-type charge generation layer comprises at least one phenanthroline group, preferably two phenanthroline groups, one or more pyridine groups, one or more pyrimidine groups, one or more triazine groups.

According to an embodiment, the matrix compound of the first n-type charge generation layer is selected from the group comprising 2,2'-(1,3-Phenylene)bis[9-phenyl-1,10-phenanthroline], (3-(10-(3-(2,6-diphenylpyrimidin-4-yl)phenyl) anthracen-9-yl)phenyl)dimethylphosphine oxide, 3-(3-(9,10-diphenylanthracen-2-yl)phenyl)-1-(pyridin-2-yl)imidazo [1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethylphosphine oxide.

According to an embodiment, the matrix compound of the first n-type charge generation layer comprises at least one phenanthroline group, preferably two phenanthroline groups.

According to one embodiment, the metal dopant is selected from a metal with an electronegativity of ≤ 1.4 eV by Pauling scale or a metal alloy comprising a metal with an electronegativity of ≤ 1.4 eV by Pauling scale.

According to one embodiment, the metal dopant is selected from a metal with an electronegativity of ≤ 1.35 eV by Pauling scale or a metal alloy comprising a metal with an electronegativity of ≤ 1.35 eV by Pauling scale.

According to one embodiment, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment, the metal dopant is a metal selected from the group consisting of Li, Mg and Yb or a metal alloy comprising a metal selected from the group consisting of Li, Mg and Yb.

According to one embodiment, wherein the metal dopant of the first n-type charge generation layer is a metal selected from the group consisting of Li, Mg and Yb or a metal alloy comprising a metal selected from the group consisting of Li, Mg and Yb.

According to one embodiment, the metal dopant is a metal selected from the group consisting of Li and Yb or a metal alloy comprising a metal selected from the group consisting of Li, and Yb.

According to one embodiment, the metal dopant is Yb or a metal alloy comprising a metal selected from the group consisting of Li and Yb.

According to one embodiment, the metal dopant is Yb.

According to one embodiment, the metal dopant is in the oxidations state ±0.

According to one embodiment, the metal dopant is present in the first n-type charge generation layer in an amount of ≤ 99.9 vol% based on the total volume of the layer, preferably ≤ 99 vol%, more preferably ≤ 95 vol%, more preferably ≤ 90 vol%, more preferably ≤80 vol%, more preferably ≤ 70 vol%, more preferably ≤ 60 vol% , more preferably ≤ 50 vol%, more preferably ≤ 40 vol%, more preferably ≤ 30 vol%, more preferably ≤ 20 vol%, more preferably ≤ 10 vol%, more preferably ≤ 5 vol% , more preferably ≤ 3.0 vol%, more preferably ≤ 2 vol%, more preferably ≤ 1.5 vol%, more preferably ≤ 1.25 vol%, and most preferably ≤ 1.0 vol%.

According to one embodiment, the matrix compound is present in the first n-type charge generation layer in an amount of ≥ 0.1 vol% based on the total volume of the layer, preferably ≥ 1 vol%, more preferably ≥ 5 vol%, more preferably ≥ 10 vol%, more preferably ≥ 20 vol%, more preferably ≥3 0 vol%, more preferably ≥ 40 vol%, more preferably ≥ 50 vol%, more preferably ≥ 60 vol%, more preferably ≥ 70 vol%, more preferably ≥ 80 vol%, more preferably ≥ 90 vol%, more preferably ≥ 95 vol%, more preferably ≥ 97.0 vol%, more preferably ≥ 98 vol%, more preferably ≥ 98.25 vol%, more preferably ≥ 98.5 vol%, more preferably ≥ 98.75 vol% and most preferably ≥ 99.0 vol%.

## Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating

conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

According to one embodiment of the present invention, the hole injection layer is adjacent to the anode layer.

According to one embodiment of the present invention, the hole injection layer is in direct contact to the anode layer.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

*Hole transport layer*

The organic electronic device according to the present invention may further comprise at least one hole transport layer (HTL). According to one embodiment of the present invention, the at least one hole transport layer is comprised in one of the at least two light-emitting units, wherein preferably at least one hole transport layer is comprised in each light-emitting unit.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to a preferred embodiment of the present invention, the hole injection layer and the hole transport layer may comprise an identical substantially covalent matrix compound as described above.

According to one embodiment of the present invention, the hole transport layer may comprise a compound of formula (VII) or (VIII) as described above.

According to a preferred embodiment of the present invention, the hole injection layer and the hole transport layer may comprise an identical compound of formula (VII) or (VIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (VII) or (VIII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

According to the invention the organic electronic device comprises at least two photoactive layers.

A photoactive layer in the sense of the present invention especially means a layer that converts an electrical current into photons or photons into an electrical current.

The photoactive layer may be a light-emitting layer or a light-absorbing layer, in particular a light-emitting layer.

According to an embodiment of the present invention, the first photoactive layer is a first light-emitting layer, and the second photoactive layer is a second light-emitting layer.

According to an embodiment of the present invention, the organic electronic device is an organic electroluminescent device and/or an organic light-emitting diode, wherein the first photoactive layer is a first light-emitting layer, and the second photoactive layer is a second light-emitting layer.

According to an embodiment of the present invention, the organic electronic device is an organic electroluminescent device in particular an organic light-emitting diode, wherein the first photoactive layer is a first light-emitting layer, and the second photoactive layer is a second light-emitting layer.

According to an embodiment of the present invention, wherein the organic electronic device is an organic electroluminescent device in particular and organic light-emitting diode comprising a substrate, an anode layer, a cathode layer, a first light-emitting layer, a second light-emitting layer, and a hole injection layer, a charge generation layer,

wherein the charge generation layer comprises a p-type charge generation layer and an n-type charge generation layer,
wherein the hole injection layer, the charge generation layer, the first light-emitting layer, and the second light-emitting layer are arranged between the anode layer and the cathode layer,
wherein the hole injection layer is arranged closer to the anode layer than the p-type charge generation layer,
wherein the p-type charge generation layer is arranged closer to the cathode layer than the n-type charge generation layer, and the n-type charge generation layer is arranged closer to the anode layer than the p-type charge generation layer;
wherein the hole injection layer is in direct contact to anode layer,
wherein the charge generation layer is arranged between the first light-emitting layer and the second light-emitting layer,
wherein the hole injection layer comprises a compound of formula (I):

$$M^{n\oplus}(L^{\ominus})_n\ (AL)_m \quad (I),$$

wherein:

M is a metal ion;
n is the valency of M and selected from 1 to 4;
L is a ligand selected from formula (II)

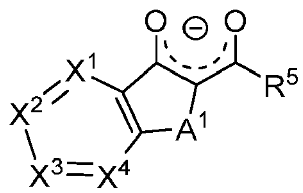

(II),

wherein

$A^1$ is selected from C=O or $SO_2$;
$X^1$ is selected from $CR^1$ or N;
$X^2$ is selected from $CR^2$ or N;
$X^3$ is selected from $CR^3$ or N;
$X^4$ is selected from $CR^4$ or N;

wherein 0, 1 or 2 of the group consisting of $X^1$, $X^2$, $X^3$, $X^4$ are selected from N;
$R^1$ to $R^4$ are independently selected from H, D, substituted or unsubstituted $C_1$ to $C_{12}$ alkyl, partially fluorinated or perfluorinated $C_1$ to $C_{12}$ alkyl, $CF_3$, substituted or unsubstituted $C_1$ to $C_8$ alkoxy, partially fluorinated or perfluorinated $C_1$ to $C_8$ alkoxy, $OCF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_8$ to $C_5$ heteroaryl; substituted or unsubstituted 6-membered $C_4$ to $C_5$ heteroaryl; halogen, F, Cl or CN, and whereby any $R^k$ to $R^{k+1}$ may form a ring, wherein k is an integer selected from 1 to 3;
$R^5$ is selected from substituted or unsubstituted $C_1$ to $C_{12}$ alkyl, partially fluorinated or perfluorinated $C_1$ to $C_{12}$ alkyl, $CF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_3$ to $C_5$ heteroaryl; substituted or unsubstituted 6-membered $C_4$ to $C_5$ heteroaryl;
wherein the one or more substituents of the substituted $C_1$ to $C_{12}$ alkyl, substituted $C_1$ to $C_8$ alkoxy, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl of $R^1$ to $R^5$ are independently selected from D, electron-withdrawing group, halogen, Cl, F, CN, partially fluorinated or perfluorinated $C_1$ to $C_8$ alkyl, partially or perfluorinated $C_1$ to $C_8$ alkoxy;

AL is an ancillary ligand which coordinates to the metal M;
m is an integer selected from 0 to 2;

wherein the p-type charge generation layer comprises an organic compound of formula (III)

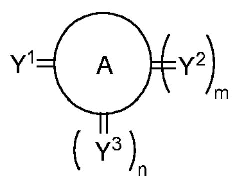

(III),

wherein

n is an integer selected from 0, 1, 2, 3, 4, 5 or 6, preferably 0, 2, or 4;

m is an integer selected from 0 or 1; preferably 1;

$Y^1$, $Y^2$ and $Y^3$ are independently selected from O, S, $CR^{1a}R^{2a}$, $CR^{1b}R^{2b}$, $NR^{3a}$, $NR^{3b}$ or at least one of $Y^1$, $Y^2$, and $Y^3$ form a fused ring with A, wherein each $Y^2$ is selected the same or different, preferably the same, and wherein each $Y^3$ is selected the same or different, preferably the same,

$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{40}$ aryl, substituted or unsubstituted $C_2$ to $C_{40}$ heteroaryl,

wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from substituted or unsubstituted $C_3$ to $C_{40}$ cyclohydrocarbon group, substituted or unsubstituted $C_3$ to $C_{40}$ cycloalkane group, substituted or unsubstituted $C_3$ to $C_{40}$ cycloalkane group containing one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group,
wherein the one or more substituents on A are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, $CF_3$, partially fluorinated $C_1$ to $C_8$ alkoxy, perfluorinated $C_1$ to $C_8$ alkoxy, $OCF_3$.

The photoactive layer may be formed on the HTL by vacuum deposition, spin coating, slot-die coat-ing, printing, casting, LB deposition, or the like. When the photoactive layer is formed using vacuum deposition or spin coating, the conditions for deposition and coating may be similar to those for the formation of the HIL. However, the conditions for deposition and coating may vary, according to the compound that is used to form the photoactive layer.

*Emission layer (EML)*

According to an embodiment of the present invention, the organic electronic device may further comprise an emission layer, wherein the emission layer is arranged between the anode layer and the cathode layer.

The EML may be formed on the HTL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (X):

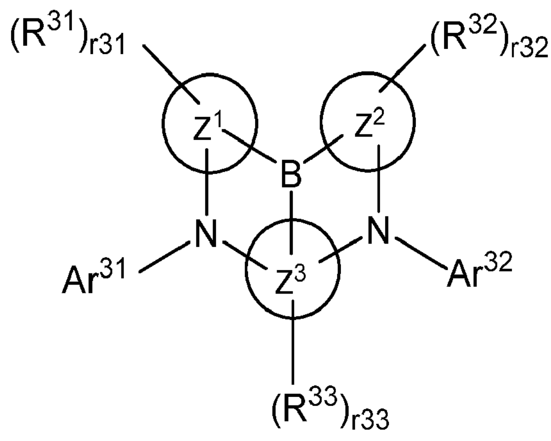

(X),

wherein

$Z^1$, $Z^2$ and $Z^3$ are the same as or different from each other, and are each independently selected from the group comprising a monocyclic to polycyclic aromatic hydrocarbon ring or monocyclic to polycyclic aromatic hetero ring;
$Ar^{31}$ and $Ar^{32}$ are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;

$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,

wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;

$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

According to one embodiment, for formula (III):

$Z^1$, $Z^2$ and $Z^3$ are the same as or selected different from each other, and are each independently selected from the group comprising a monocyclic to bicyclic aromatic hydrocarbon ring, or a monocyclic to bicyclic aromatic hetero ring containing O, N or S;

$Ar^{31}$ and $Ar^{32}$ are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;

$R^{31}$, $R^{32}$ and $R^{33}$ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (III):

$Z^1$, $Z^2$ and $Z^3$ are the same as or selected different from each other, and are each independently selected from the group comprising a benzene ring or a thiophene ring;

$Ar^{31}$ and $Ar^{32}$ are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (X) is selected from formulae (BD1) to (BD9):

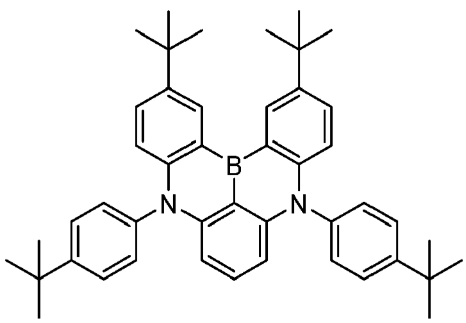
(BD1),
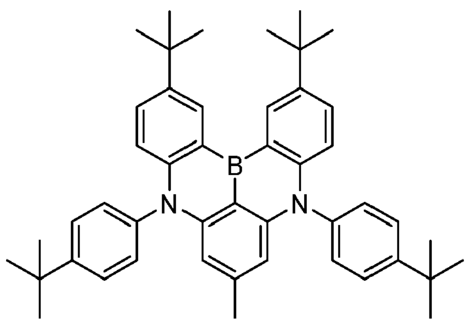
(BD2),

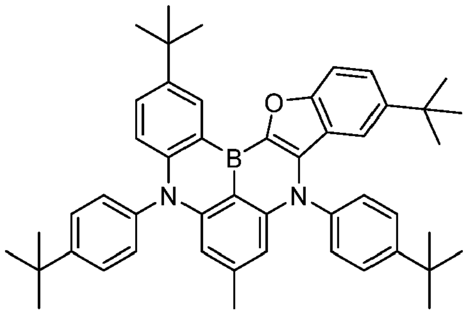 (BD3), 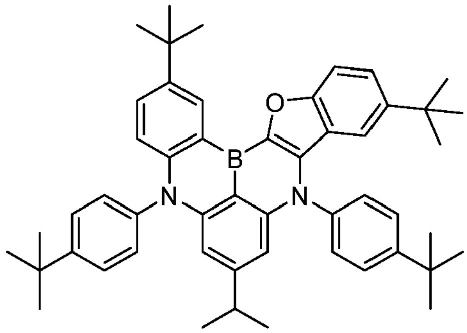 (BD4),

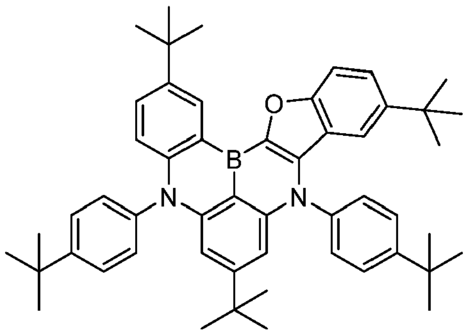 (BD5), 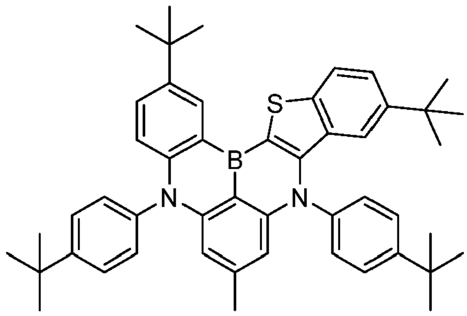 (BD6),

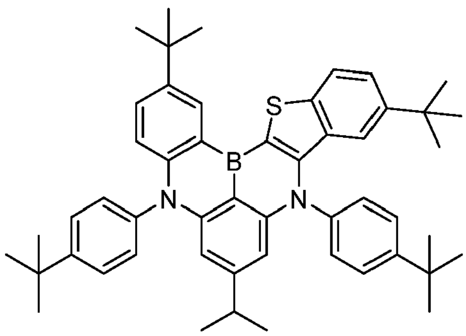 (BD7), 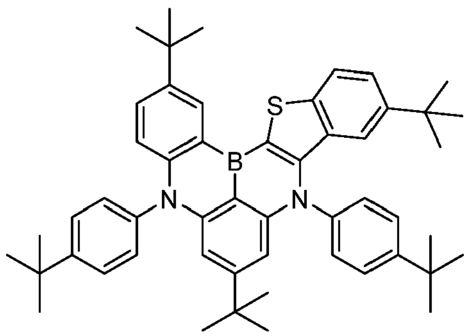 (BD8),

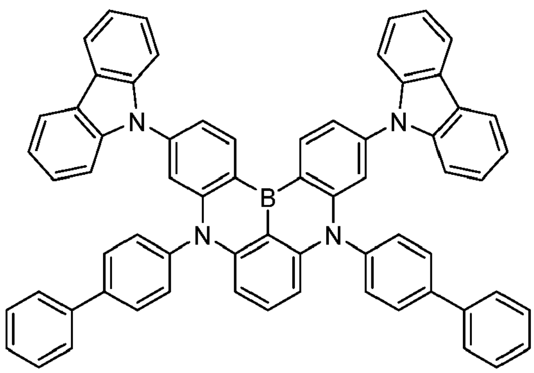 (BD9).

According to a preferred embodiment of the present invention, the emission layer comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;

wherein the molecular weight Mw of the organic emitter host compound is in the range of ≥ 400 and ≤ 2000 g/mol.

According to a preferred embodiment of the present invention, the organic emitter host compound has the formula (XI)

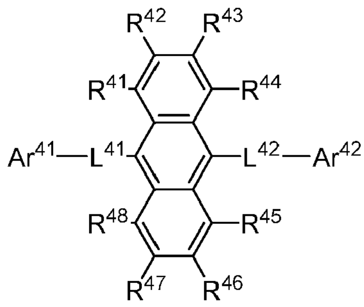

(XI),

wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;
$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;
$R^{41}$ to $R^{41}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;
wherein
the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (XI) is selected from formulae (BH1) to (BH13):

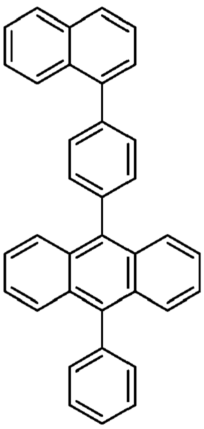

(BH1),

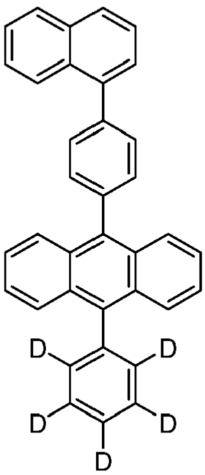

(BH2),

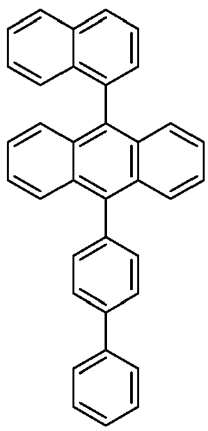

(BH3),

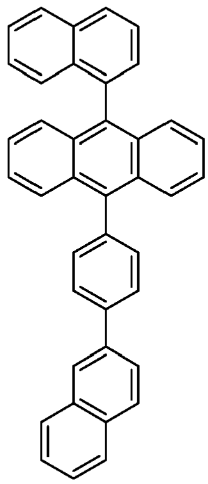

(BH4),

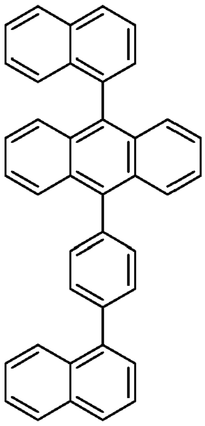 (BH5), 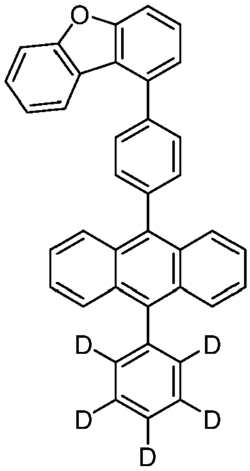 (BH6), 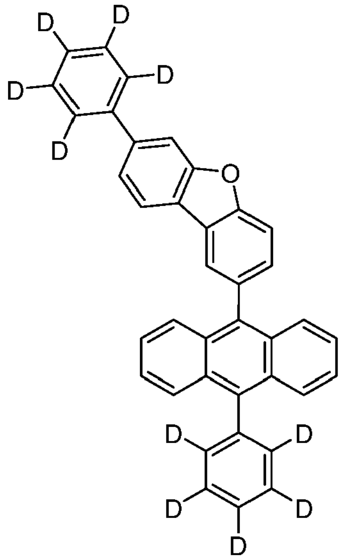 (BH7),

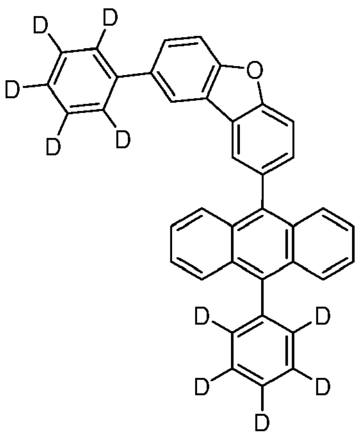 (BH8), 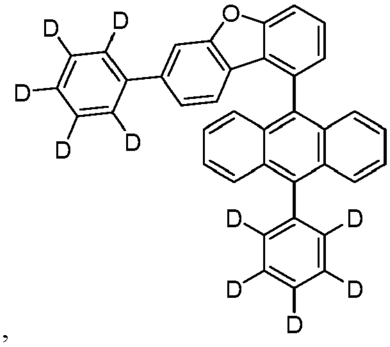 (BH9),

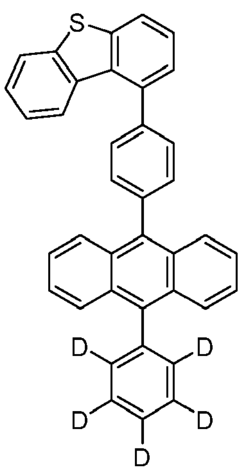 (BH10), 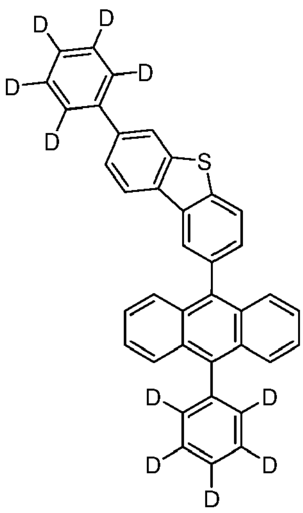 (BH11),

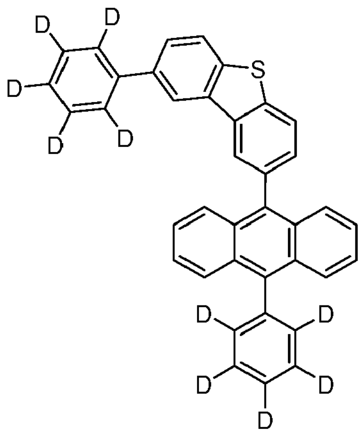 (BH12), 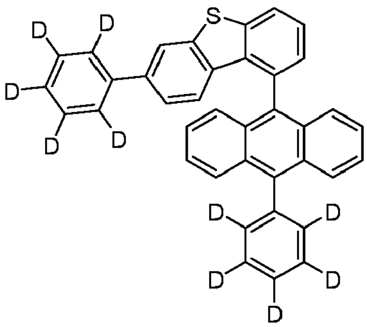 (BH13).

According to a preferred embodiment of the present invention, the emission layer comprises a light-emitting dopant of formula (X) and an organic emitter host of formula (XI).

According to a preferred embodiment of the organic electronic device, the hole injection layer comprises a compound of formula (I) and a compound of formula (III), the hole transport layer comprises a compound of formula (III), preferably the hole injection layer and the hole transport layer comprise the same compound of formula (III) and the emission layer comprises a light-emitting dopant of formula (X) and an organic emitter host of formula (XI);
wherein the hole transport layer is arranged between the hole injection layer and the emission layer, and the emission layer is arranged between the hole transport layer and the cathode layer.

According to a preferred embodiment of the organic electronic device, the hole injection layer comprises a compound of formula (I) and a compound of formula (III), the hole transport layer comprises a compound of formula (III), preferably the hole injection layer and the hole transport layer comprise the same compound of formula (III) and the emission layer comprises a light-emitting dopant of formula (X) and an organic emitter host of formula (XI);

wherein the hole transport layer is arranged between the hole injection layer and the emission layer, and the emission layer is arranged between the hole transport layer and the cathode layer;
wherein the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm, preferably the transparent conductive oxide is selected from ITO or IZO.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise at least one electron transport layer (ETL). According to one embodiment of the present invention, the at least one electron transport layer is comprised in one of the at least two light-emitting units, wherein preferably at least one electron transport layer is comprised in each light-emitting unit.

According to another embodiment of the present invention, the electron transport layer may further comprise an azine compound, preferably a pyridine, pyrimidine or triazine compound, and most preferably a triazine compound or a

pyrimidine compound.

According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

*Electron injection layer (EIL)*

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

In a preferred embodiment, the cathode layer comprises a metal or metal alloy and is transparent.

It is to be understood that the cathode layer is not part of an electron injection layer or the electron transport layer.

*Device*

According to one embodiment of the invention the electronic organic device is an organic electroluminescent device and/or an organic light emitting diode.

According to a preferred embodiment of the invention, the electronic device is an organic light emitting diode, wherein light is emitted through the cathode layer.

The present invention furthermore relates to a display device comprising an organic electronic device according to the present invention.

According to a preferred embodiment of the invention, the display device comprising an organic electronic device according to the present invention, wherein the cathode layer is transparent.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent

claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electronic device according to an exemplary embodiment of the present invention.

FIG. 2 is a schematic sectional view of a stacked organic electronic device according to another exemplary embodiment of the present invention.

FIG. 3 is a schematic sectional view of a stacked organic electronic device according to another exemplary embodiment of the present invention.

FIG. 4 is a schematic sectional view of an anode layer 120 on a substrate 110.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an organic electronic device 100, according to one exemplary embodiment of the present invention.

Referring to Fig. 1 the organic electronic device 100 includes a substrate 110, an anode layer 120, a hole injection layer (HIL) 130 comprising the compound of formula (I) and optionally at least one arylamine compound, diarylamine compound, triarylamine compound, a compound of formula (IVa) or a compound of formula (IVb)), and a first photoactive layer in particular a first light-emitting layer 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electronic device 100 further comprising a first charge generation layer (CGL1) 150 comprising a first n-type charge generation layer (n-CGL1) 151 and a first p-type charge generation layer (p-GCL1) 152, wherein the first p-type charge generation layer (p-CGL1) 152 comprises the organic compound of formula (III) and optionally at least one arylamine compound, diarylamine compound, triarylamine compound, a compound of formula (IVa) or a compound of formula (IVb).

The organic electronic device 100 further comprises, a second photoactive layer in particular a second light-emitting layer 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245. The organic electronic device 100 further comprising and electron injection layer (EIL) 180, a cathode layer (CAT) 190.

Fig. 2 is a schematic sectional view of a stacked organic electronic device 100, according to another exemplary embodiment of the present invention. Fig. 2 differs from Fig. 1 in that the organic electronic device 100 of Fig. 1 further comprises a second charge generation layer (CGL2) 250 disposed on the second photoactive layer in particular on the second light-emitting layer 240, comprising a second n-type charge generation layer (n-CGL2) 251 and a second p-type charge generation layer (p-GCL2) 252, wherein the second p-type charge generation layer (p-CGL2) 252 may optionally also comprise the organic compound of formula (III) and optionally at least one arylamine compound, diarylamine compound, triarylamine compound, a compound of formula (IVa) or a compound of formula (IVb). Wherein the organic electronic device 100 of Fig. 2 further differs from Fig. 1 in that it further comprises a third light-emitting layer 340 disposed on the second charge generation layer (CGL2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

Fig. 3 is a schematic sectional view of a stacked organic electronic device 100, according to another exemplary embodiment of the present invention. Fig. 3 differs from Fig. 2 in that the organic electronic device 100 of Fig. 2 further comprises a third charge generation layer (CGL3) 350 disposed on the third light-emitting layer 340, comprising a third n-type charge generation layer (n-CGL3) 351 and a third p-type charge generation layer (p-GCL3) 352, wherein the third p-type charge generation layer (p-CGL3) 352 may optionally also comprise the organic compound of formula (III) and optionally at least one arylamine compound, diarylamine compound, triarylamine compound, a compound of formula (IVa) or a compound of formula (IVb). Wherein the organic electronic device 100 of Fig. 3 further differs from Fig. 2 in that it further comprises a fourth light-emitting layer 440 disposed on the third charge generation layer (CGL3) 350, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

While not shown in Fig. 1, 2, and 3 a capping and/or a sealing layer may further be formed on the cathode layer 190, in order to seal the organic electronic device 100. In addition, various other modifications may be applied thereto.

FIG. 4 is a schematic sectional view of an anode layer 120 on a substrate 110. The anode layer 120 that comprises a first anode sub-layer 121, a second anode sub-layer 122 and a third anode sub-layer 123.

Hereinafter, one or more exemplary embodiments of the present invention will be described in detail with, reference to the following examples. However, these examples are not intended to limit the purpose and scope of the one or more exemplary embodiments of the present invention.

**Detailed description**

The invention is furthermore illustrated by the following examples which are illustrative only and non-binding.

The protonated form of the ligand of formula (II) L-H may be prepared by methods known in the art, for example as described in J. G. Lombardino, J. Org. Chem. 1968, 33, 10, 3938-3941.

Compounds of formula (I) may be prepared by methods known in the art and as described below.

Compounds of formula (I), wherein M is Cu, Zn, Cd, Pb and n is 2 may be prepared by methods described in Enchev, Venelin et al., J. Mol. Struct., 2001, 595(1-3), 67-76.

Compounds of formula (I), wherein M is Fe and n is 3 may be prepared by methods described in Ahmedova, Anife et al., Inorg. Chim. Acta, 2006, 359(10), 3123-3128.

Compounds of formula (I), wherein M is Fe and n is 2 may be prepared by methods described in Rusanov, Ventzislav et al. Eur. J. Chem., 2014, 5(1), 176-180.

Compounds of formula (I) may be prepared by methods known in the art and as described below.

Synthesis of bis(1-(1,3-dioxo-1,3-dihvdro-2H-inden-2-vlidene)-2,2,2-trifluoroethoxy)copper (MC-1)

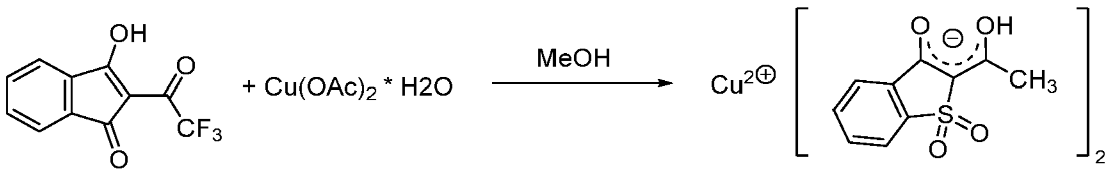


2.42g (10mmol) of 3-hydroxy-2-(2,2,2-trifluoroacetyl)-1H-inden-1-one and 1g (5mmol) of copper acetate monohydrate were added to 50ml methanol and stirred vigorously for 3 days. The suspension was filtered and the solid washed with methanol. After drying in high vacuum at 60°C, 2.39g (95%) product was obtained as a pale green powder, which was further purified by sublimation in vacuo.

Synthesis of tris((2-(3,5-bis(trifluoromethyl)benzoyl)-1,1-dioxidobenzo[b]thiophen-3-yl)oxy)iron (MC-40)

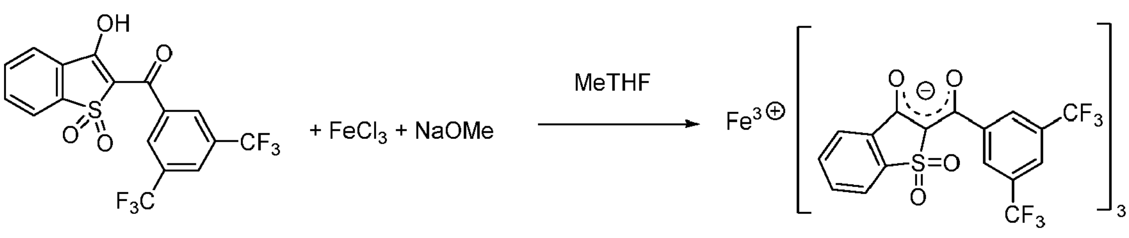


3g (7.1mmol) of (3,5-bis(trifluoromethyl)phenyl)(3-hydroxy-1,1-dioxidobenzo[b]thiophen-2-yl)methanone was dissolved in 30mL 2-methyltetrahydrofurane and 0.38g (7.1mmol) sodium methoxide and 0.41g (2.49mmol) iron trichloride were added. The mixture was stirred at room temperature for 2 hours. The precipitate was filtered off and the solvent was removed under reduced pressure. The residue was dissolved in dichloromethane and the product was precipitated by adding hexane. After filtration the product was dried in high vacuum to obtain 2.82g (90%) dark red solid, which was further purified by sublimation in vacuo.

Synthesis of bis((2-(3,5-bis(trifluoromethyl)benzoyl)-1,1-dioxidobenzo[b]thiophen-3-yl)oxy)manganese (MC-65)

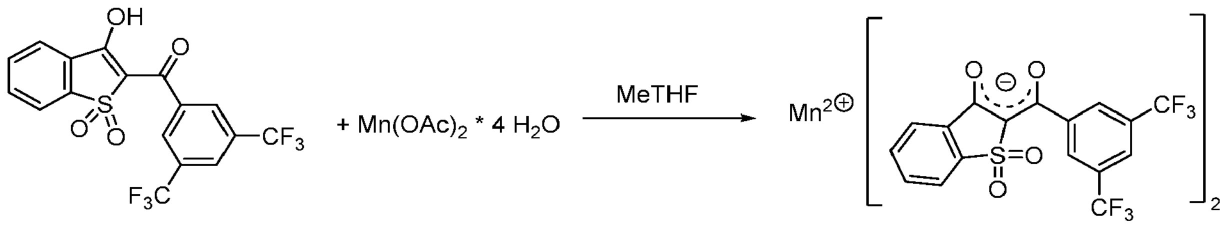


4,0g (9.47mmol) of (3,5-bis(trifluoromethyl)phenyl)(3-hydroxy-1,1-dioxidobenzo[b]thiophen-2-yl)methanone was dissolved in 40mL ethanol and a solution of 1.16g (4,74mmol) of manganese acetate tetrahydrate in 35ml ethanol was added. The mixture was stirred under reflux for 2 hours. After cooling the precipitate was filtered off and washed with ethanol and the solvent was removed under reduced pressure. The residue was dissolved in tetrahydrofurane and precipitated with hexane. The solid was filtered off, washed with hexane and dried in high vacuum to obtain 2,41g (57%) pale orange solid, which was further purified by sublimation in vacuo.

Compounds of formula (III) may be prepared by methods known in the art, for example US2005121667A1, or as described below.

Scheme 1: Method for preparation of compounds of formula (III)

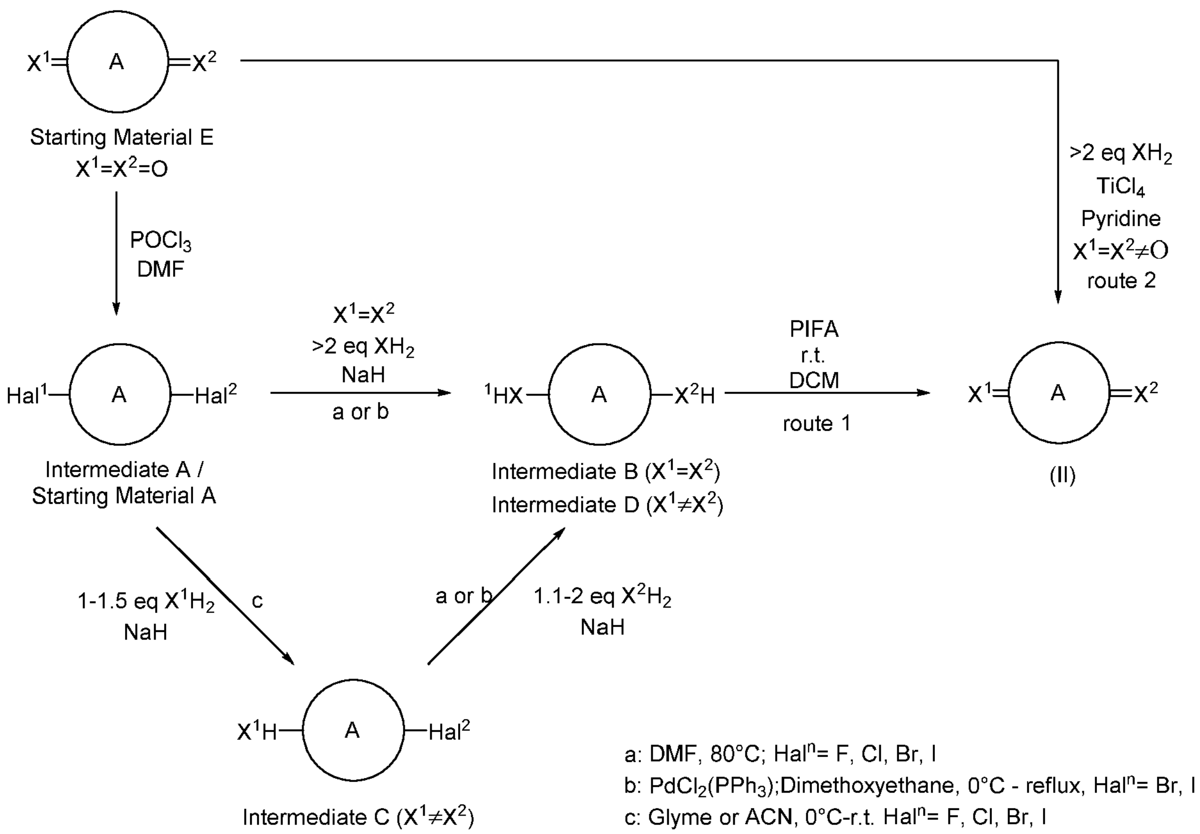


**Conversion** of starting material E into Intermediate A

The conversion from diketones to dihalides was achieved using Bucsis and Friedrichs protocol as published in Chem. Ber. 1976, 109, 2462 - 2468.

**Intermediate B (condition a/b)**

In a 3-neck round-bottle flask equipped with a reflux condenser dropping funnel and a septum, 2.4 equivalents of sodium hydride was suspended in dry DMF and cooled below 10°C using an ice bath under inert gas atmosphere. After dropwise addition of a solution of 2.3 equivalents of $XH_2$ in anhydrous DMF (condition b: anhydrous DME), the mixture was stirred for 15 minutes at 0 to 10°C. Then 1 equivalent Compound A (starting material or intermediate) was added in one portion (condition b: followed by 0.05 equivalents catalyst) and the mixture was stirred for 15 minutes at 0°C, 15 minutes at room temperature and at 80°C (at reflux for condition b) overnight. If the reaction was incomplete on the next morning, the reaction mixture was added dropwise to a suspension of 0.5 to 2 equivalents of additional Compound B deprotonated with a small excess of sodium hydride (0.6 to 2.1 equivalents respectively) and stirred at 80°C for further 24 hours. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in DCM over night at room temperature, filtered and dissolved in a small amount of ethyl acetate again. The concentrated solution was then added dropwise into an 8-fold excess of dichloromethane. The precipitated product was filtered, washed with dichloromethane twice, and dried.

**Intermediate C**

In a 3-neck round-bottle flask equipped with a reflux condenser dropping funnel and a septum, 1.2-1.6 equivalents of sodium hydride was suspended in dry DME and cooled below 10°C using an ice bath under inert gas atmosphere. After dropwise addition of a solution of 1.1-1.5 equivalent of $XH_2$ in dry DME, the mixture was stirred for 15 minutes at 0 to 10°C. Then 1 equivalent Compound A (starting material or intermediate) was added as a solid in one portion and the mixture was stirred for 15 minutes at 0°C and at room temperature overnight. If the reaction was found to be incomplete on the next morning, the reaction mixture was added dropwise to a suspension of 0.5 to 1 equivalents of additional $XH_2$ deprotonated with a small excess of sodium hydride (0.6 to 1.1 equivalents respectively) and stirred for further 24 hours at room temperature. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in toluene over night at room temperature, filtered off, washed with toluene several times and dried.

**Intermediate D**

In a 3-neck round-bottle flask equipped with a reflux condenser dropping funnel and a septum, 1.5 equivalents of sodium hydride was suspended in dry DMF and cooled down below 10°C using an ice bath under inert gas atmosphere. After dropwise addition of a solution of 1.4 equivalents of $XH_2$ in anhydrous DMF, the mixture was stirred for 15 minutes at 0° to 10°C. Then 1 equivalent Intermediate C was added as a solid in one portion and the mixture was stirred for 15 minutes at 0°C, 15 minutes at room temperature and overnight at 80°C. If the reactions was incomplete on the next morning, the reaction mixture was added dropwise to a suspension of 0.5 to 1.5 equivalents of additional Compound $XH_2$ deprotonated with a small excess of sodium hydride (0.6 to 1.6 equivalents respectively) and stirred at 80°C for additional 24 hours. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in DCM over night at room temperature, filtered and dissolved in a small amount of ethyl acetate again. The concentrated solution was then added dropwise into an 8-fold excess of dichloromethane. The precipitated product was filtered, washed with dichloromethane twice, and dried.

**Compound (II) from intermediate B/D**

Prior to oxidation, the Intermediate B / Intermediate D was converted into a potassium salt by suspending in a potassium carbonate solution. The salt was then extracted with ethyl acetate and the solution was concentrated in vacuum. By dropwise addition of the concentrated solution into an excess of n-hexane, the potassium salt was precipitated and filtered off. After drying in vacuum for two hours, the potassium salt was suspended in dry DCM under inert gas atmosphere, 1.1 equivalents of PIFA were added in one portion and the mixture was stirred under exclusion of light over night at room temperature. The product was filtered off, washed with DCM three times and purified by stirring in 50% acetic acid followed by stirring in hot chloroform, filtration from the mother liquor washing with chloroform. The product may be purified further by methods known in the art, for example US2005121667A1.

**Compound (III) from starting material E**

The conversion from diketones to quinodimethanes was achieved by following J. Org. Chem. 1995, 60, 13, 4077-4084 using Lehnerts reagent. The synthesis of N,N-dicyanoquinonediimines was performed using bis(trimethylsily1)carbodiimide following Hünigs and Aumüllers protocol (Liebigs Annalen der Chemie 1986 (1), 142-164).

Calculated HOMO and LUMO of formula (III)

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Calculated LUMP of compounds of formula (I) and comparative compounds

The energy of the lowest unoccupied molecular orbital (LUMO) of compounds of formula (I) and comparative compounds was calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The LUMO energy levels of the molecular structures are determined by applying the hybrid functional B3LYP with a Def2-TZVP basis set and the Stuttgart/Dresden (SDD) effective core potential (ECP) for the metals from the optimized geometries obtained by applying the functional BP86 with a Def2-SVP basis set the Stuttgart/Dresden (SDD) effective core potential (ECP) for the metals. For materials containing a Ce(IV) cation, the LUMO energy levels of the molecular structures are determined by applying the hybrid functional B3LYP with a SARC-ZORA-TZVP basis set for the metals and a ZORA-Def2-TZVP basis set for all other atoms from the optimized geometries obtained by applying the functional BP86 with a SARC-ZORA-TZVP basis set for the metals and a ZORA-Def2-SVP basis set for all other atoms. All the calculations were performed in the gas phase. All relativistic calculations were performed by applying the zero order regular approximation (ZORA). If more than one conformation is viable, the conformation with the lowest total energy is selected. Depending on the metal cation different multiplicities may be applied. For the following metal cations the multiplicity is shown in brackets: $Cu^{2+}$ (doublet), $Cr^{3+}$ (quartet), $Mn^{2+}$ (sextet), $Mn^{3+}$ (quintet), $Fe^{3+}$ (sextet), $Co^{3+}$ (quintet), $Al^{3+}$ (singlet), $In^{3+}$ (singlet), $Ru^{3+}$ (sextet), $Ce^{4+}$ (singlet). The LUMO values in Tables 1 and 2 were calculated by this method unless noted otherwise.

According to an embodiment of compound of formula (I), the LUMO of compound of formula (I) is selected in the range of ≤ -3.4 eV and ≥ -6.5 eV, preferably ≤ -3.45 eV and ≥ -6 eV, more preferred ≤ -3.5 eV and ≥ -5.8 eV; wherein the LUMO is calculated by the method described above.

General procedure for fabrication of OLEDs

For the examples according to the invention and comparative examples in Table 4, a glass substrate with an anode layer comprising a first anode sub-layer of 10 nm ITO, a second anode sub-layer of 120 nm Ag and a third anode sub-layer of 8 nm ITO was cut to a size of 100 mm x 100 mm x 0.7 mm, ultrasonically washed with water for 60 minutes and then with isopropanol for 20 minutes. The liquid film was removed in a nitrogen stream, followed by plasma treatment, see Table 4, to prepare the anode layer. The plasma treatment was performed in an atmosphere comprising 97.6 vol.-% nitrogen and 2.4 vol.-% oxygen.

Then N-([1,1'-biphenyl]-4-yl)-9,9-dimethyl-N-(4-(9-phenyl-9H-carbazol-3-yl)phenyl)-9H-fluoren-2-amine (N-1, cf Table 1) as first hole transport matrix compound was vacuum deposited with 5 wt% of a compound of formula (I) or comparative compound according to Table 2 to form a hole injection layer (pHIL) having a thickness 5 nm.

Then N-([1,1'-biphenyl]-4-yl)-9,9-dimethyl-N-(4-(9-phenyl-9H-carbazol-3-yl)phenyl)-9H-fluoren-2-amine (N-1) was vacuum deposited, to form a first hole transport layer having a thickness of 33 nm

Then N,N-di([1,1'-biphenyl]-4-yl)-3'-(9H-carbazol-9-yl)-[1,1'-biphenyl]-4-amine (N-2, cf Table 1) was vacuum deposited on the HTL, to form an electron blocking layer (EBL) having a thickness of 5 nm.

Then, a first emission layer (EMI,1) having a thickness of 19 nm is formed on the EBL1 by co-depositing 99 vol.-% Dibenzofuran, 7-(phenyl-2 ,3 ,4 ,5 ,6 -d )-1-[10-(phenyl-2 ,3 ,4 ,5 ,6 - d )-9-anthracenyl] [2457172-82-4]as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis [4-(1,1-dimethylethyl)phenyl] [2482607-57-6] as blue dopant.

Then, the first electron transporting layer (ETL1) having a thickness of 15 nm is formed on first emission layer by depositing (3-(10-(3-(2,6-diphenylpyrimidin-4-yl)phenyl)anthracen-9-yl)phenyl)dimethylphosphine oxide (N-3, cf. Table 1).

Then a first n-type charge generation layer (n-CGL1) having a thickness of 7.5 nm is formed on the first electron

transport layer (ETL1) by co-depositing 98 vol% of 2,2'-(1,3-Phenylene)bis[9-phenyl-1,10-phenanthroline (N-4, cf Table 1) and 2 vol% Yb.

Then a first p-type charge generation layer (p-CGL) having a thickness of 10 nm is formed on the first n-type CGL by co-depositing 91.09 wt% of N-(9,9-diphenyl-9H-fluoren-2-yl)-N,9-diphenyl-9H-carbazol-2-amine (N-5, Cf. Table 1) with 12 wt% of a compound of formula (III) or comparative according to Table 3 as a dopant.

Then a second hole transport layer having a thickness of 43 nm is formed on the first p-type CGL by depositing N-(9,9-diphenyl-9H-fluoren-2-yl)-N,9-diphenyl-9H-carbazol-2-amine (N-5, cf. Table 1).

Then a second electron blocking layer having a thickness of 5 nm is formed on the second hole transport layer by depositing N,N-di([1,1'-biphenyl]-4-yl)-3'-(9H-carbazol-9-yl)-[1,1'-biphenyl]-4-amine (N-2)..

Then, a second emission layer (EML2) having a thickness of 19 nm is formed on the EBL1 by co-depositing 99 vol.-% Dibenzofuran, 7-(phenyl-2 ,3 ,4 ,5 ,6 -d )-1-[10-(phenyl-2 ,3 ,4 ,5 ,6 -d )-9-anthracenyl] [2457172-82-4]as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis[4-(1,1-dimethylethyl)phenyl] [2482607-57-6] as blue dopant.

Then, a first hole blocking layer (HBL1) having a thickness of 5 nm is formed on the EMI,2 by depositing compound 4-([1,1'-biphenyl]-4-yl)-6-(3'-(9,9-dimethyl-9H-fluoren-4-yl)-[1,1'-biphenyl]-4-yl)-2-phenylpyrimidine (N-6).

Then, a second electron transport layer (ETL2) having a thickness of 31 nm is formed on the HBL1 by co-depositing compound 6,6'-(naphthalene-1,2-diylbis(4,1-phenylene))bis(2,4-diphenyl-1,3,5-triazine) (N-7, cf. Table 1) and LiQ (N-8) in a ratio of 50:50 wt.-%.

Then Yb was evaporated at a rate of 0.01 to 1 Å/s at $10^{-7}$ mbar to form an electron injection layer (EIL) with a thickness of 1.3 nm on the electron transporting layer.

Ag/Mg (10vol% Mg) is evaporated at a rate of 0.01 to 1 Å/s at $10^{-7}$ mbar to form a cathode with a thickness of 13 nm.

Then, N-(f[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/$m^2$ using an Instrument Systems CAS-140CT array spectrometer (calibrated by Deutsche Akkreditierungsstelle (DAkkS)) for each of the voltage values. The cd/A efficiency at 15 mA/$cm^2$ is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/$cm^2$.

In top emission devices, the emission is forward directed, non-Lambertian and also highly dependent on the micro-cavity. Therefore, the efficiency EQE will be higher compared to bottom emission devices. To determine the efficiency EQE in % the light output of the device is measured using a calibrated photodiode at 15 mA/$cm^2$.

Lifetime LT of the device is measured at ambient conditions (20°C) and 10 mA/$cm^2$ or 30 mA/$cm^2$, using a Keithley 2400 source meter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U(100\ h)-U(1h)].$$

The smaller the value of ΔU the better is the operating voltage stability.

**Table 1:Compounds used**

| | | |
|---|---|---|
| N-1 | N-([1,1'-biphenyl]-4-yl)-9,9-dimethyl-N-(4-(9-phenyl-9H-carbazol-3 -yl)phenyl)-9H-fluoren-2-amine | 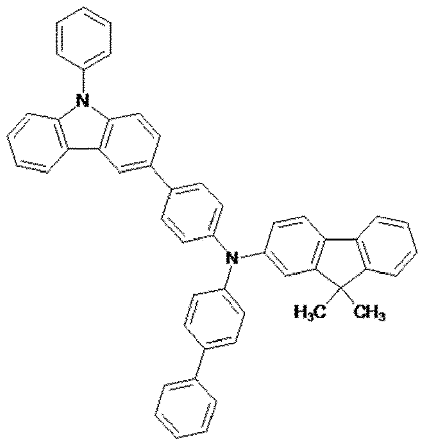 |
| N-2 | N,N-di([1,1'-biphenyl]-4-yl)-3'-(9H-carbazol-9-yl)-[1,1'-biphenyl]-4-amine | 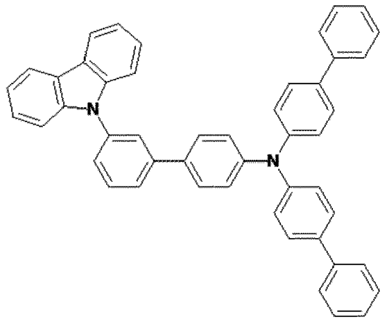 |
| N-3 | (3-(10-(3-(2,6-diphenylpyrimidin-4-yl)phenyl)anthracen-9-yl) phenyl)dimethylphosphine oxide | 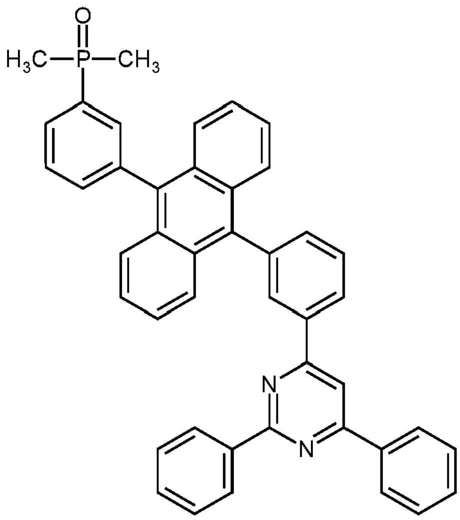 |
| N-4 | 2,2'-(1,3-Phenylene)bis[9-phenyl-1,10-phenanthroline | 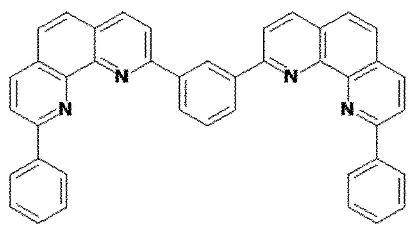 |

(continued)

| | | |
|---|---|---|
| N-5 | N-(9,9-diphenyl-9H-fluoren-2-yl)-N,9-diphenyl-9H-carbazol-2-amine | 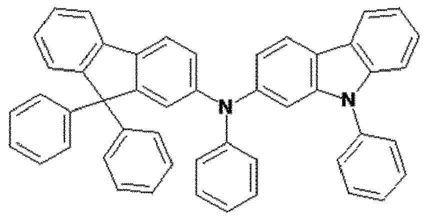 |
| N-6 | 4-([1,1'-biphenyl]-4-yl)-6-(3'-(9,9-dimethyl-9H-fluoren-4-yl)-[1,1'-biphenyl]-4-yl)-2-phenylpyrimidine | 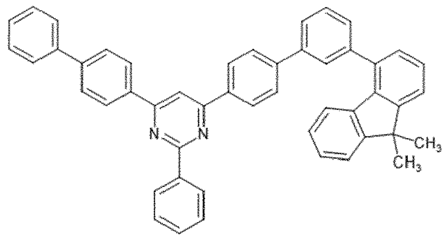 |
| N-7 | 6,6'-(naphthalene-1,2-diylbis(4,1-phenylene))bis(2,4-diphenyl-1,3,5-triazine) | 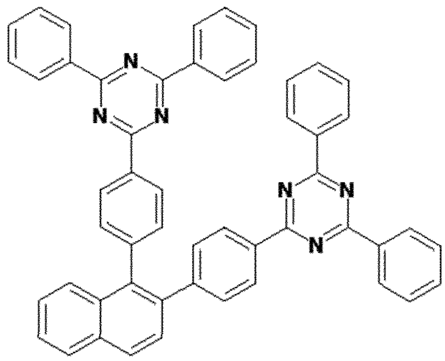 |
| N-8 | LiQ (8-Hydroxyquinolinolato-lithium) | 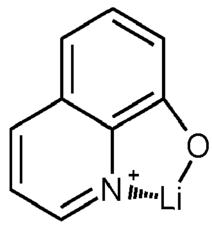 |

**Table 2: Metal compounds for comparative device and according to formula (I)**

| | Structure | LUMO [eV] |
|---|---|---|
| MC-1 | | -3.98 |
| A127 | | -4.77 |
| A1 | | -4.40 |
| A52 | | -4.62 |
| A91 | | -4.80 |
| A116 | | -3.56 |

**Table 3: Organic compound in the comparative device and organic compound according to formula (III)**

| | Structure | LUMO [eV] |
|---|---|---|
| G1 | 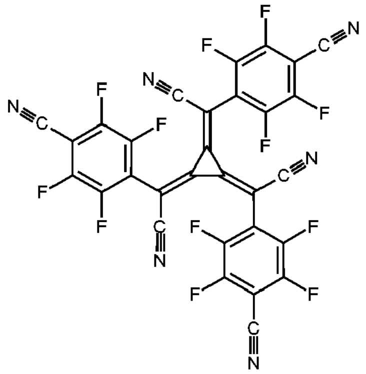 | -5.19 |
| G11 | 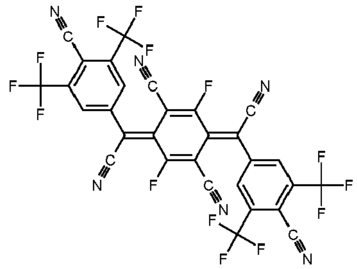 | -5.25 |
| G2 | 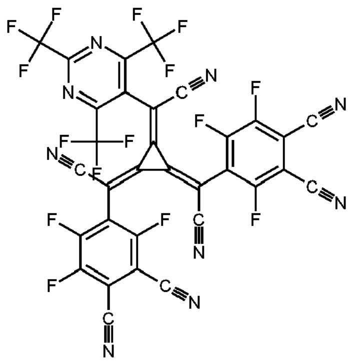 | -5.44 |
| G25 | 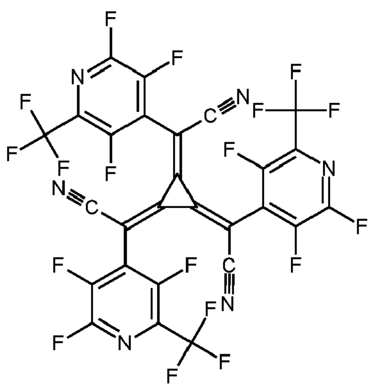 | -5.29 |

(continued)

| | Structure | LUMO [eV] |
|---|---|---|
| G26 | 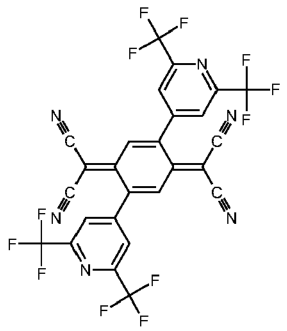 | -5.29 |
| G5 | 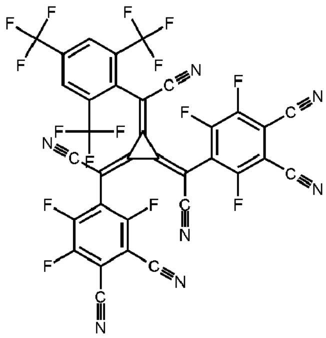 | -5.22 |
| G6 | 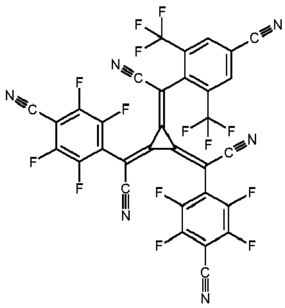 | -5.07 |
| G8 | 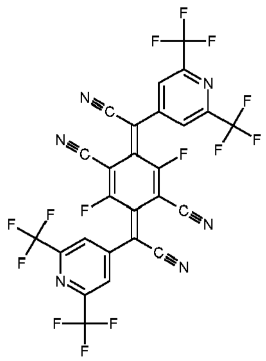 | -5.31 |

(continued)

| | Structure | LUMO [eV] |
|---|---|---|
| OC-1 | 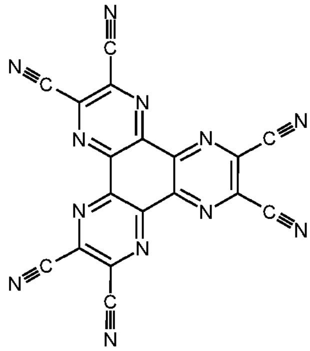 | -4.61 |

Table 4 shows the setup and performance of several comparative and inventive examples.

**Table 4: Setup and performance of several comparative and inventive examples**

| | Dopant in HIL | Dopant in p-CGL | Voltage at 15mA/cm2 [V] | Ceff at 15mA/cm2 [cd/A] | EQE at 15mA/cm2 [%] | LT97 at 30mA/cm2 [h] | ΔU (1-100h) at 30mA/cm2 [V] |
|---|---|---|---|---|---|---|---|
| Comp. Ex. 1 | MC-1 | MC-1 | *>>10* | - | - | - | - |
| Comp. Ex. 2 | MC-1 | OC-1 | *>>10* | - | - | --- | - |
| Comp. Ex. 3 | A127 | OC-1 | *>>10* | - | - | - | - |
| Comp. Ex. 4 | A5 | OC-1 | *>>10* | - | - | --- | - |
| Comp. Ex. 5 | A127 | MC-1 | *>>10* | - | - | - | - |
| Comp. Ex. 6 | MC-1 | B1 | 6.99 | 16.2 | 29.6 | 122 | 0.69 |
| Comp. Ex. 7 | MC-1 | C1 | 6.84 | 16.7 | 30.8 | 131 | 0.54 |
| Inv. Ex. 1 | A127 | G8 | 6.69 | 17.3 | 31.7 | 112 | 0.11 |
| Inv. Ex. 3 | A127 | G5 | 6.47 | 17.3 | 31.9 | 113 | 0.12 |
| Inv. Ex. 4 | A1 | G1 | 6.52 | 17.2 | 31.0 | 147 | 0.52 |
| Inv. Ex. 5 | A52 | G11 | 6.67 | 17.3 | 31.7 | 53 | 0.25 |
| Inv. Ex. 6 | A91 | G8 | 6.72 | 17.3 | 32.0 | 126 | 0.13 |
| Inv. Ex. 7 | A91 | G6 | 6.66 | 17.3 | 32.0 | 112 | 0.12 |
| Inv. Ex. 8 | A116 | G2 | 6.53 | 17.3 | 31.9 | 125 | 0.12 |
| Inv. Ex. 9 | A52 | G25 | 6.56 | 17.3 | 31.7 | 145 | 0.30 |

The comparative device Comp. Ex. 1 contains a metal compound MC-1 as p-dopant in the hole injection layer (HIL) and a metal compound MC-1 as p-dopant in the p-type charge generation (p-CGL). MC-1 is not a metal compound according to formula (I).

The comparative device Comp. Ex. 2 contains the same metal compound MC-1 as p-dopant in the HIL as in Comp. Ex. 1 but in the p-CGL it contains an organic compound OC-1 as p-dopant in the p-CGL. OC-1 is not an organic compound according to formula (III).

The comparative device Comp. Ex. 3 contains a metal compound A1 according to formula (I) as p-dopant in the HIL and the same organic compound OC-1 as p-dopant in the p-CGL as in Comp. Ex. 2.

The comparative device Comp. Ex. 4 contains a metal compound A5 according to the formula (I) as p-dopant and the same organic compound OC-1 as p-dopant in the p-CGL as in comp. ex. 2 and Comp. Ex. 3.

The comparative device Comp. Ex. 4 contains the same metal compound MC-1 as p-dopant as in Comp. Ex. 1 and Comp. Ex. 2 and an organic compound B1 as p-dopant according to formula (III) in the p-CGL.

The comparative device Comp. Ex. 5 contains a metal compound A1 according to formula (I) as p-dopant in the HIL and a metal compound MC-1 as p-dopant in the p-CGL.

The comparative device Comp. Ex. 6 contains the metal compound MC-1 as p-dopant in the HIL and an organic compound as p-dopant according to formula (III) in the p-CGL.

The comparative device Comp. Ex. 7 contains a metal compound MC-1 as p-dopant in the HIL and an organic compound C1 as p-dopant in the p-CGL.

The inventive example Inv. Ex. 1 contains a metal compound A1 of formula (I) as p-dopant in the HIL and an organic compound B1 of formula (III) as p-dopant in the p-CGL.

The inventive example Inv. Ex. 2 contains a metal compound A2 of formula (I) as p-dopant in the HIL and an organic compound B2 of formula (III) as p-dopant in the p-CGL.

The inventive example Inv. Ex. 3 contains a metal compound A1 of formula (I) as p-dopant in the HIL and an organic compound C2 of formula (III) as p-dopant in the p-CGL.

The inventive example Inv. Ex. 4 contains a metal compound A3 of formula (I) as p-dopant in the HIL and an organic compound C3 of formula (III) as p-dopant in the p-CGL.

The inventive example Inv. Ex. 5 contains a metal compound A4 of formula (I) as p-dopant in the HIL and an organic compound B3 of formula (III) as p-dopant in the p-CGL.

The inventive example Inv. Ex. 6 contains a metal compound A5 of formula (I) as p-dopant in the HIL and an organic compound B1 of formula (III) as p-dopant in the p-CGL.

The inventive example Inv. Ex. 7 contains a metal compound A5 of formula (I) as p-dopant in the HIL and an organic compound C1 of formula (III) as p-dopant in the p-CGL.

The inventive example Inv. Ex. 8 contains a metal compound A6 of formula (I) as p-dopant in the HIL and an organic compound C4 of formula (III) as p-dopant in the p-CGL.

The inventive example Inv. Ex. 9 contains a metal compound A4 of formula (I) as p-dopant in the HIL and an organic compound C5 of formula (III) as p-dopant in the p-CGL.

In general, when comparing

a combination of HIL and p-CGL each containing two metal compound which are not a compounds in HIL and p-CGL as defined in the present invention (Comp. Ex. 1);
or a combination of HIL and p-CGL wherein the HIL contains a metal compound which is not a compound as in the present invention and wherein the p-CGL contains an organic compound which is not a compound as in the present invention (Comp. Ex. 2);
or a combination of HIL and p-CGL wherein the HIL contains a metal compound as in the present invention and wherein the p-CGL does not contain an organic compound as in the present invention (Comp. Ex. 3 and 4);
or a combination of HIL and p-CGL wherein the HIL contains a metal compound as in the present invention and wherein the p-CGL contains a metal compound as in the present invention (Comp. Ex. 5);
or a combination of HIL and p-CGL wherein the HIL contains a metal compound which is not a metal compound as in the present and wherein the p-CGL contains an organic compound as in the present invention (Comp. Ex. 6 and 7);
with the inventive devices Inv. Ex. 1 to Inv. Ex. 9 it can be seen that inventive devices all exhibit a lower operational voltage (Vop), a higher external quantum efficiency (EQE), a higher current efficiency (Ceff) and a lower increase of operational voltage over time.

The use of a metal compound MC-1 which is not a metal compound as in the present invention in both HIL and p-CGL (Comp. Ex. 1) results in a device which exhibits an operational voltage (Vop) of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound MC-1 which is not a metal compound as in the present invention in the HIL and an organic compounds OC-1 which is not an organic compound as in the present invention (Comp. Ex. 2) results in a device which exhibits an operational voltage of higher than 10V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound A1 which is a metal compound as in the present invention in HIL and an organic compounds OC-1 which is not an organic compound as in the present invention (Comp. Ex. 3) results in a device which

exhibits an operational voltage of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound A5 which is a metal compound as in the present invention in HIL and an organic compounds OC-1 which is not an organic compound as in the present invention (Comp. Ex. 4) results in a device which exhibits an operational voltage of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound A1 which is a metal compound as in the present invention in HIL and a metal compound MC-1 which is not a metal compound as in the present invention (Comp. Ex. 5) results in a device which exhibits an operational voltage of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound MC-1 which is not a metal compound as in the present invention in HIL and an organic compound B1 which is an organic compound as in the present invention (Comp. Ex. 6) results in a device which exhibits an operational voltage of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The use of a metal compound MC-1 which is not a metal compound as in the present invention in HIL and an organic compound C1 which is an organic compound as in the present invention (Comp. Ex. 7) results in a device which exhibits an operational voltage of higher than 10 V.

In contrast to thereto, using a compound of formula (I) in HIL and an organic compound of formula (III) in p-CGL as in the inventive devices (Inv. Ex..1 to Inv. Ex. 9) exhibit a remarkably low operational voltage between 6.47 V to 6.99 V, a remarkably high external quantum efficiency (EQE) between 31.0% to 32.0%, a remarkably high current efficiency (Ceff) between 17.3 cd/A to 17.5 cd/A, and a remarkably low increase of the operational voltage over time (ΔU) between 0.11 V to 0.52 V.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

**1.** An organic electronic device comprising a substrate, an anode layer, a cathode layer, a first photoactive layer, a second photoactive layer, and a hole injection layer, a charge generation layer,

wherein the charge generation layer comprises a p-type charge generation layer and an n-type charge generation layer,

wherein the hole injection layer, the charge generation layer, the first photoactive layer, and the second

photoactive layer are arranged between the anode layer and the cathode layer,
wherein the hole injection layer is arranged closer to the anode layer than the p-type charge generation layer,
wherein the p-type charge generation layer is arranged closer to the cathode layer than the n-type charge generation layer, and the n-type charge generation layer is arranged closer to the anode layer than the p-type charge generation layer;
wherein the hole injection layer is in direct contact to anode layer,
wherein the charge generation layer is arranged between the first photoactive layer and the second photoactive layer,
wherein the hole injection layer comprises a compound of formula (I):

$$M^{n\oplus}(L^{\ominus})_n(AL)_m \qquad (I),$$

wherein:

M is a metal ion;
n is the valency of M and selected from 1 to 4;
L is a ligand independently selected from formula (II)

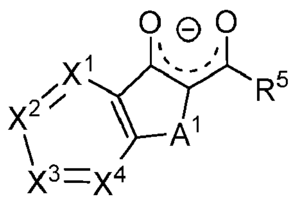

(II),

wherein

$A^1$ is selected from C=O or $SO_2$;
$X^1$ is selected from $CR^1$ or N;
$X^2$ is selected from $CR^2$ or N;
$X^3$ is selected from $CR^3$ or N;
$X^4$ is selected from $CR^4$ or N;
wherein 0, 1 or 2 of the group consisting of $X^1$, $X^2$, $X^3$, $X^4$ are selected from N;
$R^1$ to $R^4$ are independently selected from H, D, substituted or unsubstituted $C_1$ to $C_{12}$ alkyl, partially fluorinated or perfluorinated $C_1$ to $C_{12}$ alkyl, $CF_3$, substituted or unsubstituted $C_1$ to $C_8$ alkoxy, partially fluorinated or perfluorinated $C_1$ to $C_8$ alkoxy, $OCF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_3$ to $C_5$ heteroaryl; substituted or unsubstituted 6-membered $C_4$ to $C_5$ heteroaryl; halogen, F, Cl or CN, and whereby any $R^k$ to $R^{k+1}$ may form a ring, wherein k is an integer selected from 1 to 3;
$R^5$ is selected from substituted or unsubstituted $C_1$ to $C_{12}$ alkyl, partially fluorinated or perfluorinated $C_1$ to $C_{12}$ alkyl, $CF_3$, substituted or unsubstituted $C_6$ to $C_{19}$ aryl, substituted or unsubstituted $C_2$ to $C_{20}$ heteroaryl, substituted or unsubstituted 6-membered heteroaryl, substituted or unsubstituted 6-membered $C_3$ to $C_5$ heteroaryl; substituted or unsubstituted 6-membered $C_4$ to $C_5$ heteroaryl;
wherein the one or more substituents of the substituted $C_1$ to $C_{12}$ alkyl, substituted $C_1$ to $C_8$ alkoxy, substituted $C_6$ to $C_{19}$ aryl, substituted $C_2$ to $C_{20}$ heteroaryl, substituted 6-membered heteroaryl, substituted 6-membered $C_3$ to $C_5$ heteroaryl; substituted 6-membered $C_4$ to $C_5$ heteroaryl of $R^1$ to $R^5$ are independently selected from D, electron-withdrawing group, halogen, Cl, F, CN, partially fluorinated or perfluorinated $C_1$ to $C_8$ alkyl, partially or perfluorinated $C_1$ to $C_8$ alkoxy;

AL is an ancillary ligand which coordinates to the metal M;
m is an integer selected from 0 to 2;

wherein the p-type charge generation layer comprises an organic compound of formula (III)

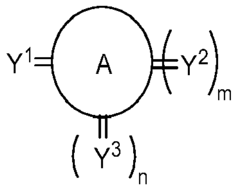

(III),

wherein

n is an integer selected from 0, 1, 2, 3, 4, 5 or 6, preferably 0, 2, or 4;
m is an integer selected from 0 or 1; preferably 1;
$Y^1$, $Y^2$ and $Y^3$ are independently selected from O, S, $CR^{1a}R^{2a}$, $CR^{1b}R^{2b}$, $NR^{3a}$, $NR^{3b}$ or at least one of $Y^1$, $Y^2$, and $Y^3$ form a fused ring with A, wherein each $Y^2$ is selected the same or different, preferably the same, and wherein each $Y^3$ is selected the same or different, preferably the same,
$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{40}$ aryl, substituted or unsubstituted $C_2$ to $C_{40}$ heteroaryl, wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from substituted or unsubstituted $C_3$ to $C_{40}$ cyclohydrocarbon group, substituted or unsubstituted $C_3$ to $C_{40}$ cycloalkane group, substituted or unsubstituted $C_3$ to $C_{40}$ cycloalkane group containing one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group,
wherein the one or more substituents on A are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are

independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, $CF_3$, partially fluorinated $C_1$ to $C_8$ alkoxy, perfluorinated $C_1$ to $C_8$ alkoxy, $OCF_3$.

**2.** The organic electronic device according to claim 1, whereby the atomic mass of M of the metal compound of formula (I) is selected in the range of ≥ 20 Da and ≤ 200 Da.

**3.** The organic electronic device according to claim 1 or 2, wherein in formula (I) the molecular mass of L is selected in the range of ≤ 600 Da and ≥ 240 Da

**4.** The organic electronic device according to any one of claims 1 to 3, formula (II) comprises at least one fluorine atom, preferably at least two fluorine atoms, and more preferably at least three fluorine atoms.

**5.** The organic electronic device according to any of the claims 1 to 4, whereby M in the formula (I) is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III), Ce(IV).

**6.** The organic electronic device according to any of the claims 1 to 5, whereby M in the formula (I) is selected from is selected from Li(I), Na(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III).

**7.** The organic electronic device according to any of the claims 1 to 6, whereby L is selected from C1 to C141:

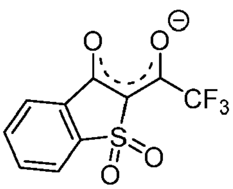 (C1), 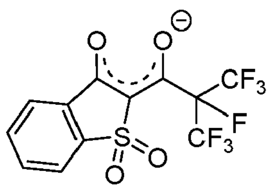 (C2), 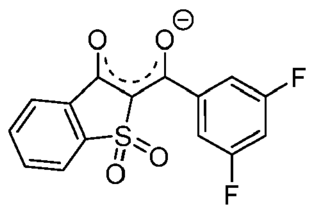 (C3),

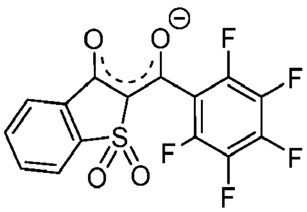 (C4), 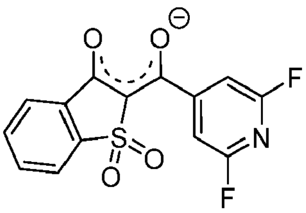 (C5), 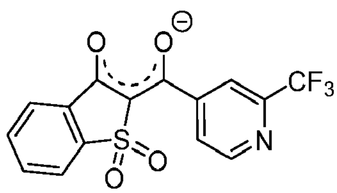 (C6),

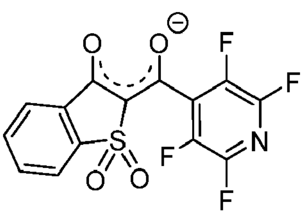 (C7), 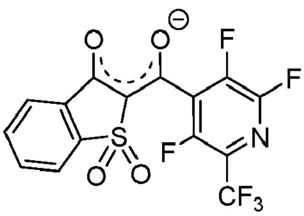 (C8), 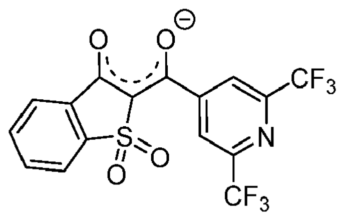 (C9),

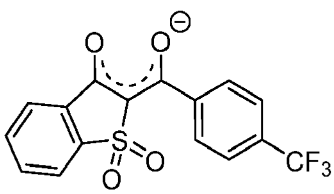 (C10), 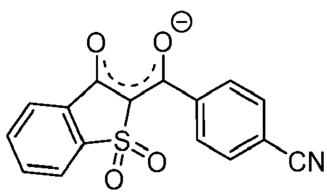 (C11), 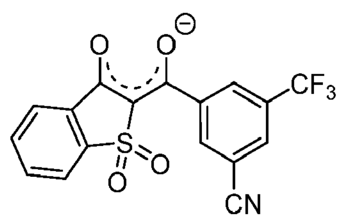

(C12), 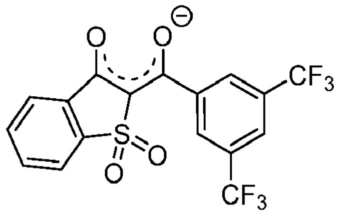 (C13), 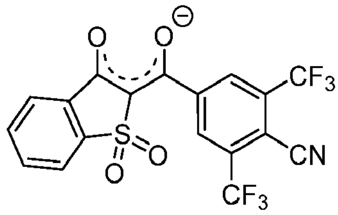 (C14),

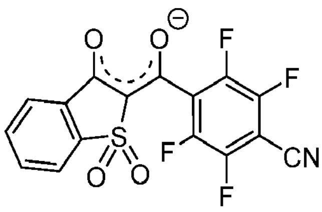 (C15), 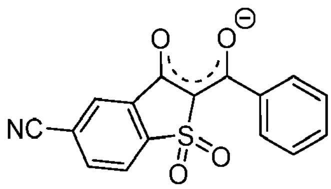 (C16), 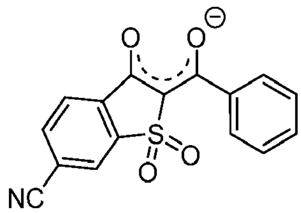 (C17),

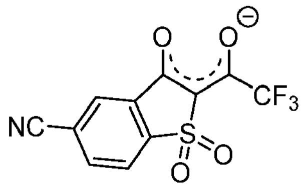 (C18), 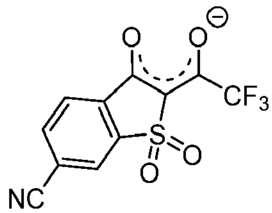 (C19), 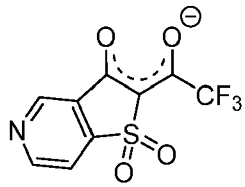 (C20),

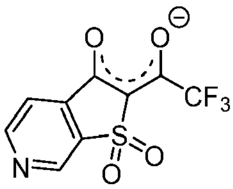 (C21), 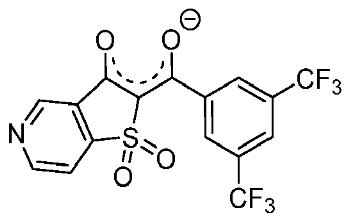 (C23), 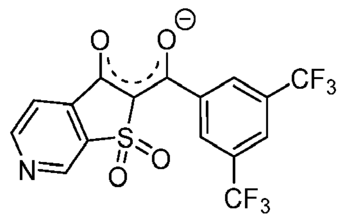 (C24),

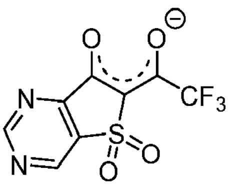 (C25), 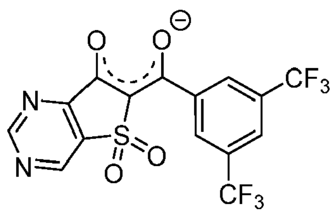 (C26), 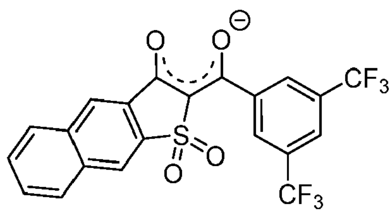 (C27),

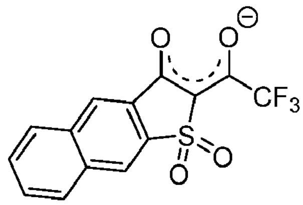 (C28);

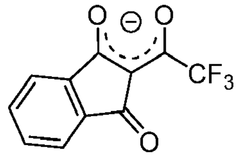
C29,

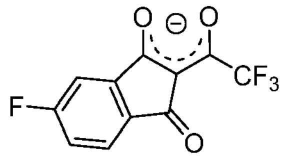
C30,

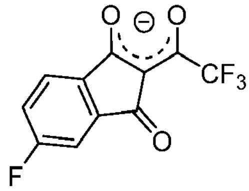
C31,

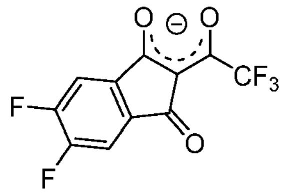
C32,

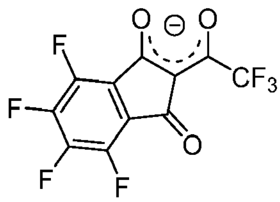
C33,

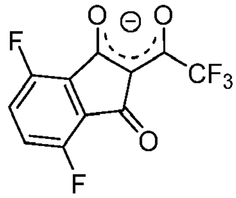
C34,

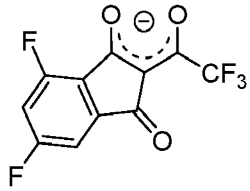
C35,

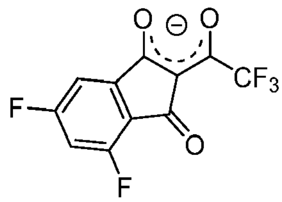
C36,

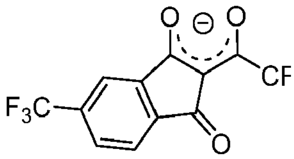
C37,

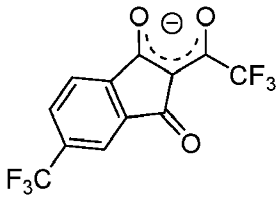
C38,

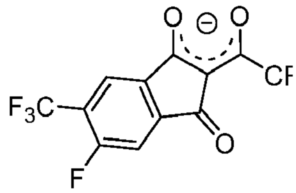
C39,

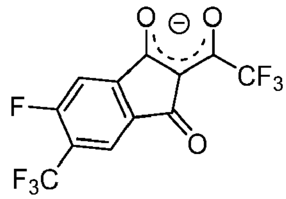
C40,

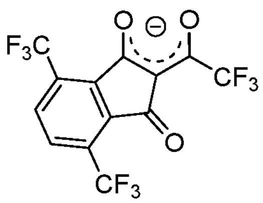
C41,

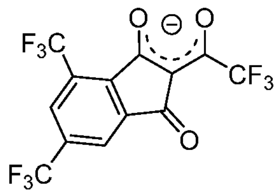
C42,

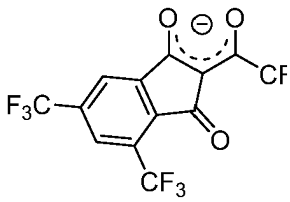
C43,

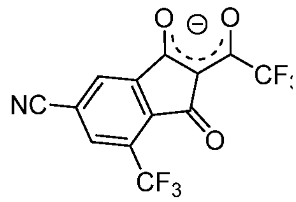
C44,

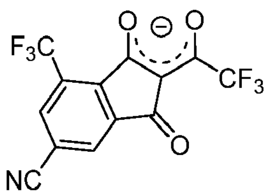
C45,

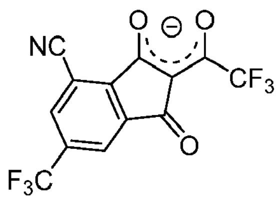
C46,

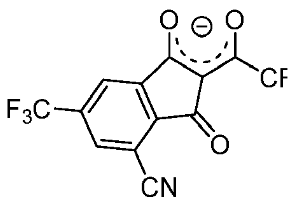
C47,

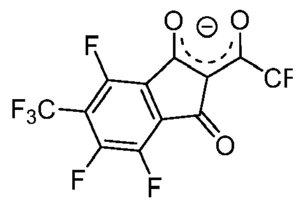
C48,

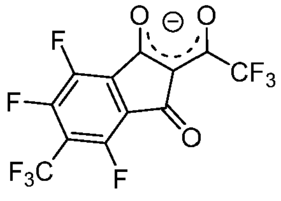
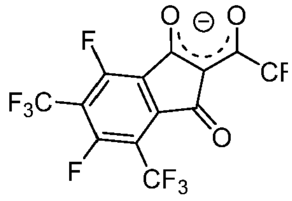
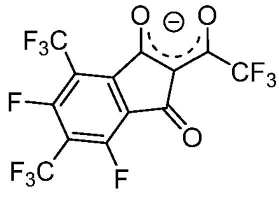
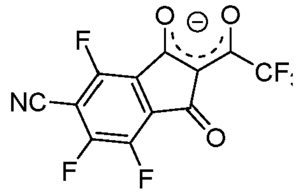

C49, C50, C51, C52,

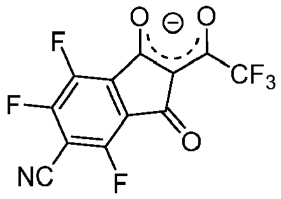
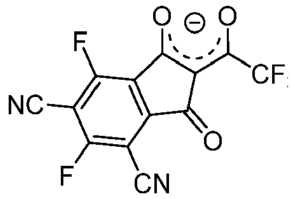
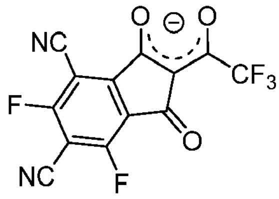
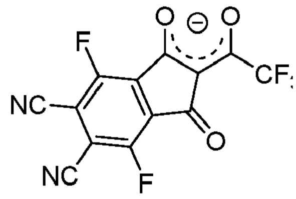

C53, C54, C55, C56,

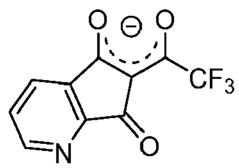
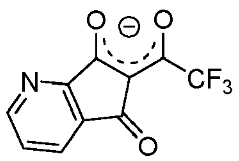
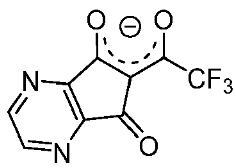
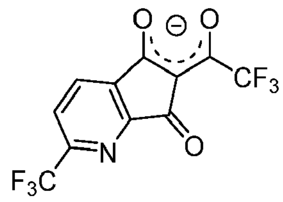

C57, C58, C59, C60,

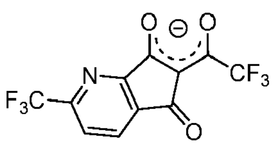
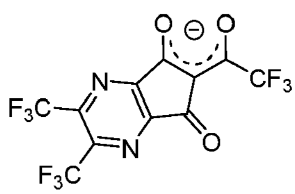
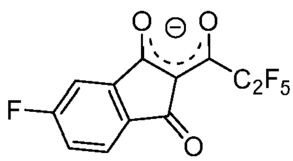
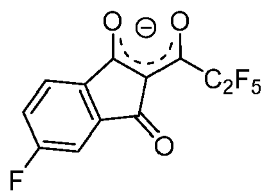

C61, C62, C63, C64,

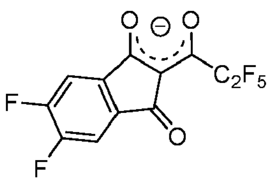
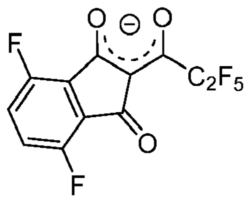
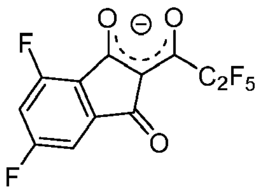
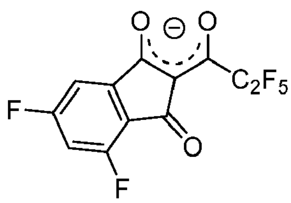

C65, C66, C67, C68,

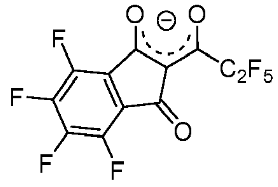 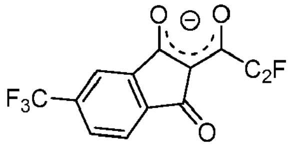 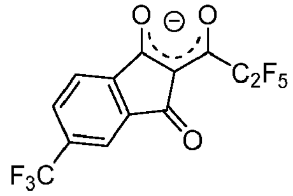 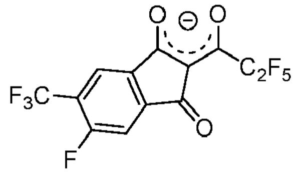

C69, C70, C71, C72,

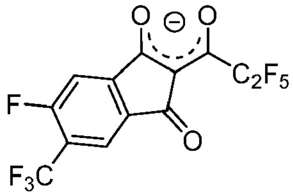 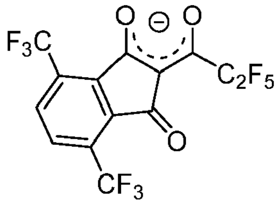 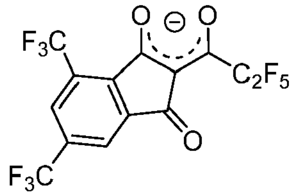 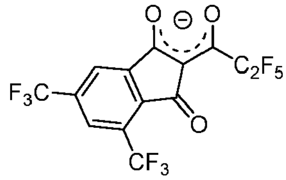

C73, C74, C75, C76,

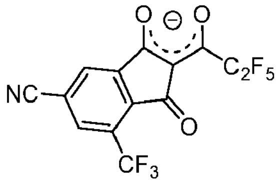 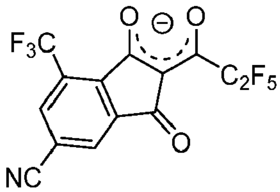 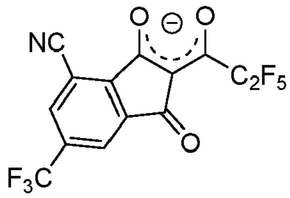 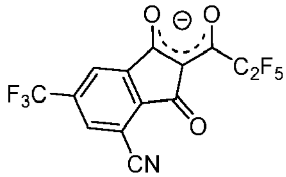

C77, C78, C79, C80,

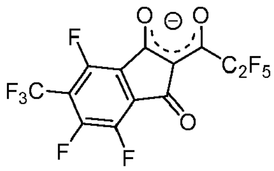 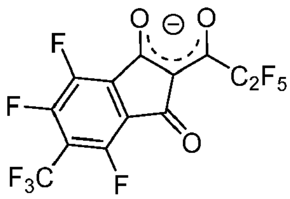 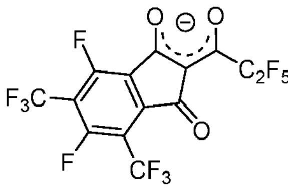 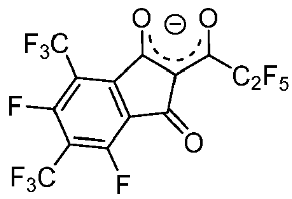

C81, C82, C83, C84,

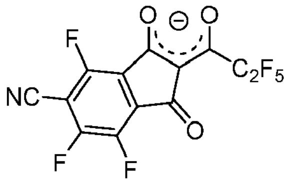 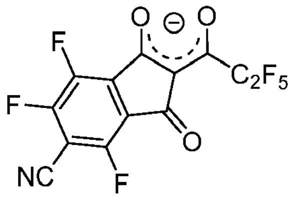 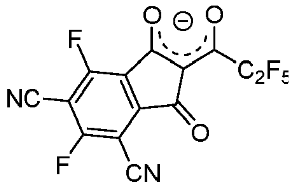 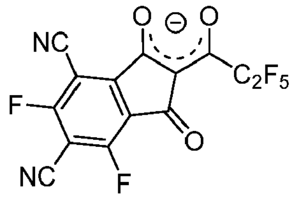

C85, C86, C87, C88,

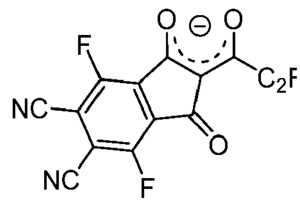 C89, 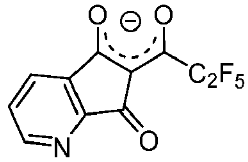 C90, 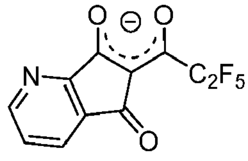 C91, 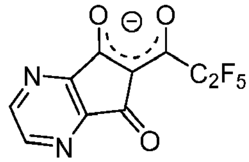 C92,

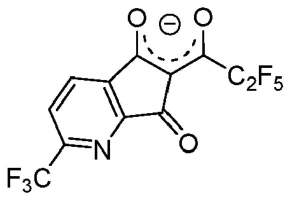 C93, 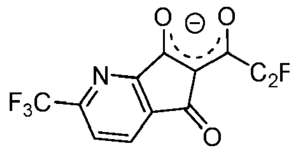 C94, 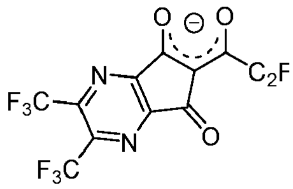 C95, 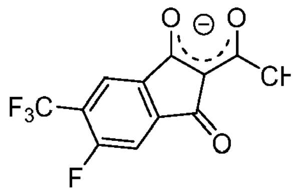 C96,

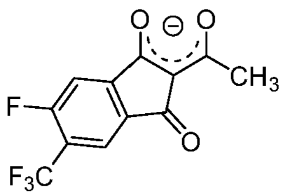 C97, 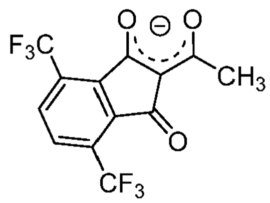 C98, 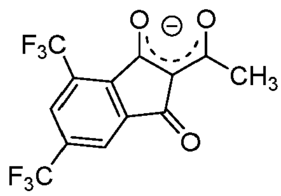 C99, 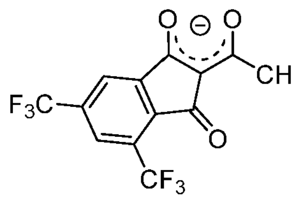 C100,

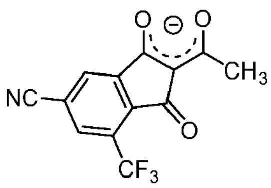 C101, 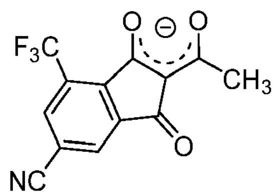 C102, 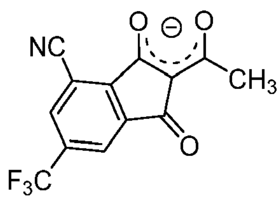 C103, 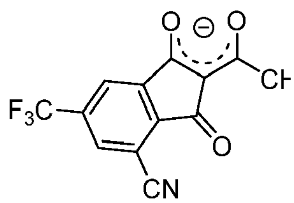 C104,

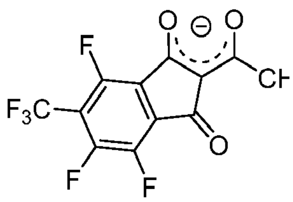 C105, 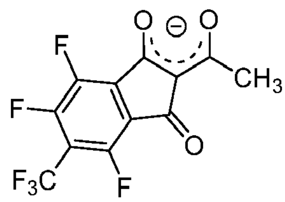 C106, 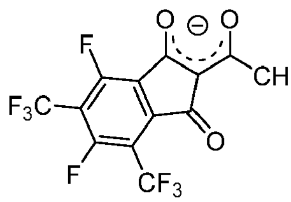 C107, 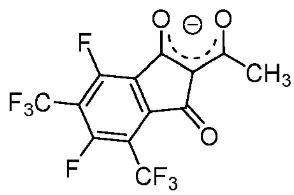 C108,

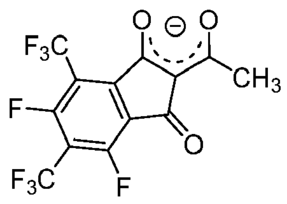 C109,

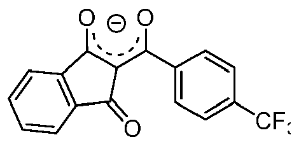 C110,

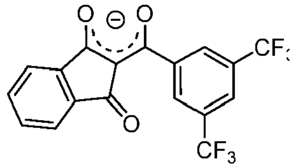 C111,

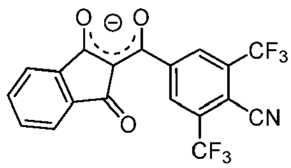 C112,

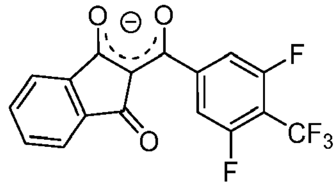

C113,

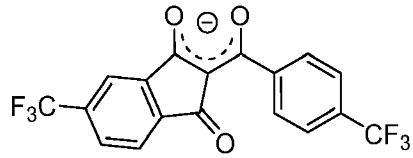

C114,

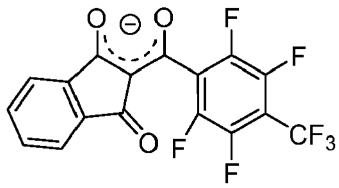

C115,

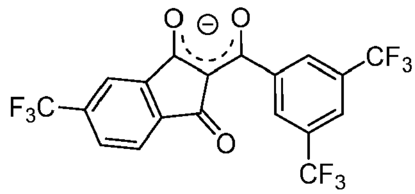

C116,

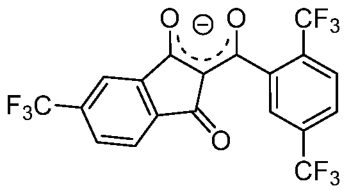

C117,

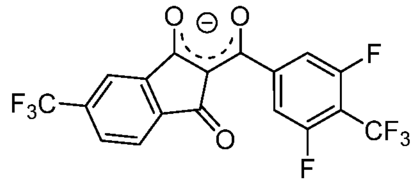

C118,

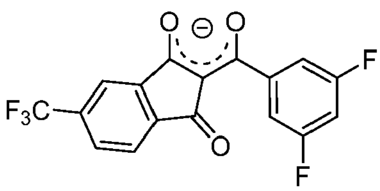

C119,

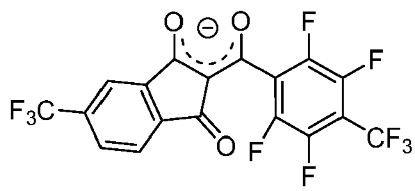

C120,

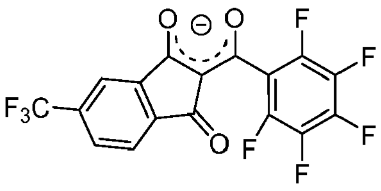

C121,

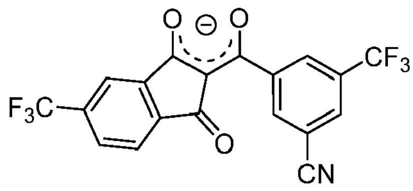

C122,

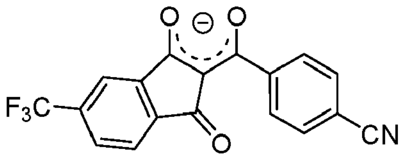

C123,

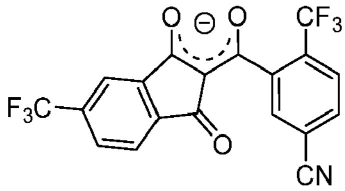

C124,

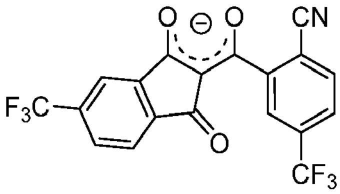

C125,

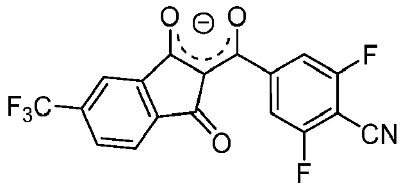

C126,

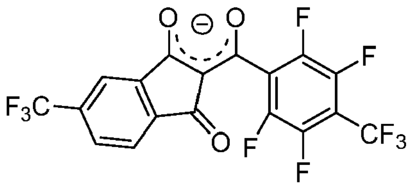

C127,

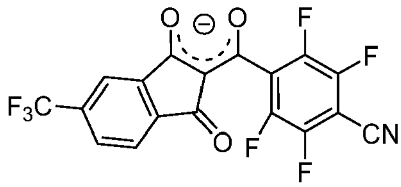

C128,

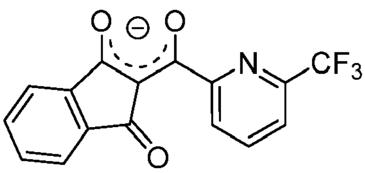

C129,

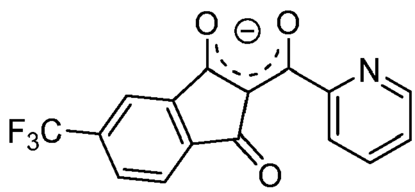

C130,

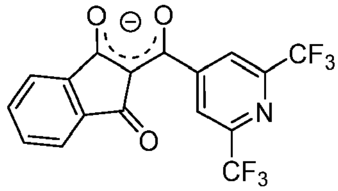

C131,

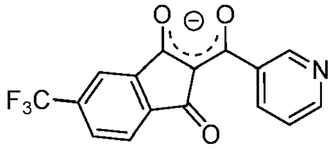

C132,

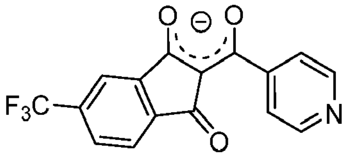

C133,

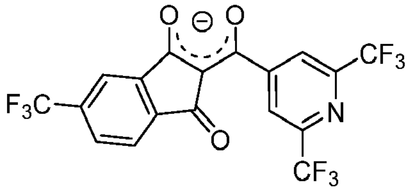

C134,

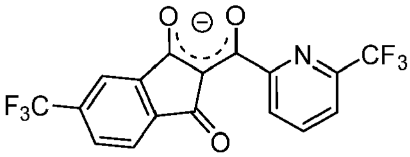

C135,

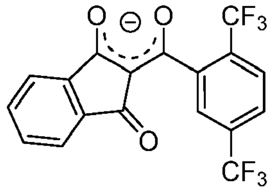

C136,

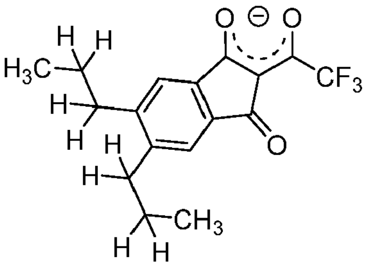

C137,

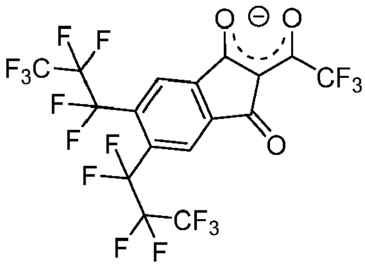

C138,

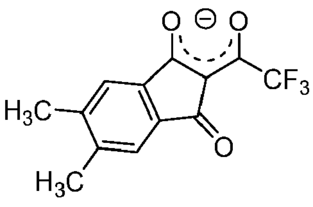

C139,

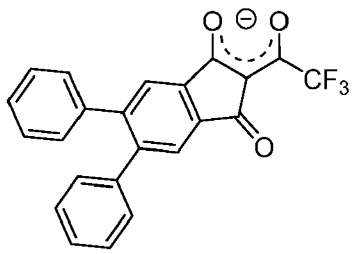

C140,

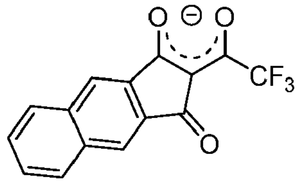

C141;

8. The organic electronic device according to any one of claims 1 to 7, whereby the organic compound of formula (III) has a LUMO energy level of equal or less than - 4.30 eV, wherein the LUMO energy level is calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

9. The organic electronic device according to any one of claims 1 to 8, whereby in formula (III), A is selected from H1 to H72:

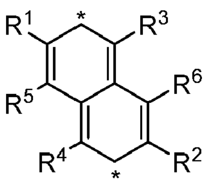 (H1), 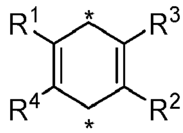 (H2), 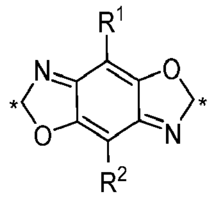 (H3),

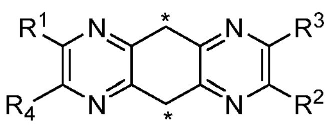 (H4), 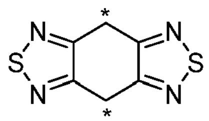 (H5), 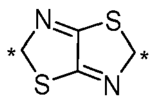 (H6), 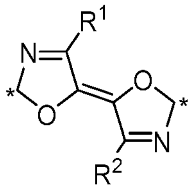 (H7),

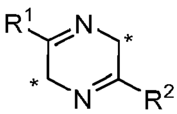 (H8), 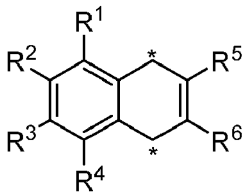 (H9), 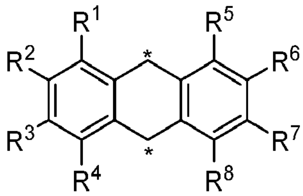 (H10),

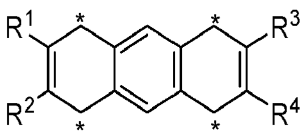 (H11), 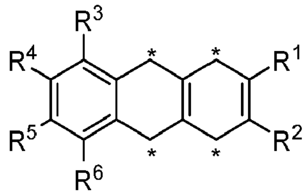 (H12), 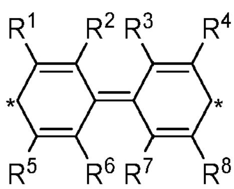 (H13),

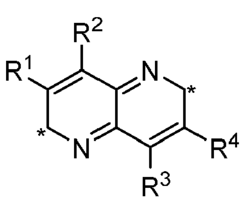 (H14), 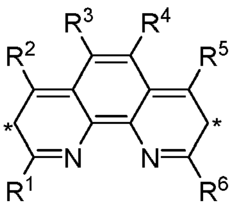 (H15), 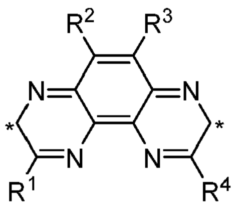 (H16),

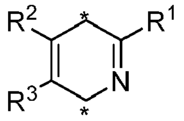 (H17), 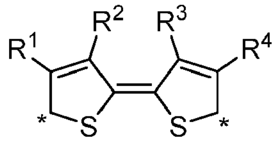 (H18), 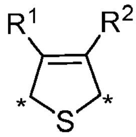 (H19),

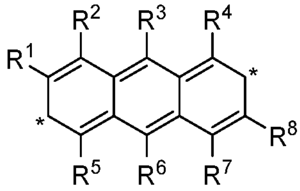 (H20), 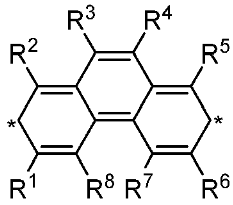 (H21), 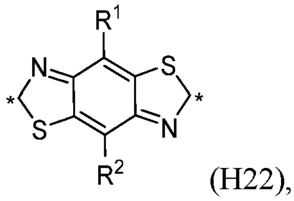 (H22), 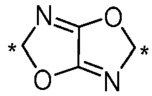

(H23), 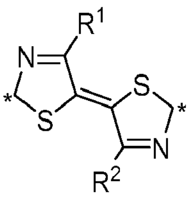 (H24), 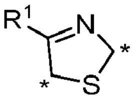 (H25), 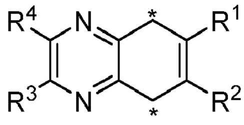 (H26), 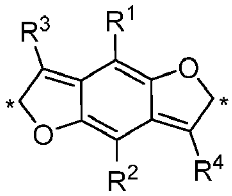

(H27), 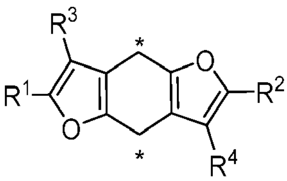 (H28), 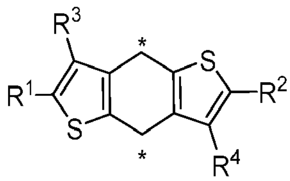 (H29), 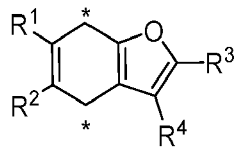 (H30),

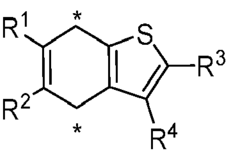 (H31), 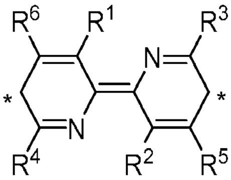 (H32), 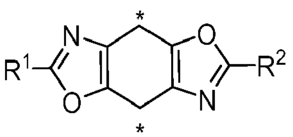 (H33),

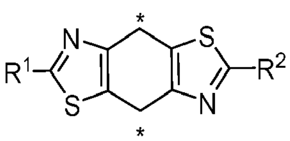 (H34), 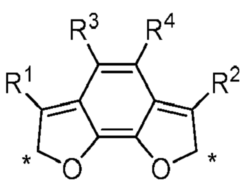 (H35), 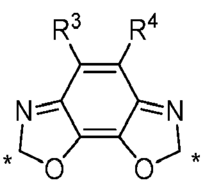 (H36),

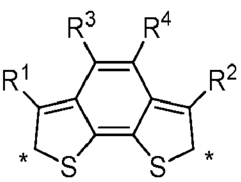 (H37), 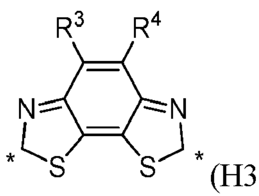 (H38),

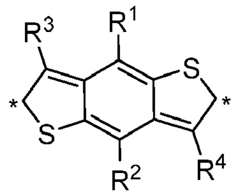 (H39), 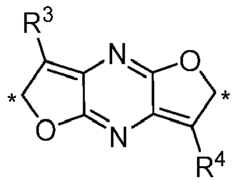 (H40), 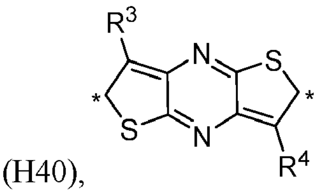 (H41), 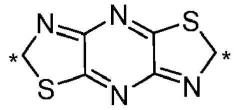

(H42), 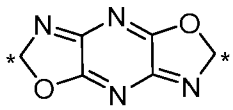 (H43), 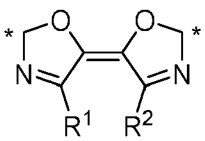 (H44), 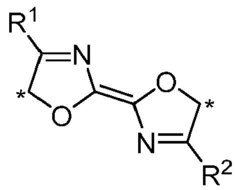 (H45),

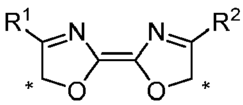 (H46), 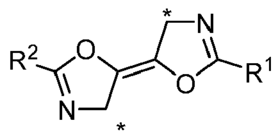 (E47), 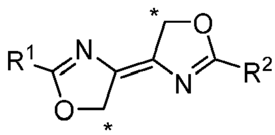 (E48),

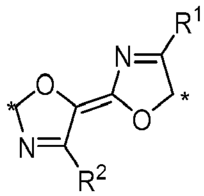 (H49), 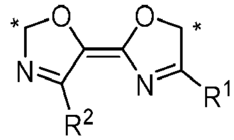 (H50), 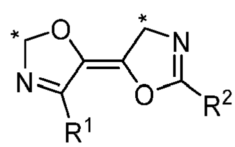 (H51), 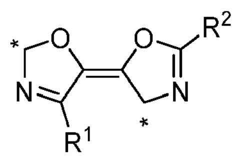

(H52), 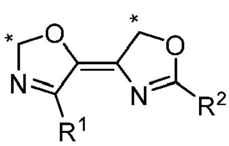 (H53), 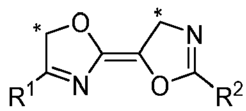 (H54), 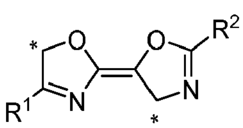 (H55),

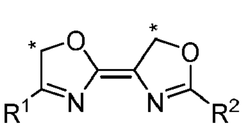 (H56), 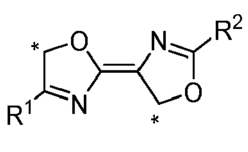 (H57), 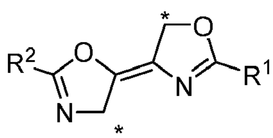 (H58),

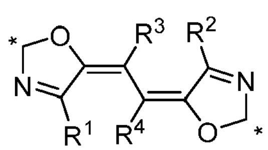 (H59), 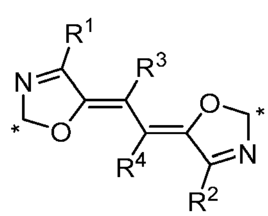 (H60), 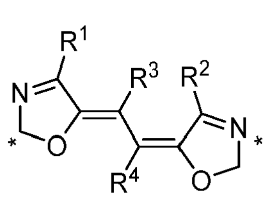 (H61),

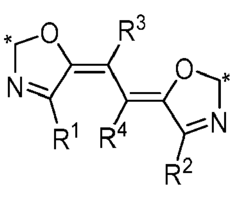 (H62), 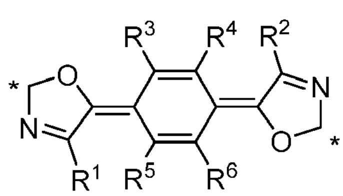 (H63), 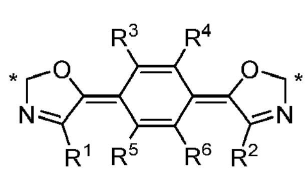 (H64),

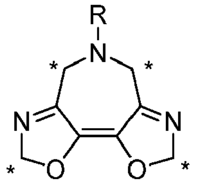 (H65), 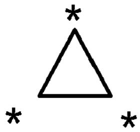 (H66), 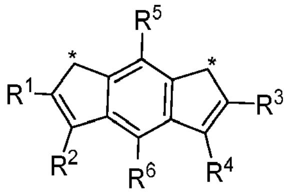 (H67),

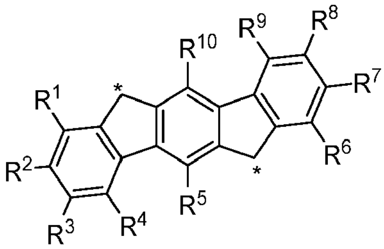 (H68), 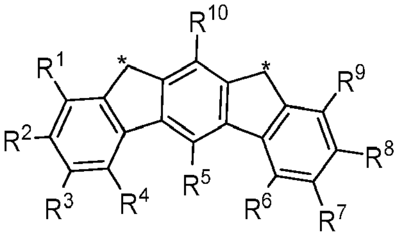 (H69),

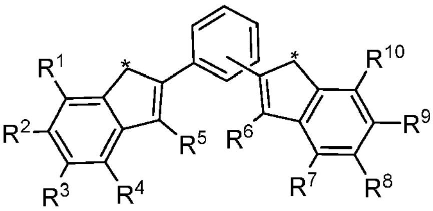 (H70), 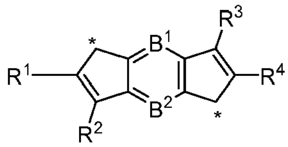 (H71),

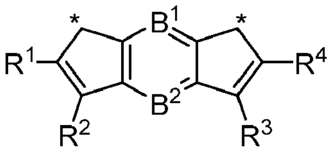 (H72),

wherein the asterisk "*" denotes the binding position;

$R^1$, $R^2$, $R^3$, $R^4$, $R^5$, $R^6$, $R^7$ and $R^8$

are independently selected from H, D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$, wherein the substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,

$B^1$ and $B^2$

are independently of each other selected from N, $CR^{5A'}$, or $CR^{6A'}$, wherein

$CR^{5A'}$, or $CR^{6A'}$ are each independently selected from other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein

the one or more substituents on $CR^{5A'}$, or $CR^{6A'}$are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl,

wherein the one or more substituents - if present - of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

**10.** The organic electronic device according to any one of claims 1 to 7, whereby in formula (III), A is selected from the following moieties:

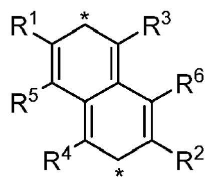
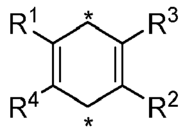
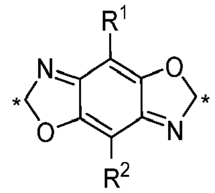
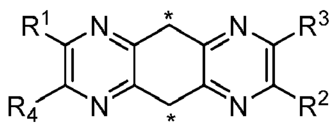
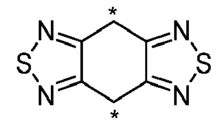
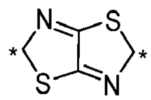
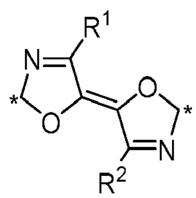
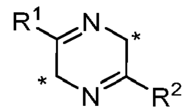
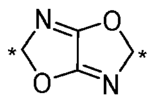
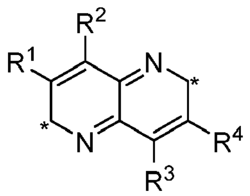
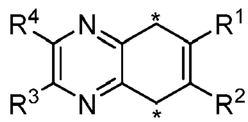
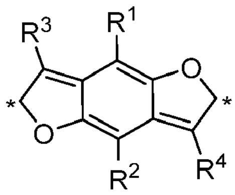
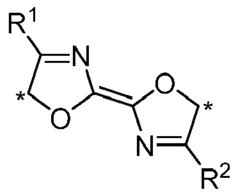
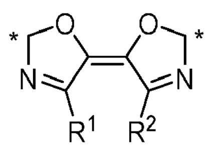
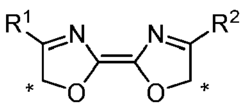
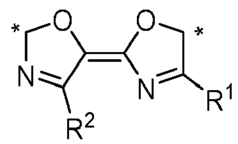
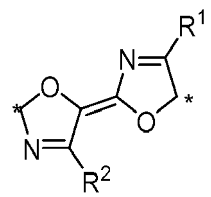
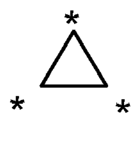
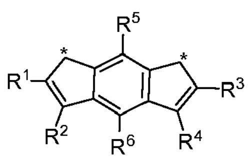
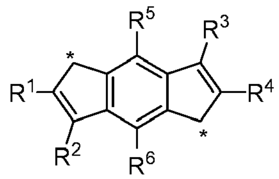

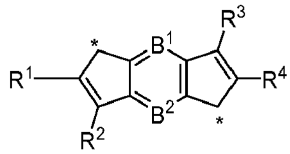

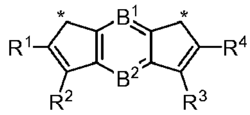

**11.** The organic electronic device according to any one of claims 1 to 8, whereby in formula (III), A is selected from the following moieties:

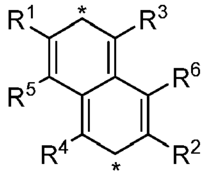

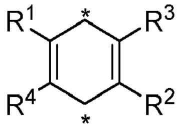

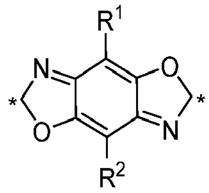

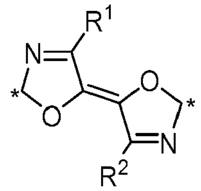

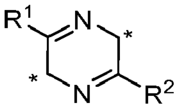

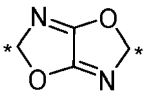

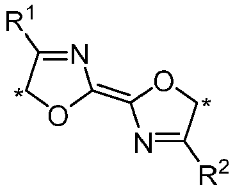

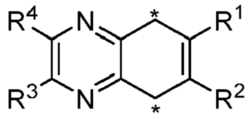

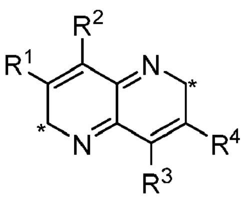

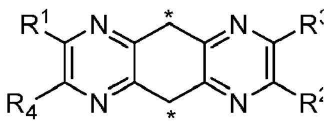

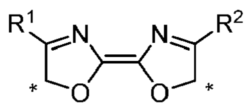

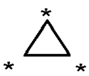

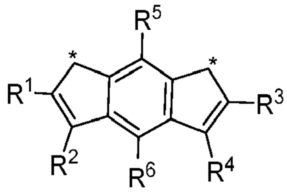

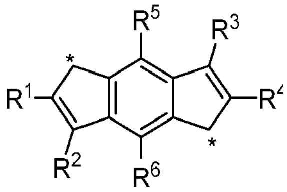

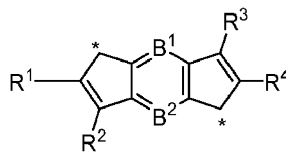

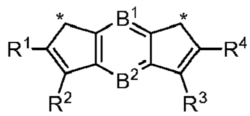

**12.** The organic electronic device according to any one of claims 1 to 11, wherein the hole injection layer and/or the p-type charge generation layer comprises at least one arylamine compound, diarylamine compound, triarylamine compound, a compound of formula (IVa) or a compound of formula (IVb):

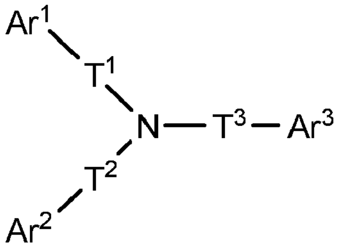 (IVa), 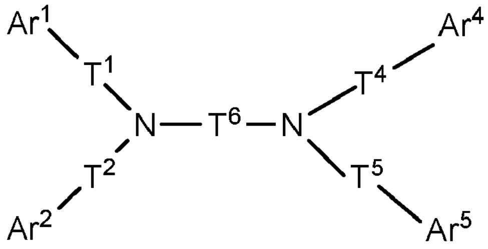 (IVb),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (IIIa) 6-member ring of an aromatic non-heterocycle;

wherein

the substituents of $Ar^1$, $Ar^2$, $Ar^3$, $Ar^4$ and $Ar^5$ are selected the same or different from the group comprising H, D, F, $C(-O)R^2$, CN, $Si(R^2)_3$, $P(-O)(R^2)_2$, $OR^2$, $S(-O)R^2$, $S(-O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or

unsubstituted aromatic ring systems having 6 to 40 aromatic ring atoms, and substituted or unsubstituted heteroaromatic ring systems having 5 to 40 aromatic ring atoms,

unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

**13.** The organic electronic device according to any one of claims 1 to 12, wherein the hole injection layer and/or the p-type charge generation layer comprises at least one compound of formula (IVa) or formula (IVb).

**14.** The organic electronic device according to any one of claims 1 to 13, whereby the organic electronic device is an organic electroluminescent device and/or an organic light emitting diode.

**15.** A display device comprising an organic electronic device according to any of the claims 1 to 14.

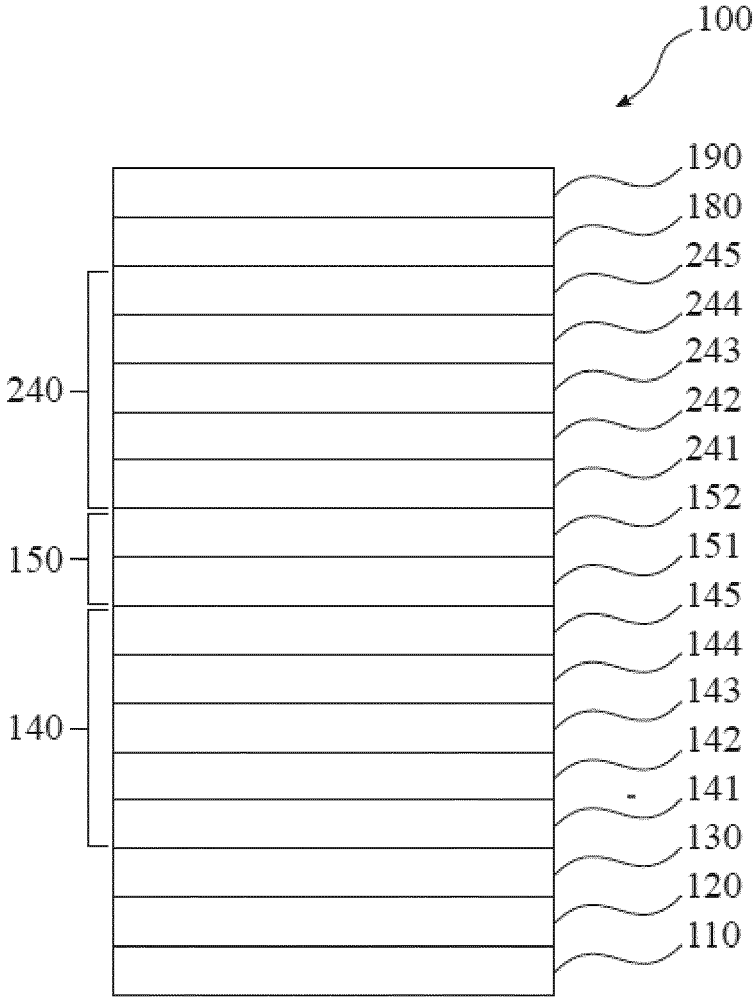
100
190
180
245
244
243
242
241
152
151
145
144
143
142
141
130
120
110
240
150
140

Fig. 1

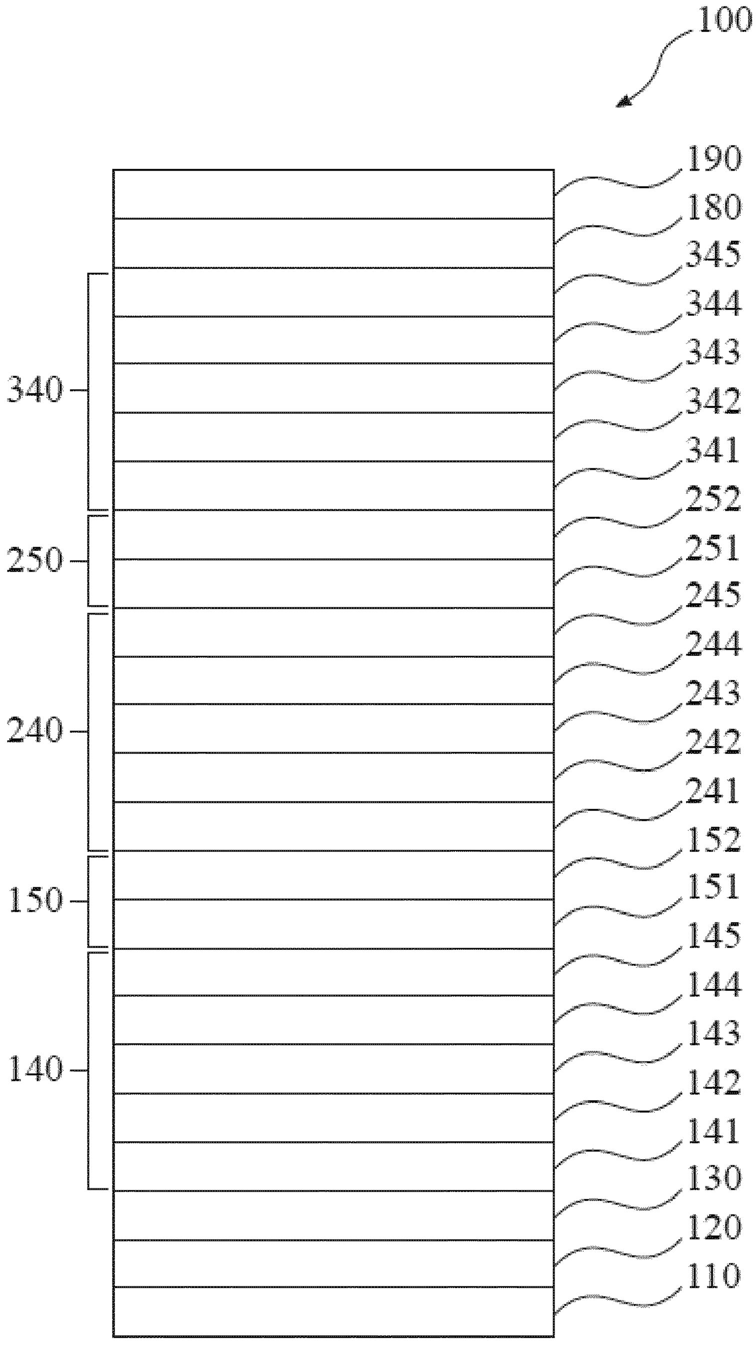
100
190
180
345
344
343
342
341
252
251
245
244
243
242
241
152
151
145
144
143
142
141
130
120
110
340
250
240
150
140

Fig. 2

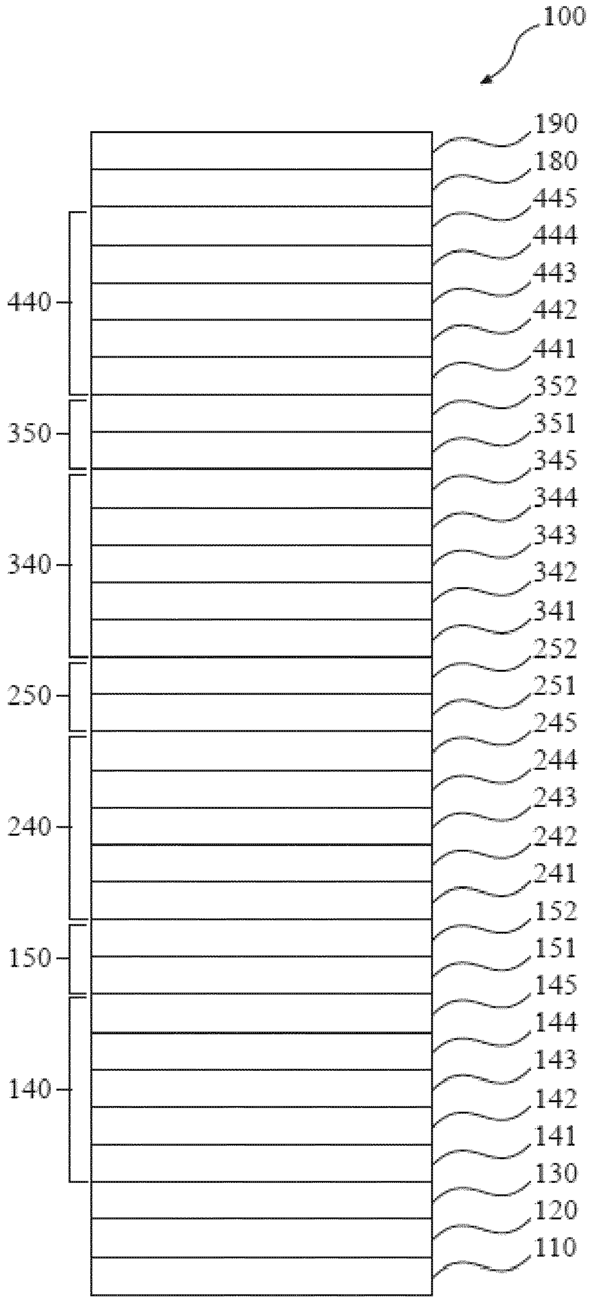
100
190
180
445
444
443
442
441
352
351
345
344
343
342
341
252
251
245
244
243
242
241
152
151
145
144
143
142
141
130
120
110
440
350
340
250
240
150
140

Fig. 3

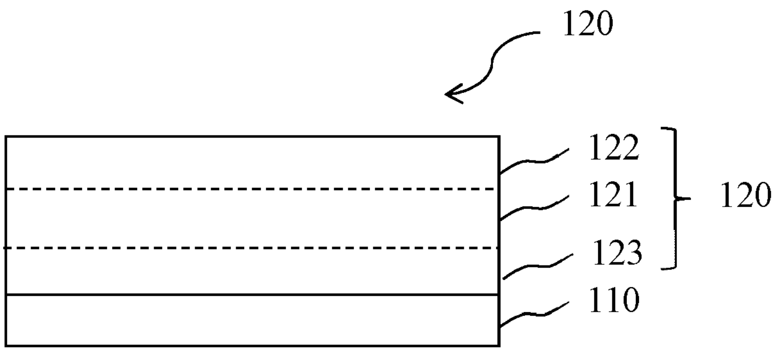


Fig. 4

Europäisches Patentamt
European Patent Office
Office européen des brevets

# EUROPEAN SEARCH REPORT

Application Number
EP 23 21 0712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2022/189431 A1 (CREDOXYS GMBH [DE]) 15 September 2022 (2022-09-15)<br>* page 51 - page 53 *<br>* page 11 *<br>* page 14; table 2; compound BPAPF *<br>----- | 1-5,7-15 | INV.<br>H10K85/30<br>H10K50/17<br>H10K50/19<br>H10K85/60 |
| Y | US 2019/207123 A1 (YOON SEUNGHEE [KR] ET AL) 4 July 2019 (2019-07-04)<br>* paragraph [0101]; compound 3 *<br>* paragraph [0128]; example 1 *<br>* paragraph [0093] *<br>* paragraph [0046]; figure 1 *<br>----- | 1-5,7-15 | |

TECHNICAL FIELDS SEARCHED (IPC)

H10K
C07C

The present search report has been drawn up for all claims

1

| Place of search | Date of completion of the search | Examiner |
|---|---|---|
| Munich | 6 May 2024 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 21 0712

This annex lists the patent family members relating to the patent documents cited in the above-mentioned European search report. The members are as contained in the European Patent Office EDP file on
The European Patent Office is in no way liable for these particulars which are merely given for the purpose of information.

06-05-2024

| Patent document cited in search report | Publication date | Patent family member(s) | Publication date |
|---|---|---|---|
| WO 2022189431 A1 | 15-09-2022 | CN 116964026 A | 27-10-2023 |
| | | EP 4305681 A1 | 17-01-2024 |
| | | JP 2024508788 A | 28-02-2024 |
| | | KR 20230154815 A | 09-11-2023 |
| | | WO 2022189431 A1 | 15-09-2022 |
| US 2019207123 A1 | 04-07-2019 | CN 110010781 A | 12-07-2019 |
| | | KR 20190080600 A | 08-07-2019 |
| | | US 2019207123 A1 | 04-07-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2722908 A1
- US 2005121667 A1


### Non-patent literature cited in the description


- **ALLEN, LELAND C.** Electronegativity is the average one-electron energy of the valence-shell electrons in ground-state free atoms. *Journal of the American Chemical Society*, 1989, vol. 111 (25), 9003-9014
- **YASUHIKO SHIROTA** ; **HIROSHI KAGEYAMA**. *Chem. Rev.*, 2007, vol. 107, 953-1010
- **J. G. LOMBARDINO**. *J. Org. Chem.*, 1968, vol. 33 (10), 3938-3941
- **ENCHEV, VENELIN et al.** *J. Mol. Struct.*, 2001, vol. 595 (1-3), 67-76
- **AHMEDOVA, ANIFE et al.** *Inorg. Chim. Acta*, 2006, vol. 359 (10), 3123-3128
- **RUSANOV, VENTZISLAV et al.** *Eur. J. Chem.*, 2014, vol. 5 (1), 176-180
- **BUCSIS** ; **FRIEDRICHS**. *Chem. Ber.*, 1976, vol. 109, 2462-2468
- *J. Org. Chem.*, 1995, vol. 60 (13), 4077-4084
- *Liebigs Annalen der Chemie*, 1986, vol. 1, 142-164